# EUROPEAN PATENT APPLICATION

(11) **EP 4 521 893 A1**
(43) Date of publication of application: **12.03.2025**
(21) Application number: 24198711.4
(22) Date of filing: 05.09.2024
(51) Int. Cl.: H10K 50/16, H10K 50/18, H10K 85/60, H10K 85/30

(54) **LIGHT-EMITTING DEVICE INCLUDING HETEROCYCLIC COMPOUND, ELECTRONIC APPARATUS INCLUDING THE LIGHT-EMITTING DEVICE, AND THE HETEROCYCLIC COMPOUND**

(30) Priority: 07.09.2023 KR 20230119276; 22.03.2024 KR 20240039977
(71) Applicant: Samsung Display Co., Ltd., Gyeonggi-do 17113 (KR)
(72) Inventor: PAK, Hankyu, 17113 Yongin-si, Gyeonggi-do (KR); Kim, Dongjun, 17113 Yongin-si, Gyeonggi-do (KR); Park, Hyunbin, 17113 Yongin-si, Gyeonggi-do, (KR); YUN, Jinyoung, 17113 Yongin-si, Gyeonggi-do (KR); Han, Sanghyun, 17113 Yongin-si, Gyeonggi-do (KR)
(74) Representative: Gulde & Partner

(57) **Abstract**

A light-emitting device including a heterocyclic compound represented by Formula 1, an electronic apparatus including the light-emitting device, and the heterocyclic compound represented by Formula 1 are provided:

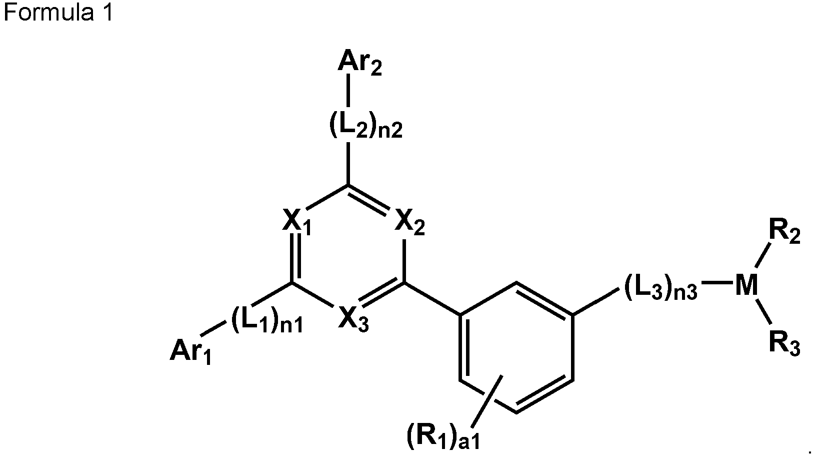

## Description

### BACKGROUND

### 1. Field

One or more embodiments of the present disclosure relate to a light-emitting device including a heterocyclic compound, an electronic apparatus including the light-emitting device, and the heterocyclic compound.

### 2. Description of the Related Art

Among light-emitting devices, self-emissive devices have relatively wide viewing angles, relatively high contrast ratios, relatively short response times, and have excellent or suitable characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as the holes and electrons, recombine in the emission layer to produce excitons. These excitons transition and decay from an excited state to a ground state, thereby generating light.

### SUMMARY

The invention is defined by the appended claims. The description that follows is subjected to this limitation. Any disclosure lying outside the scope of said claims is only intended for illustrative as well as comparative purposes. One or more aspects of embodiments of the present disclosure are directed toward a light-emitting device including a heterocyclic compound, an electronic apparatus including the light-emitting device, and the heterocyclic compound.

Additional aspects will be set forth in part in the description which follows and, in part, will be apparent from the description, or may be learned by practice of the presented embodiments of the instant disclosure.

According to an aspect of the present invention, there is procided a light-emitting device as defined in claim 1.

According to another aspect of the present invention, an electronic apparatus includes the light-emitting device.

According to a further aspect of the present invention, electronic equipment includes the light-emitting device.

According to a further aspect of the present invention, there is provided a heterocyclic compound represented by Formula 1 as defined in claim 6.

### BRIEF DESCRIPTION OF DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic view of a structure of a light-emitting device according to one or more embodiments of the present disclosure;
FIG. 2 is a schematic view of a structure of a light emitting apparatus according to one or more embodiments of the present disclosure;
FIG. 3 is a schematic view of a structure of a light emitting apparatus according to one or more embodiments of the present disclosure; and
FIGs. 4, 5, 6A, 6B, and 6C are each a schematic view of a structure of electronic equipment according to one or more embodiments of the present disclosure.

### DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly, the embodiments of the present disclosure are merely described, by referring to the drawings, to explain aspects of the present disclosure. As utilized herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

According to one or more embodiments of the present disclosure, provided is a heterocyclic compound represented by Formula 1: 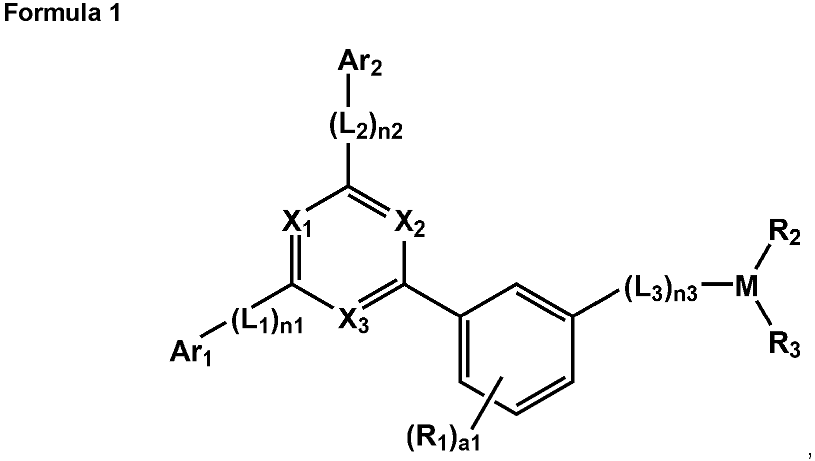 wherein, in Formula 1, M is a Group 13 element.

In one or more embodiments, M may be boron (B), aluminum (Al), or gallium (Ga).

In Formula 1, X₁ is C(Y₁) or N, X₂ is C(Y₂) or N, and X₃ is C(Y₃) or N.

In one or more embodiments, at least one selected from among X₁ to X₃ may be N.

In one or more embodiments, at least two selected from among X₁ to X₃ may each be N.

In one or more embodiments, X₁ to X₃ may each be N.

In one or more embodiments, Y₁ to Y₃ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

In one or more embodiments, Y₁ to Y₃ may each independently be:
hydrogen, deuterium, -F, -Cl, -Br, -I, a hydroxyl group, a cyano group, a nitro group, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, - CF₂H, -CFH₂, a hydroxyl group, a cyano group, a nitro group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

In Formula 1, Ar1 and Ar₂ are each independently a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

In one or more embodiments, Ar1 and Ar₂ may each independently be:
a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, - CF₂H, -CFH₂, a hydroxyl group, a cyano group, a nitro group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

In one or more embodiments, Ar1 and Ar₂ may each independently be:
a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, - CF₂H, -CFH₂, a cyano group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ may each independently be: hydrogen; deuterium; -F; -Cl; -Br; -I; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

In Formula 1, R₁ to R₃ are independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

In Formula 1, a1 indicates the number of R₁, and is an integer from 1 to 4. When a1 is 2 or more, two or more of R₁(s) may be identical to or different from each other.

In one or more embodiments, R₁ to R₃ may each independently be:
hydrogen, deuterium, -F, -Cl, -Br, -I, a hydroxyl group, a cyano group, a nitro group, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, - CF₂H, -CFH₂, a hydroxyl group, a cyano group, a nitro group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

In one or more embodiments, R₁ to R₃ may each independently be:
hydrogen, deuterium, -F, -Cl, -Br, -I, a cyano group, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a cyano group, a C₁-C₂₀ alkyl group, a C₁-C₂₀ alkoxy group, a C₁-C₂₀ alkylthio group, a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ may each independently be: hydrogen; deuterium; -F; -Cl; -Br; -I; a cyano group; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

In one or more embodiments, R₁ may be: hydrogen, deuterium, -F, or a cyano group; or
a C₁-C₂₀ alkyl group unsubstituted or substituted with deuterium, -F, -Cl, -Br, - I, -CD₃, -CD₂H, -CDH₂, -CF₃, -CF₂H, -CFH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof.

In Formula 1, L₁ to L₃ are each independently a C₃-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ may be the same as described herein.

In Formula 1, n1 to n3 are each independently an integer from 0 to 4, wherein, when n1 is 0, *-(L₁)ₙ₁-*' may be a single bond, when n2 is 0, *-(L₂)ₙ₂-*' may be a single bond, and when n3 is 0, *-(L₃)ₙ₃-*' may be a single bond.

In one or more embodiments, L₁ to L₃ may each independently be:
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phthalazine group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxin group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group, each unsubstituted or substituted with at least one R₁₀ₐ.

R₁₀ₐ may be the same as described herein.

In one or more embodiments, L₁ to L₃ may each independently be:
a benzene group, a naphthalene group, a pyridine group, a pyrimidine group, a pyrazine group, a pyridazine group, a triazine group, a quinoline group, an isoquinoline group, a quinoxaline group, a quinazoline group, or a phthalazine group, each unsubstituted or substituted with at least one R₁₀ₐ.

R₁₀ₐ may be the same as described herein.

When a1 is 2 or more, then two or more of R₁(s) are optionally bonded to each other to form a C₃-C₃₀ carbocyclic group unsubstituted or substituted with at least one R₁₀ₐ or a C₁-C₃₀ heterocyclic group unsubstituted or substituted with at least one R₁₀ₐ.

R₂ is optionally bonded to L₃ to form a C₃-C₃₀ carbocyclic group unsubstituted or substituted with at least one R₁₀ₐ or a C₁-C₃₀ heterocyclic group unsubstituted or substituted with at least one R₁₀ₐ.

R₃ is optionally bonded to L₃ to form a C₃-C₃₀ carbocyclic group unsubstituted or substituted with at least one R₁₀ₐ or a C₁-C₃₀ heterocyclic group unsubstituted or substituted with at least one R₁₀ₐ.

R₂ and R₃ are optionally bonded to each other to form a C₃-C₃₀ carbocyclic group unsubstituted or substituted with at least one R₁₀ₐ or a C₁-C₃₀ heterocyclic group unsubstituted or substituted with at least one R₁₀ₐ.

In one or more embodiments, a group represented by 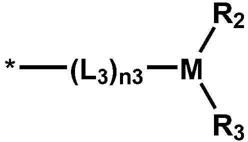 in Formula 1 may be a group represented by Formula M(1) or M(2): 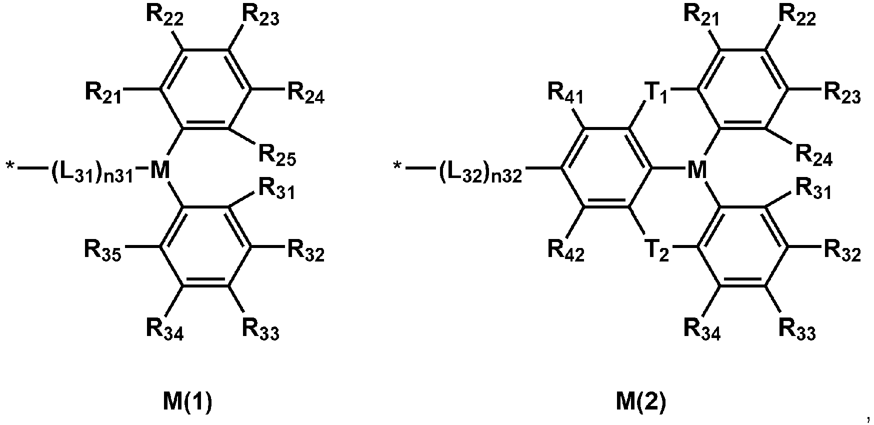 wherein, in Formulae M(1) and M(2),
L₃₁ and L₃₂ may each be the same as described herein with respect to L₃,
n31 may be an integer from 0 to 4, and n32 may be an integer from 0 to 3,
R₂₁ to R₂₅, R₃₁ to R₃₅, R₄₁, and R₄₂ may each be the same as described herein with respect to R₁₀ₐ,
T₁ may be O, S, or C(Z₁)(Z₂), and T₂ may be O, S, or C(Z₁)(Z₂),
Z₁ and Z₂ may each be the same as described herein with respect to Y₁, and
* indicates a binding site to a neighboring atom.

In one or more embodiments, R₂₁ to R₂₅ and R₃₁ to R₃₅ in Formula M(1) and R₂₁ to R₂₄ and R₃₁ to R₃₄ in Formula M(2) may each independently be: hydrogen; deuterium; or a C₁-C₆₀ alkyl group unsubstituted or substituted with at least one R₁₀ₐ.

In one or more embodiments, R₂₁ to R₂₅ and R₃₁ to R₃₅ in Formula M(1) and R₂₁ to R₂₄ and R₃₁ to R₃₄ in Formula M(2) may each independently be hydrogen, deuterium, -CH₃, -CD₃, -CD₂H, -CDH₂, -CF₃, -CF₂H, or -CFH₂.

In one or more embodiments, R₂₁, R₂₃, R₂₅, R₃₁, R₃₃, and R₃₅ in Formula M(1) may each independently be a C₁-C₆₀ alkyl group unsubstituted or substituted with at least one R₁₀ₐ.

In one or more embodiments, R₂₁, R₂₃, R₂₅, R₃₁, R₃₃, and R₃₅ in Formula M(1) may each independently be -CH₃, -CD₃, -CD₂H, -CDH₂, -CF₃, -CF₂H, or -CFH₂.

Unless defined otherwise, in Formula 1, R₁₀ₐ is:
hydrogen, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, - Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Unless defined otherwise, in Formula 1, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In one or more embodiments, the heterocyclic compound may be selected from among Compounds 1 to 1009:

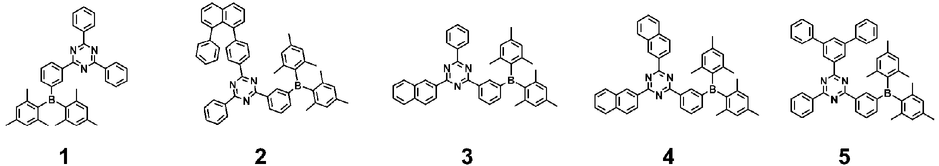

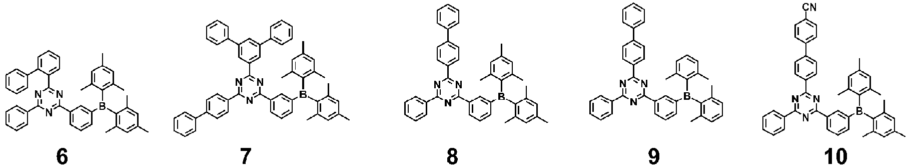

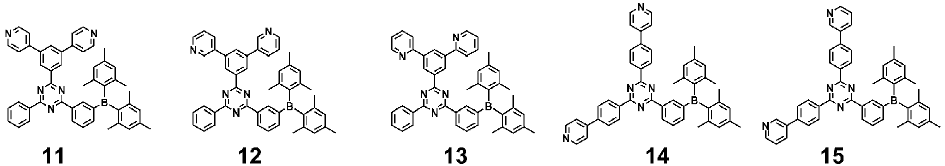

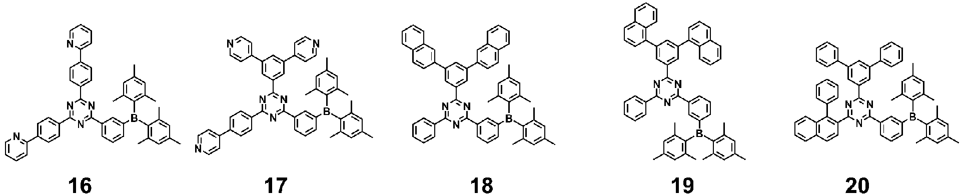

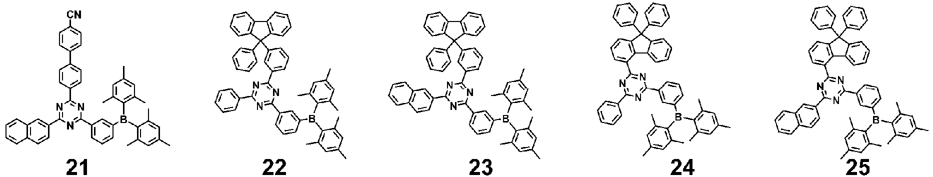

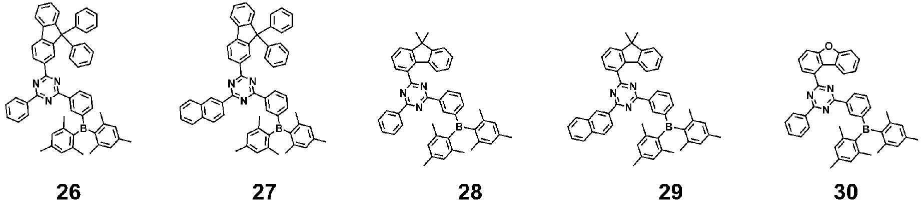

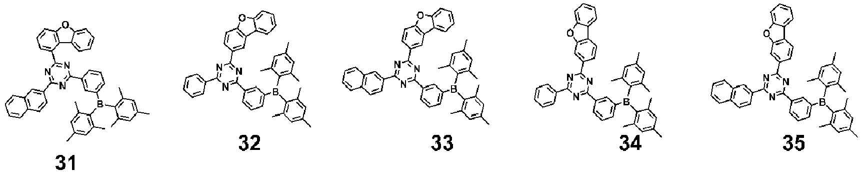

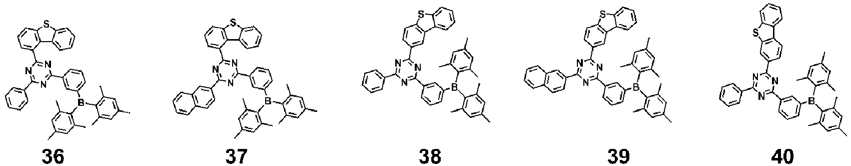

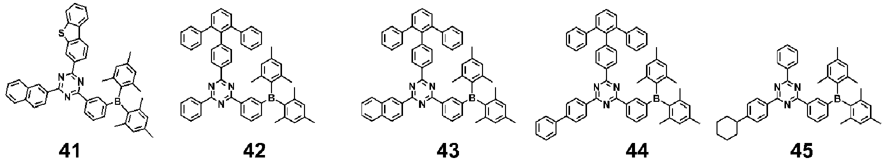

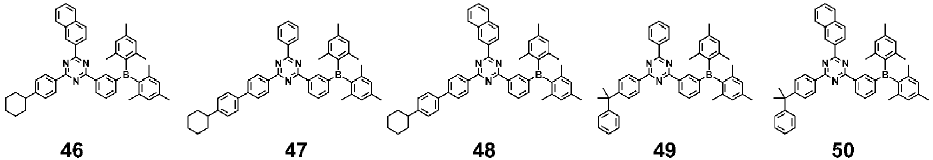

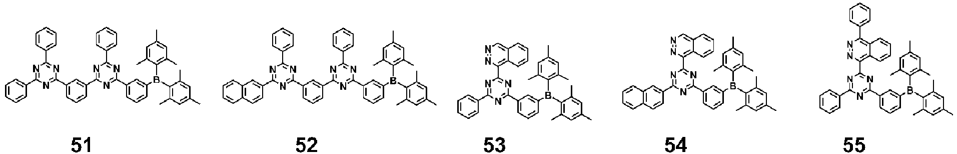

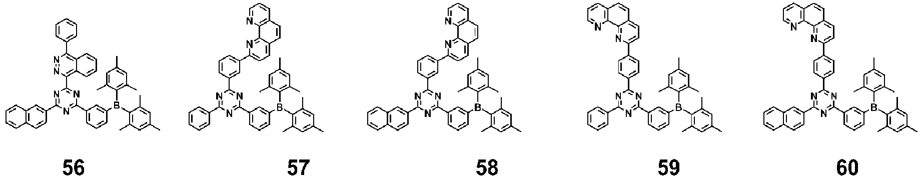

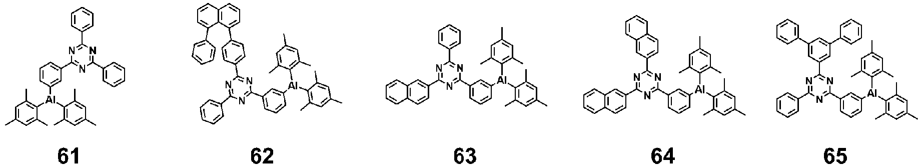

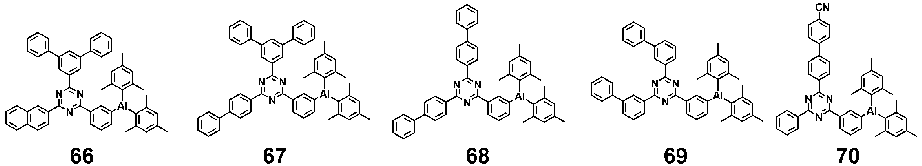

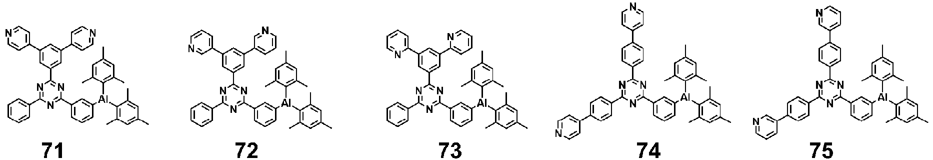

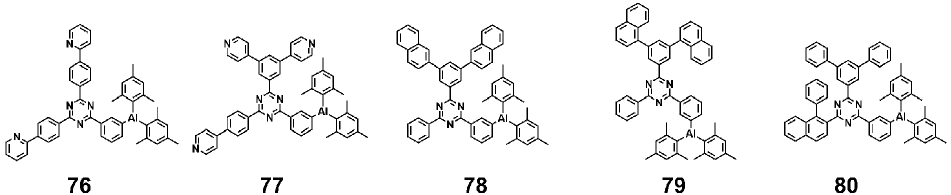

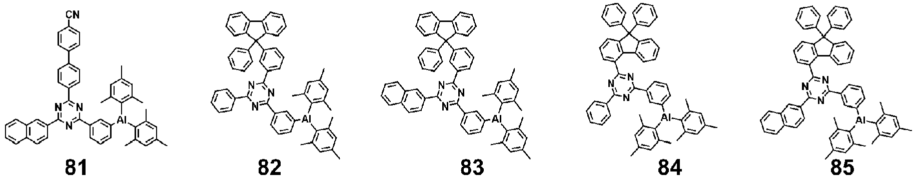

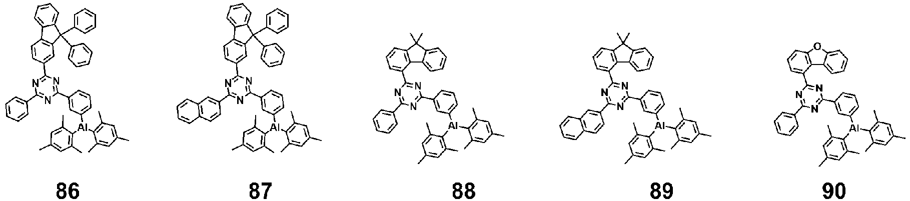

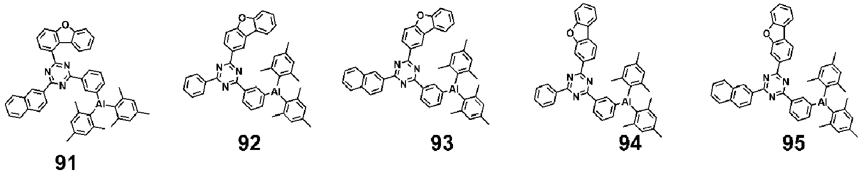

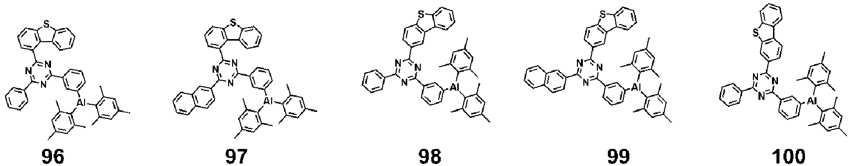

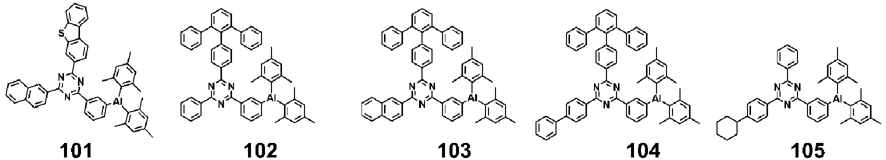

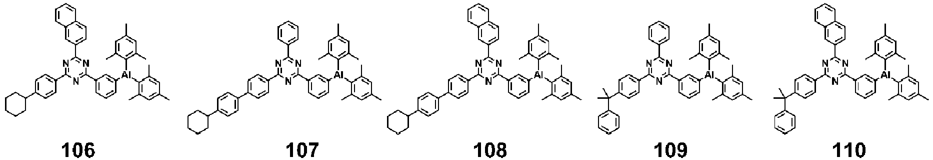

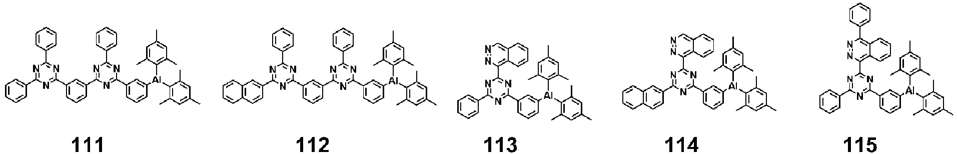

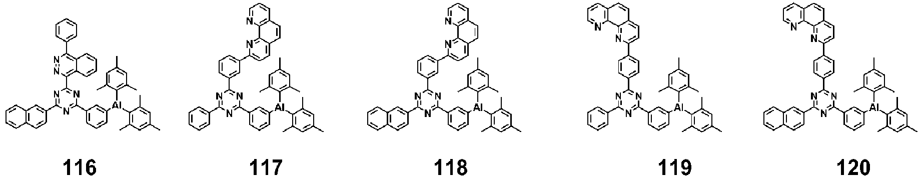

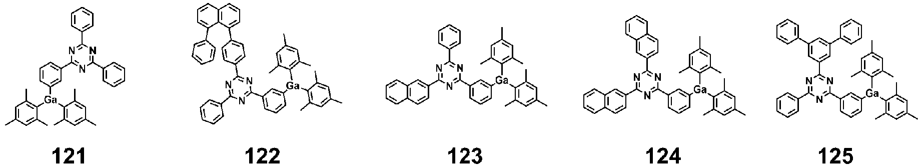

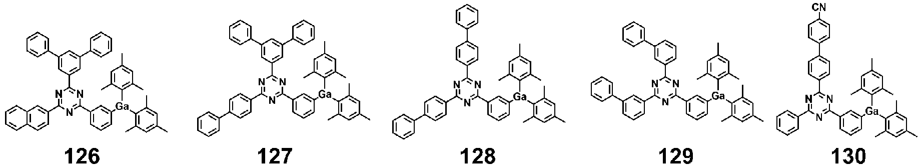

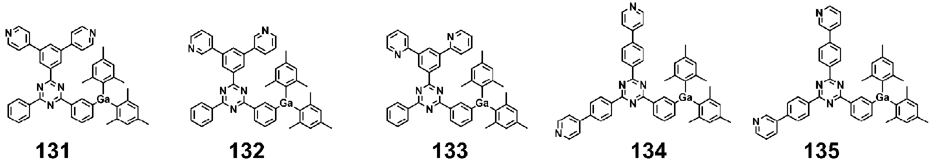

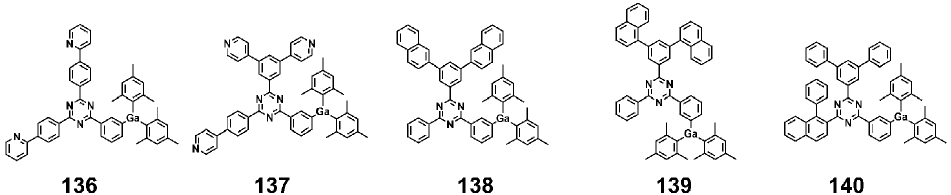

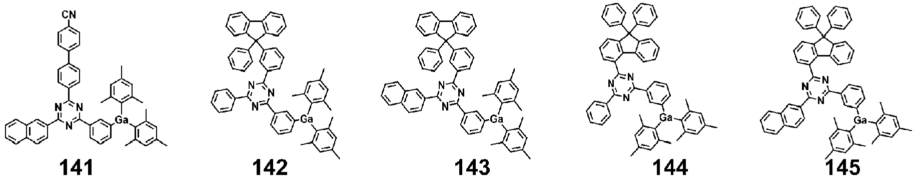

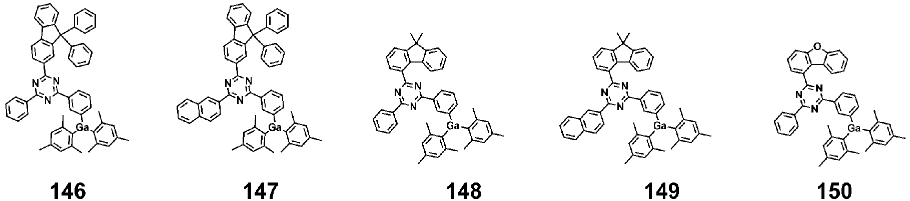

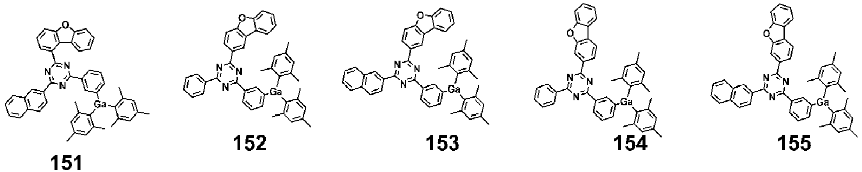

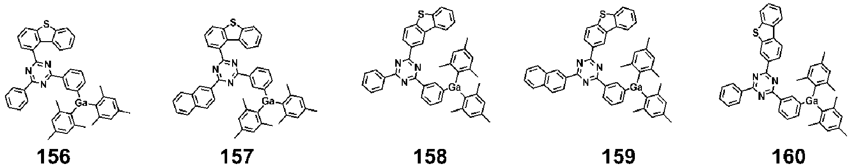

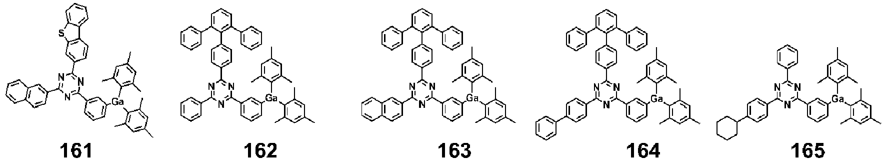

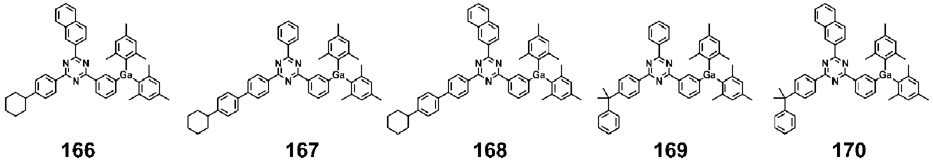

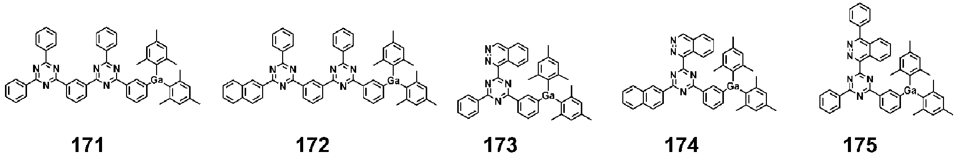

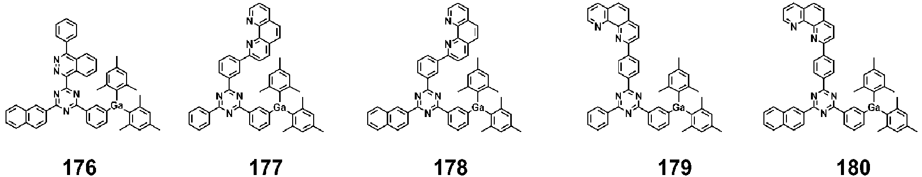

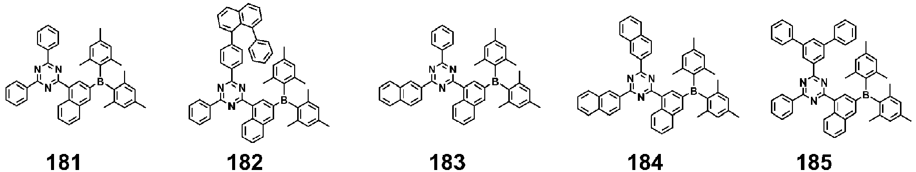

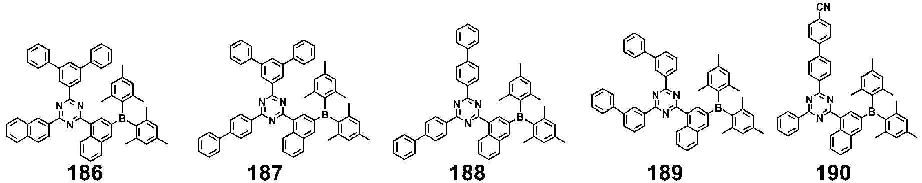

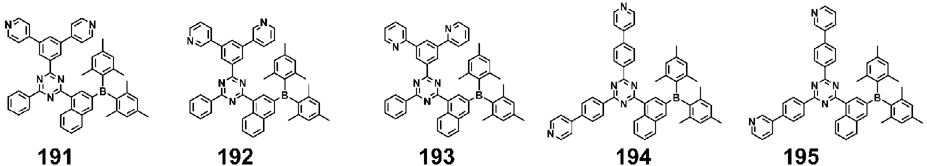

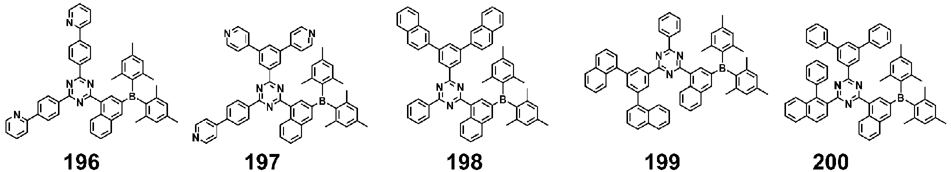

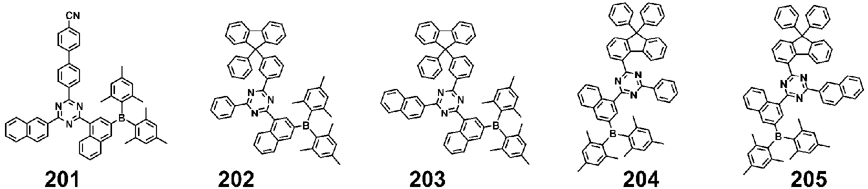

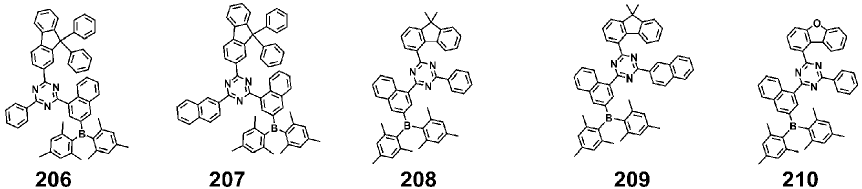

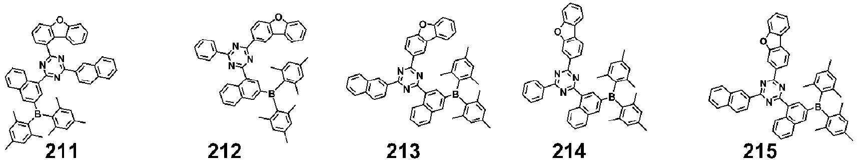

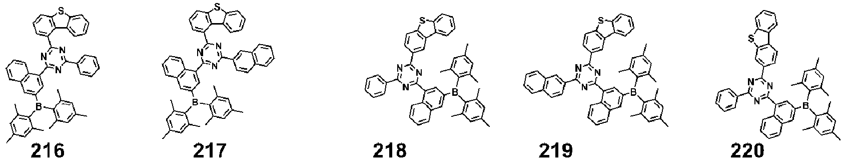

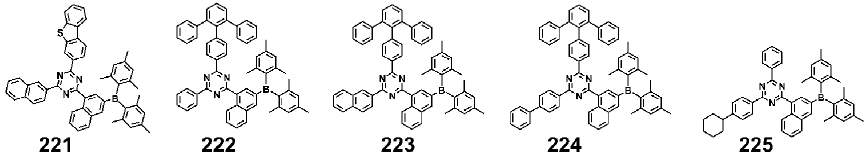

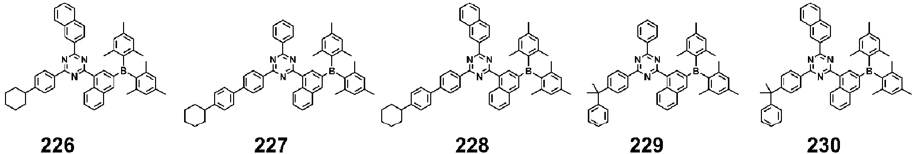

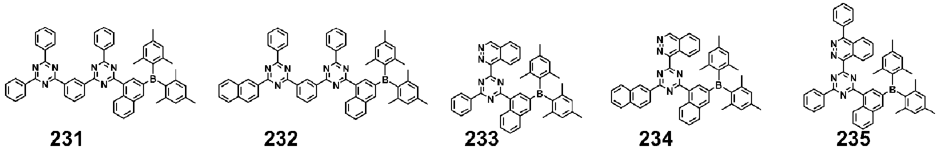

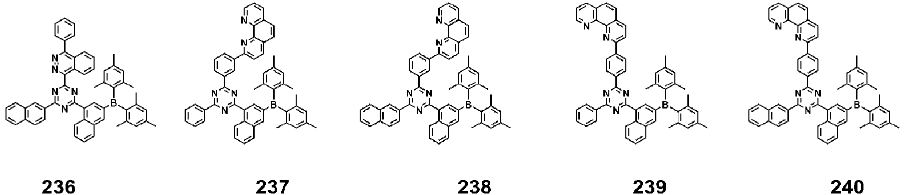

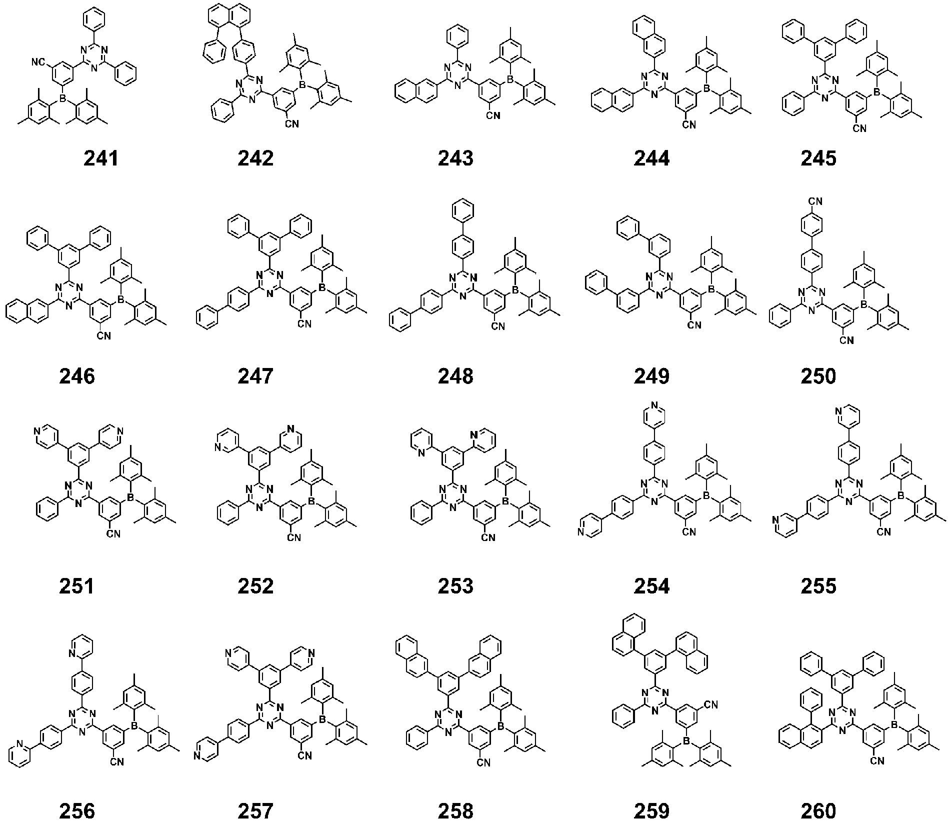

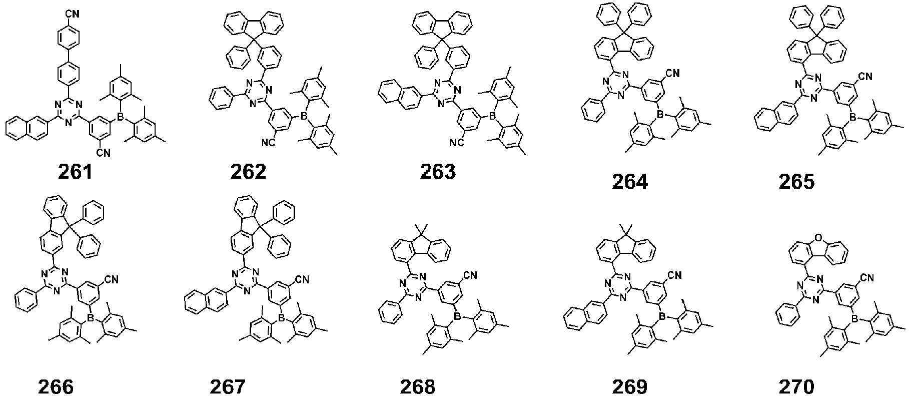

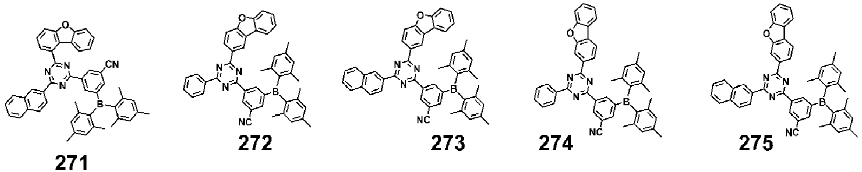

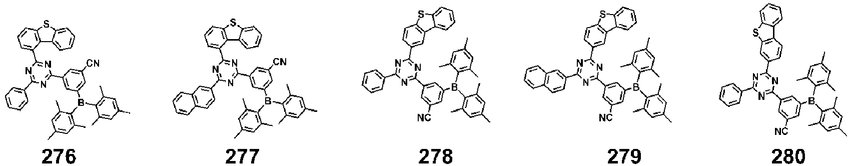

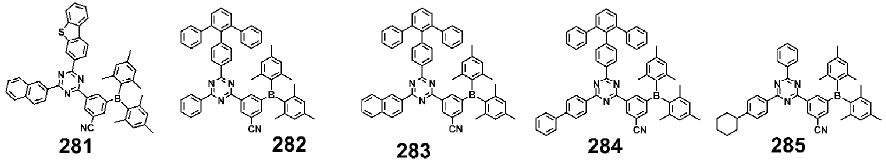

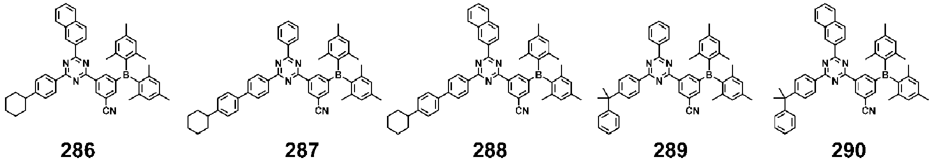

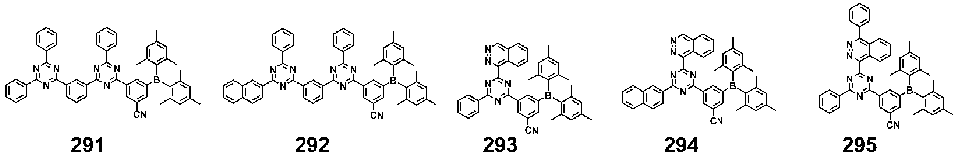

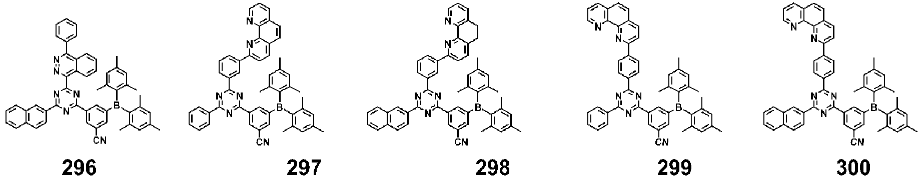

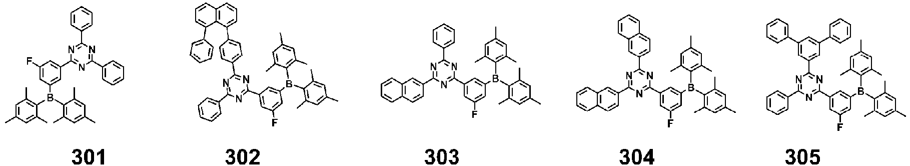

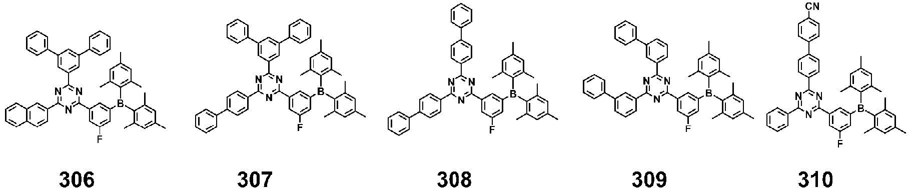

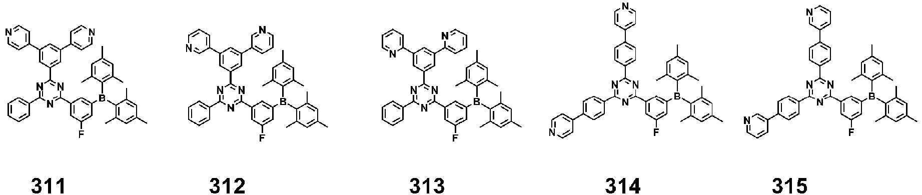

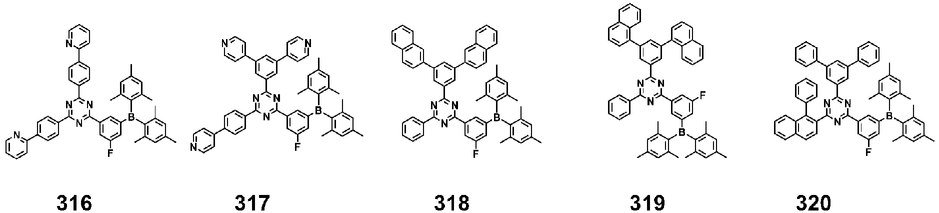

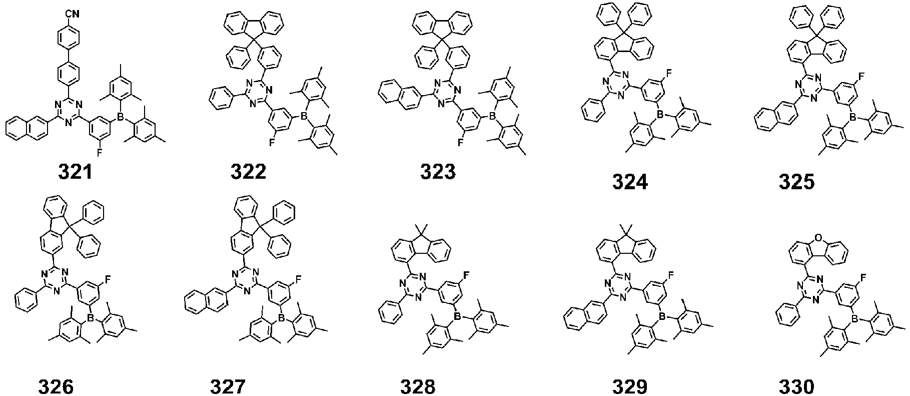

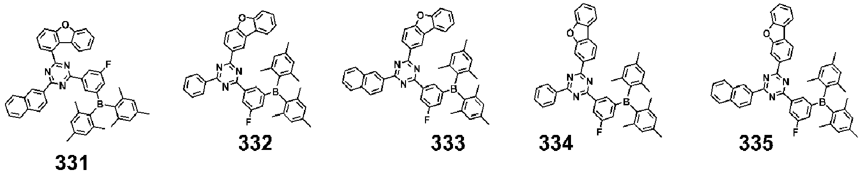

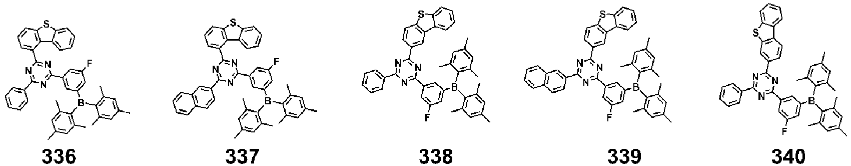

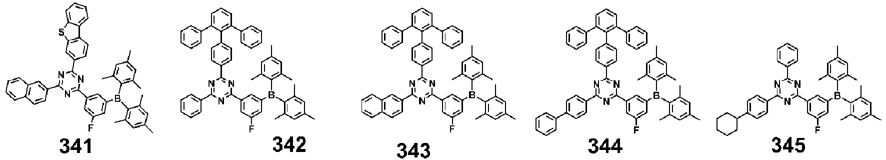

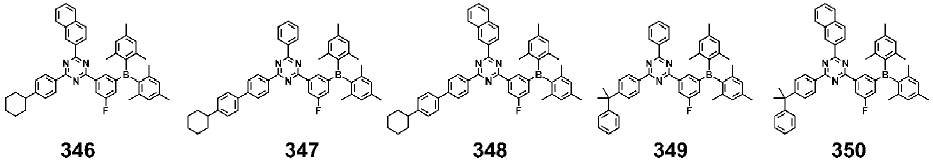

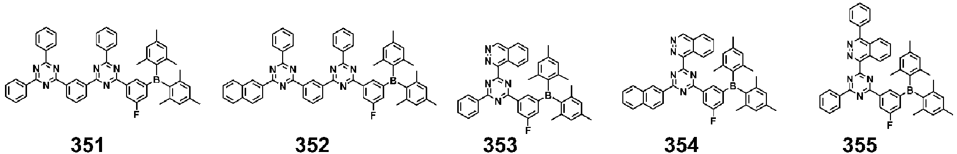

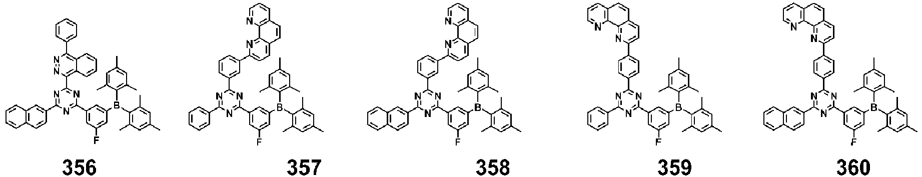

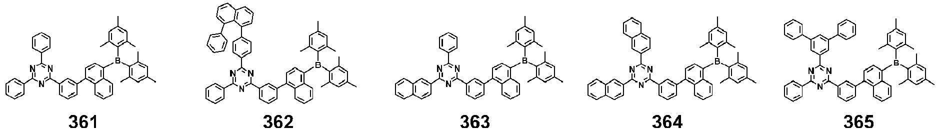

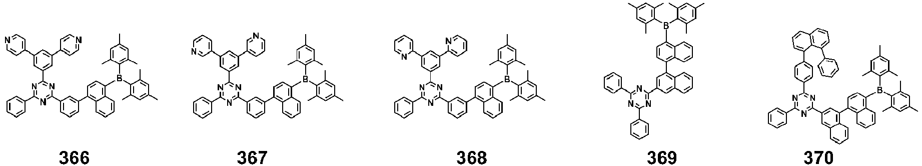

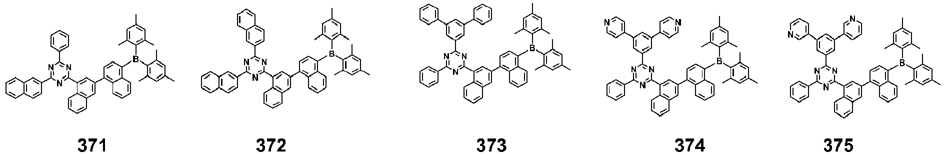

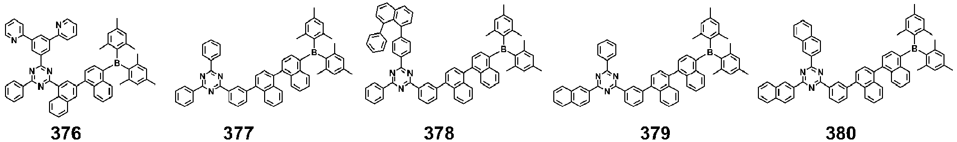

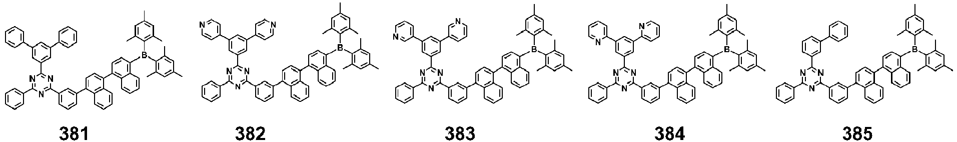

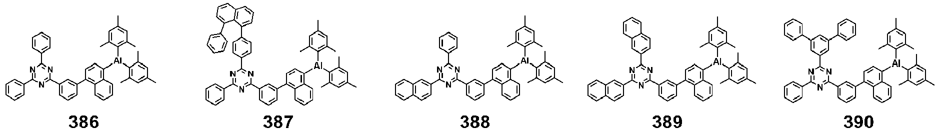

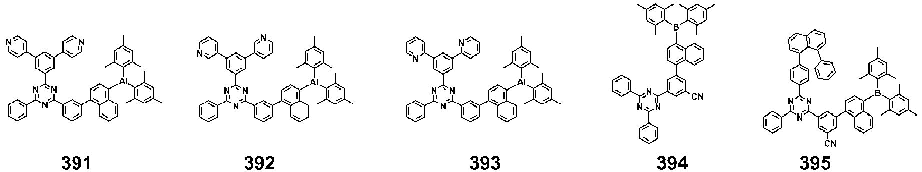

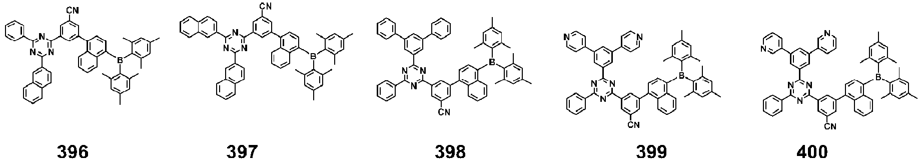

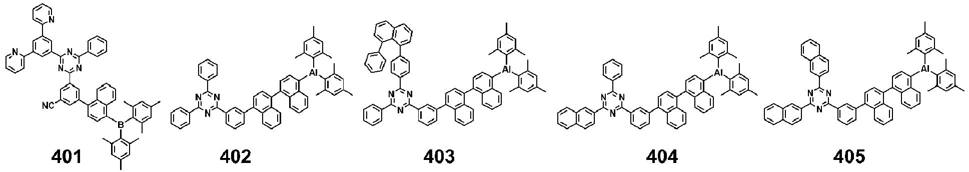

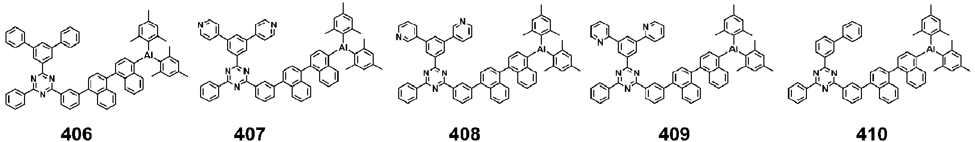

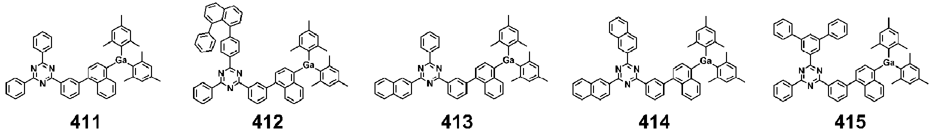

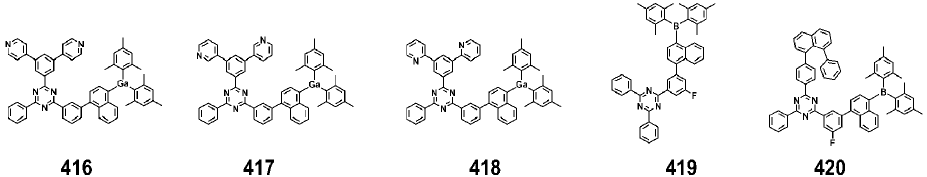

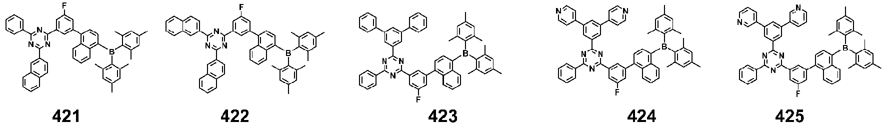

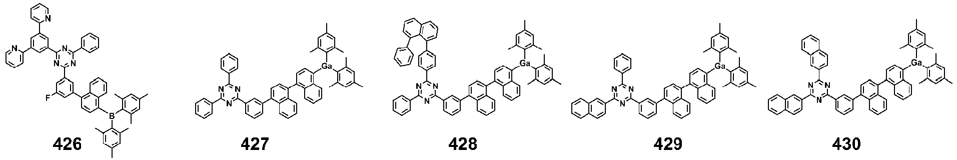

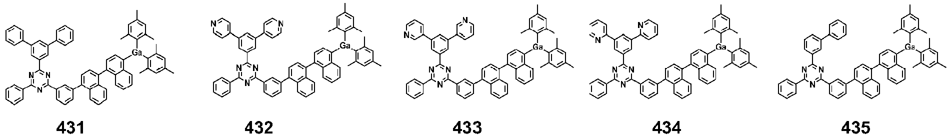

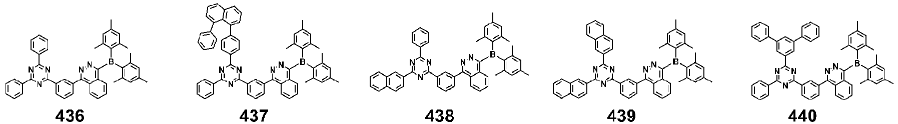

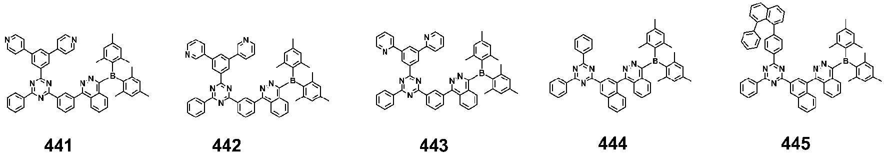

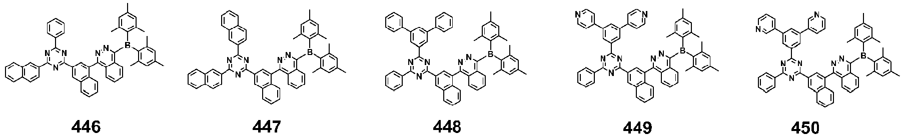

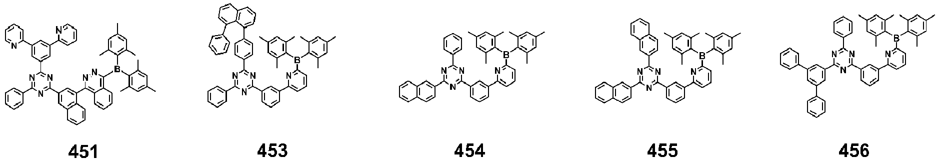

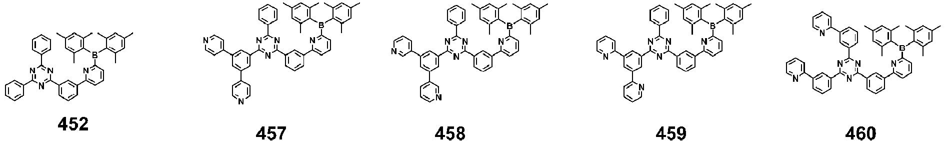

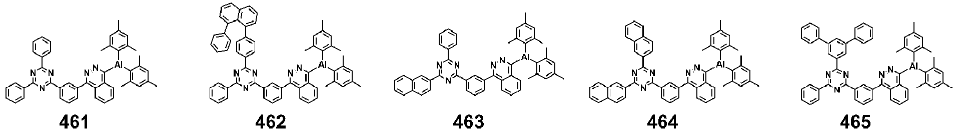

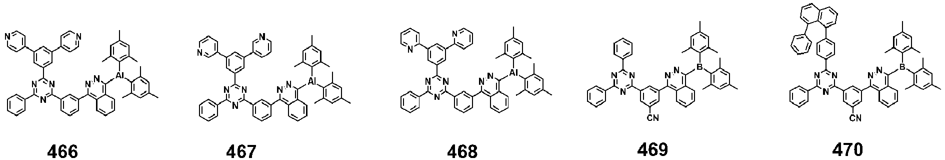

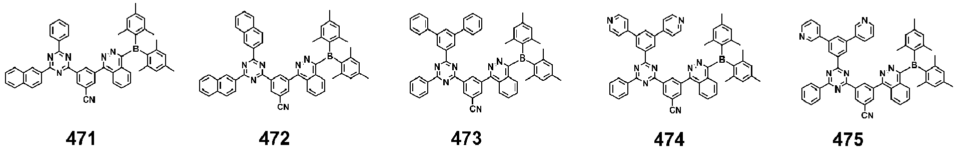

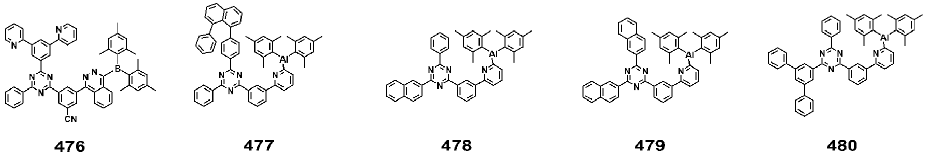

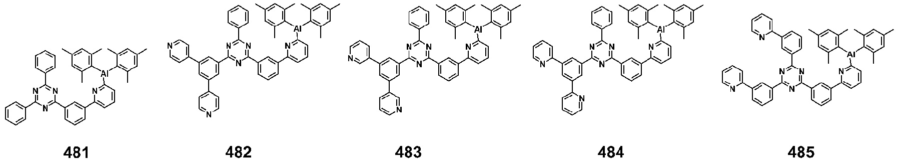

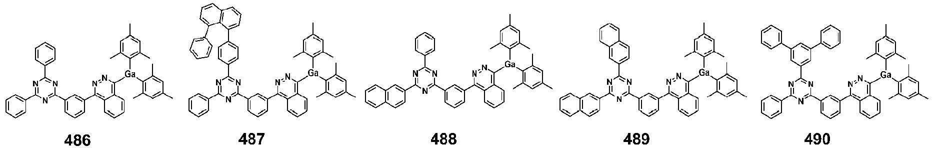

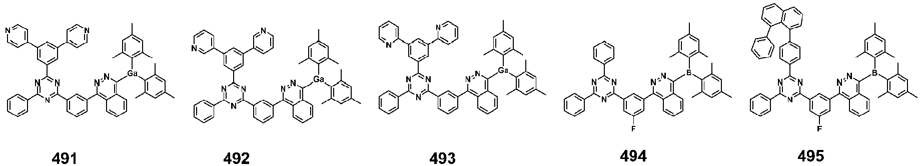

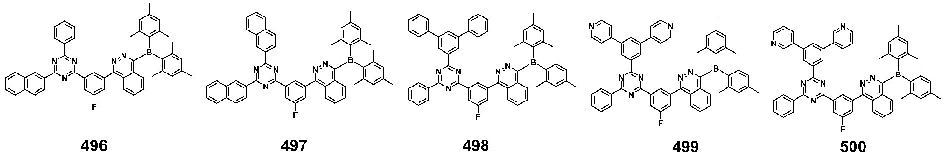

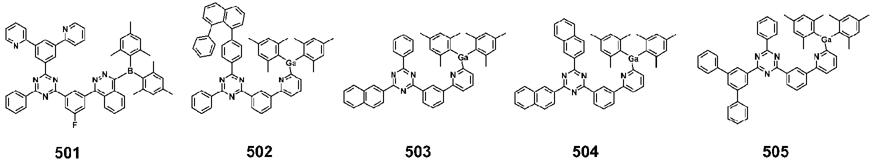

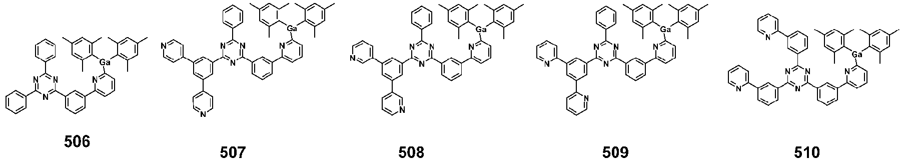

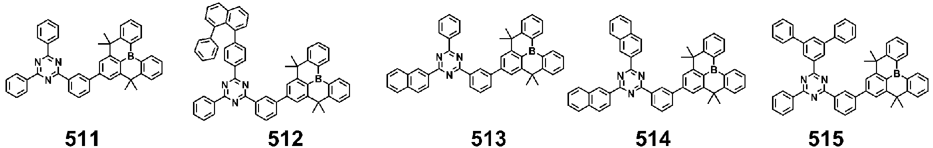

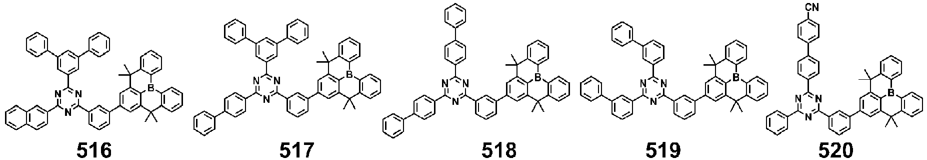

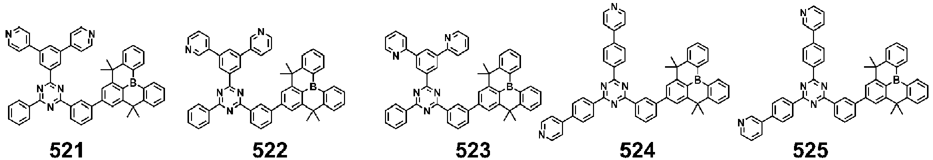

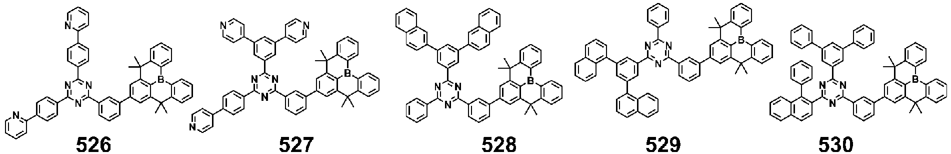

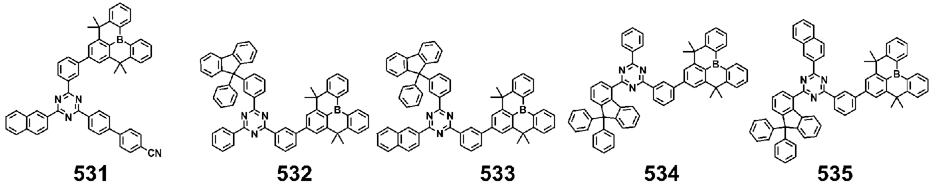

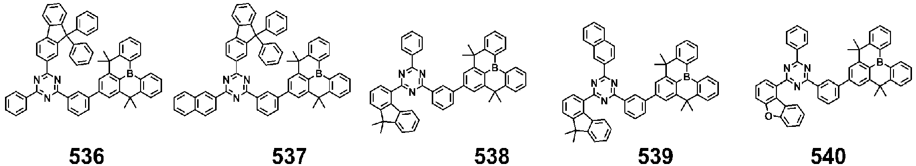

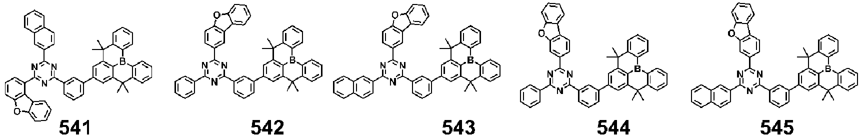

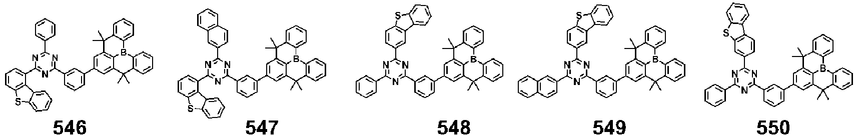

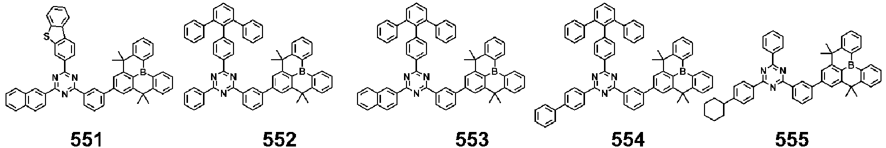

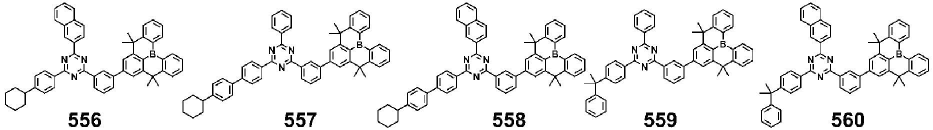

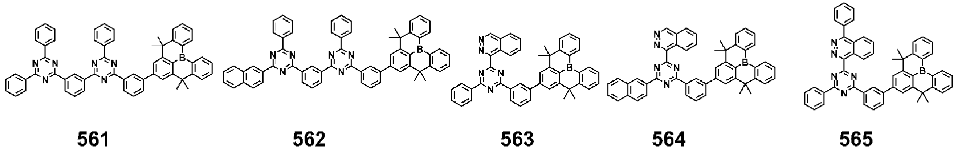

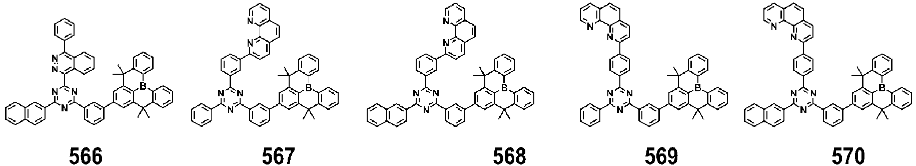

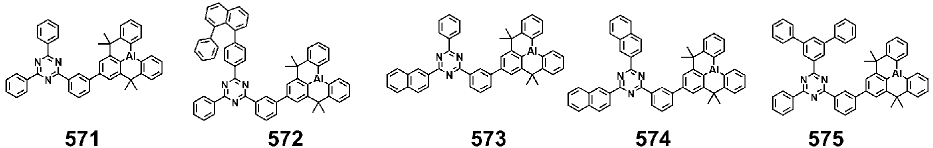

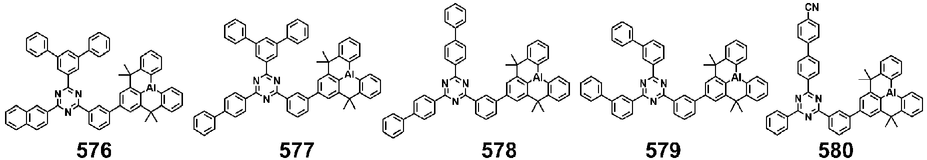

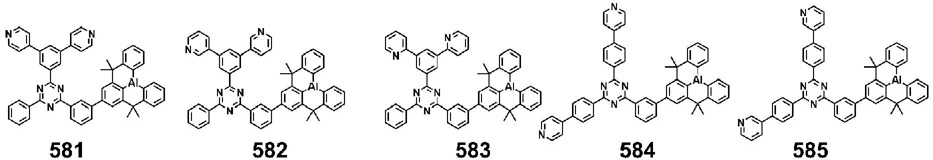

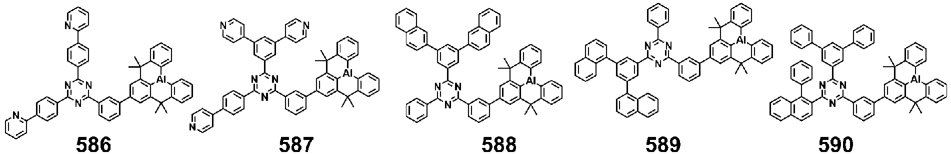

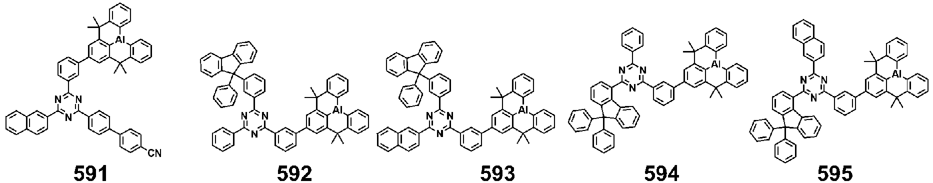

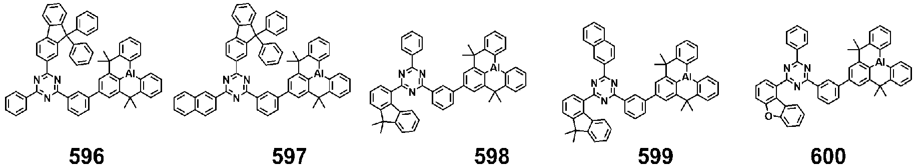

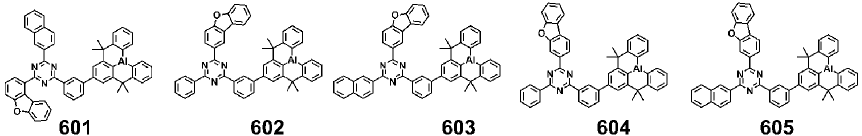

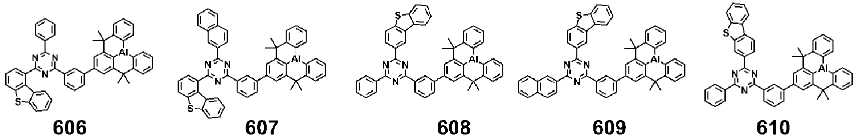

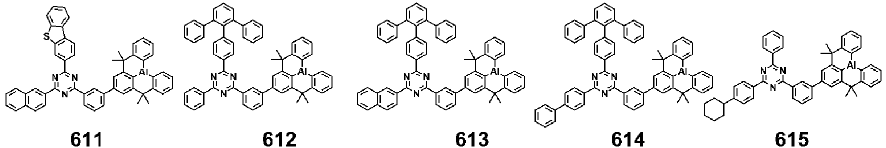

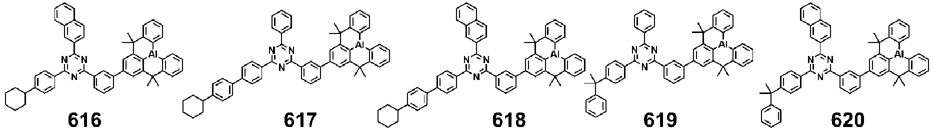

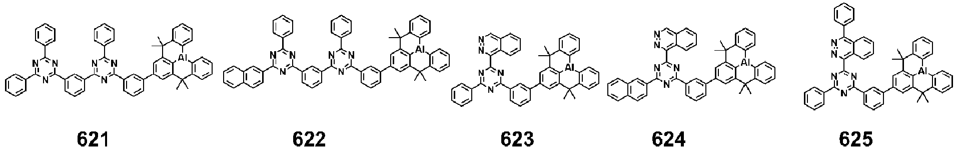

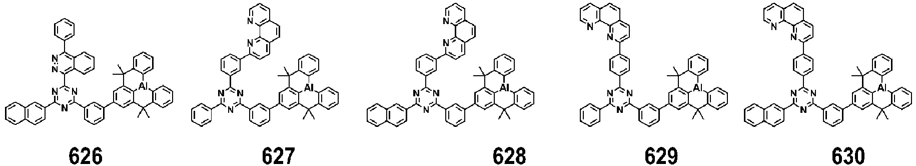

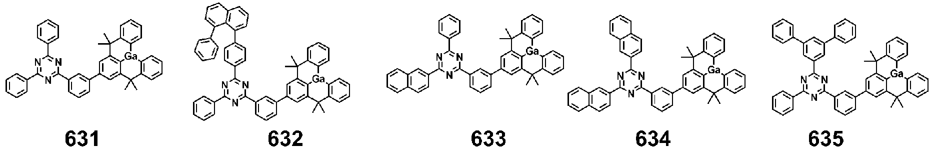

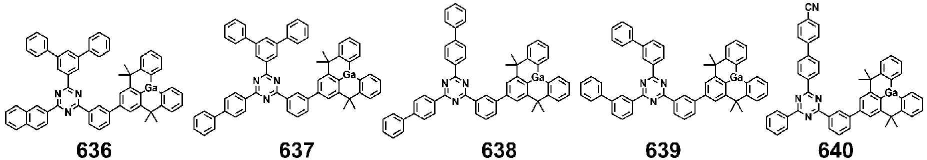

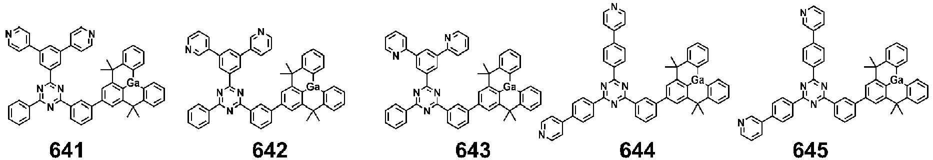

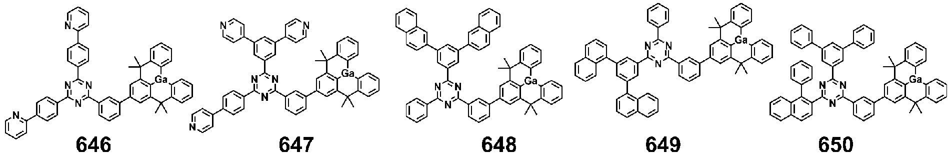

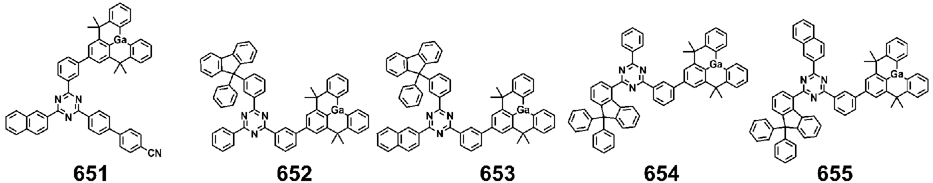

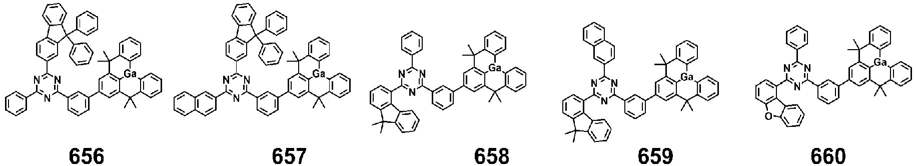

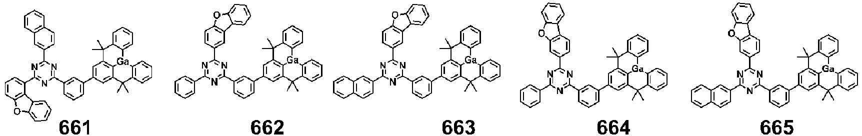

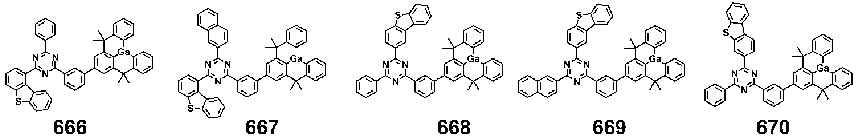

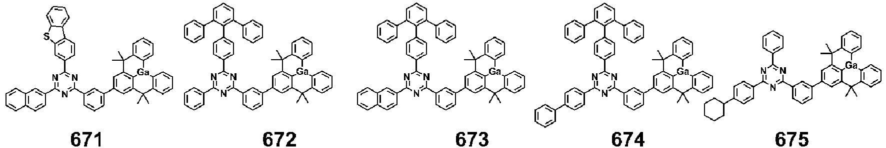

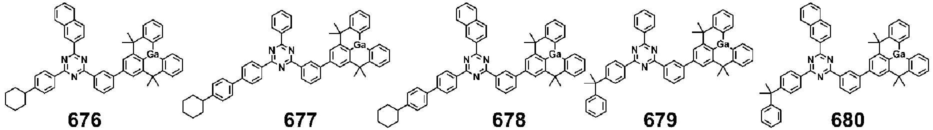

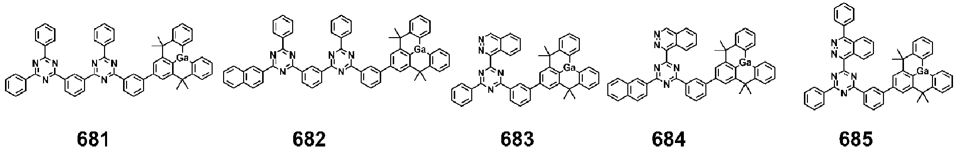

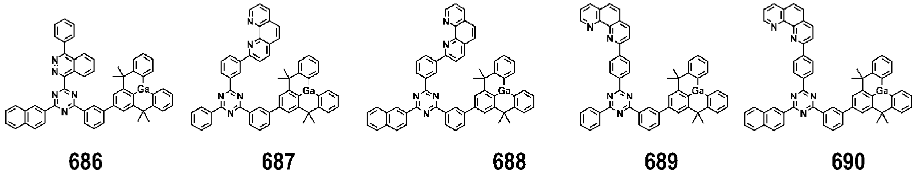

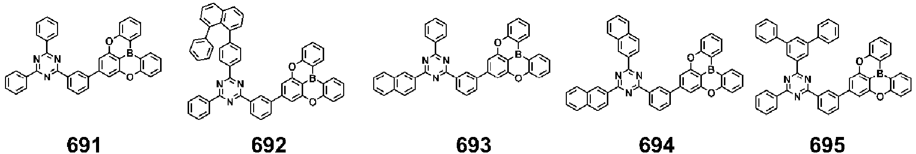

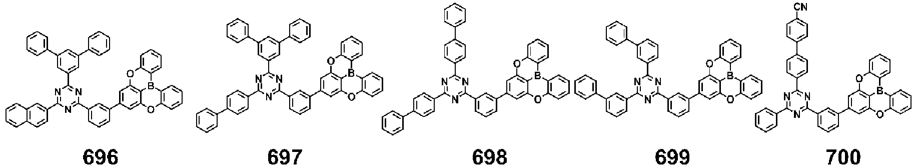

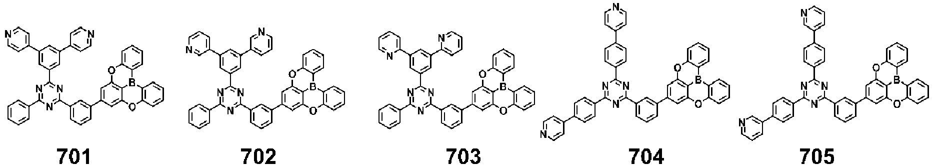

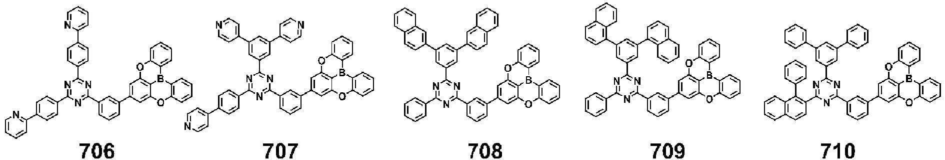

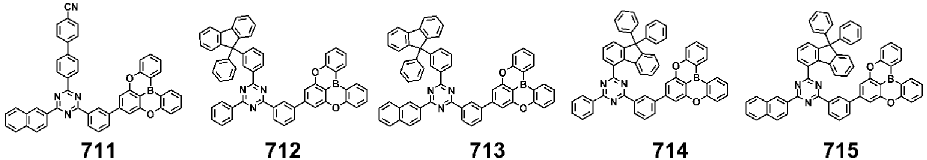

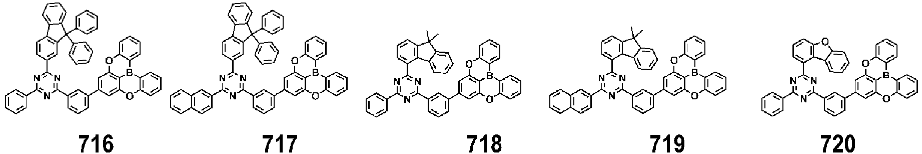

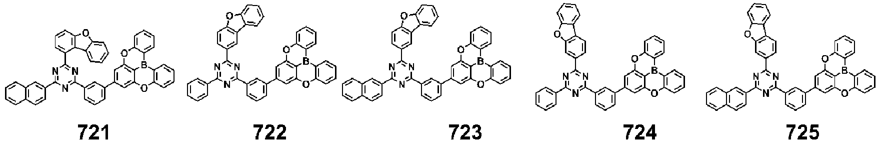

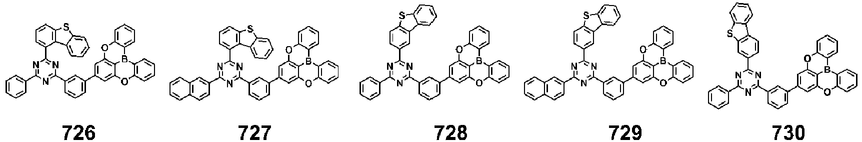

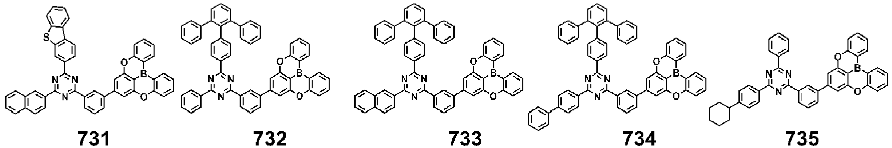

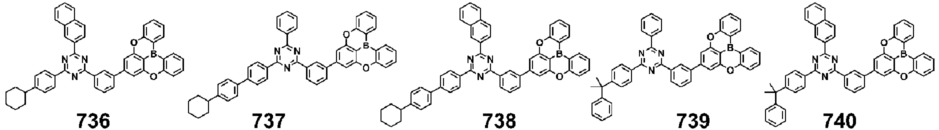

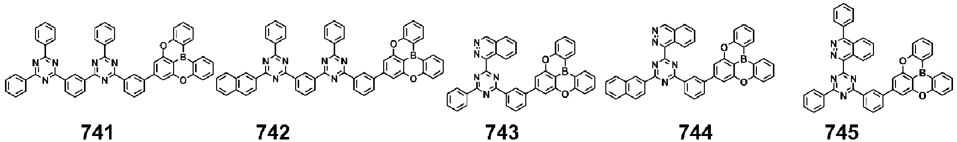

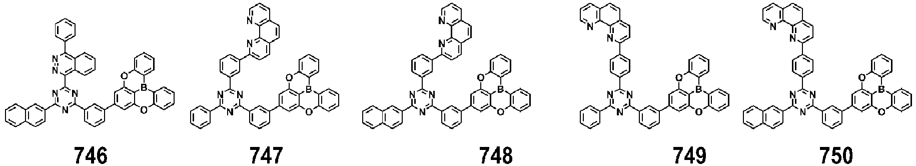

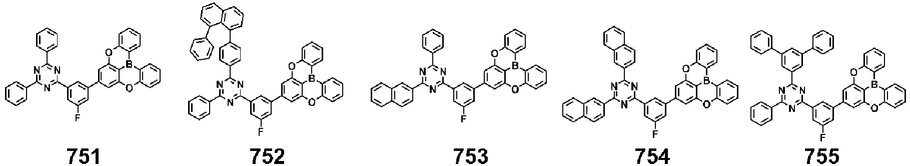

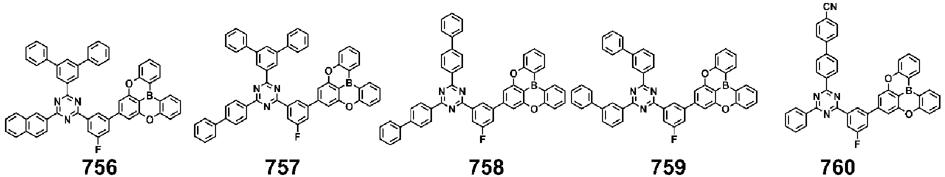

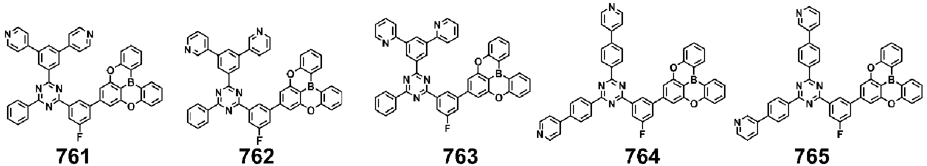

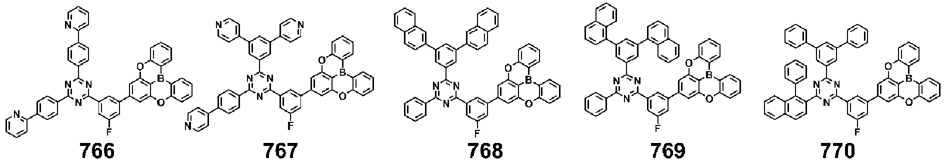

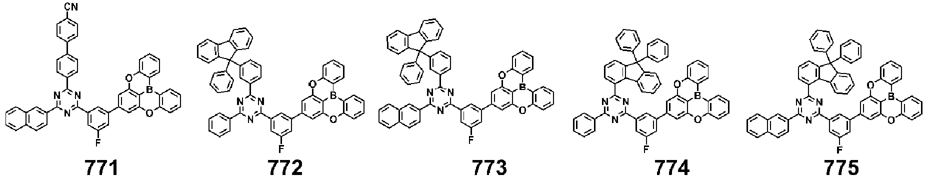

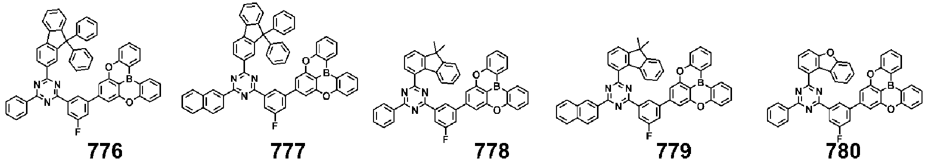

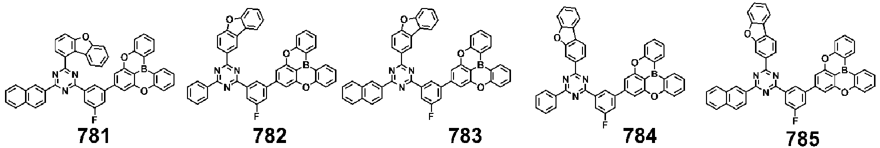

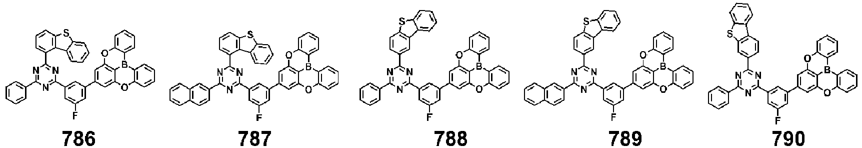

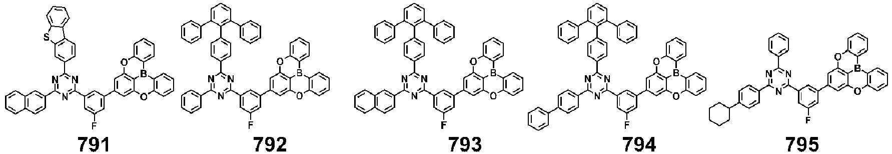

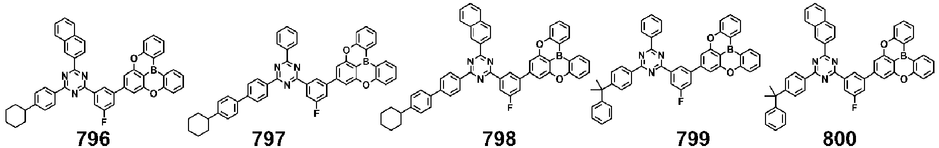

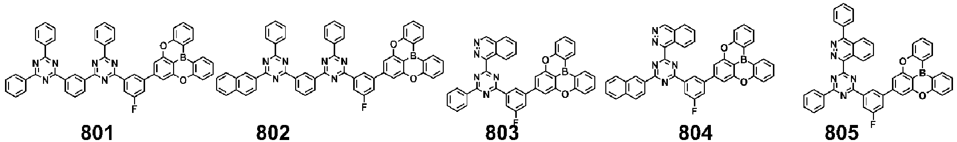

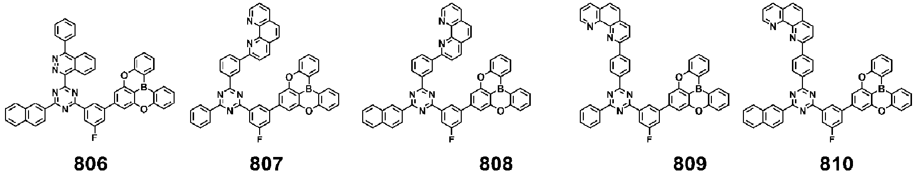

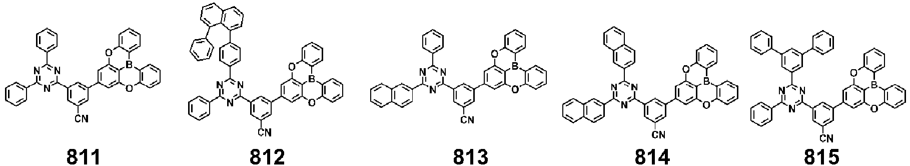

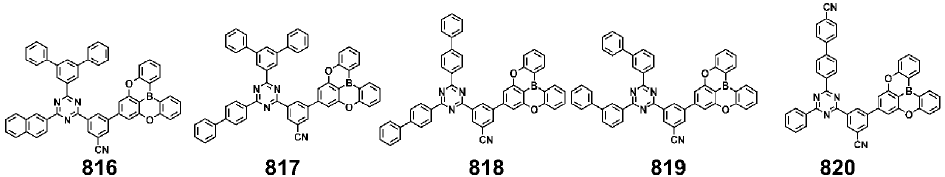

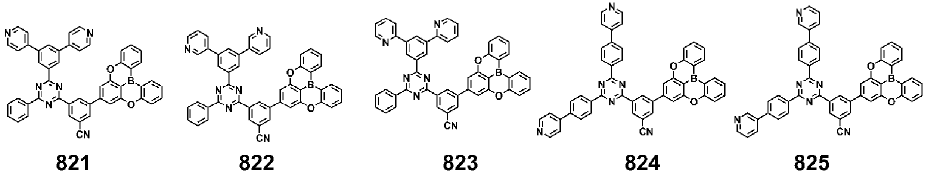

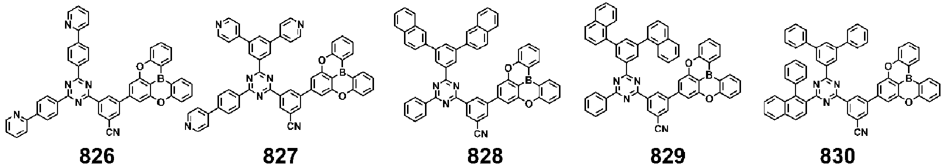

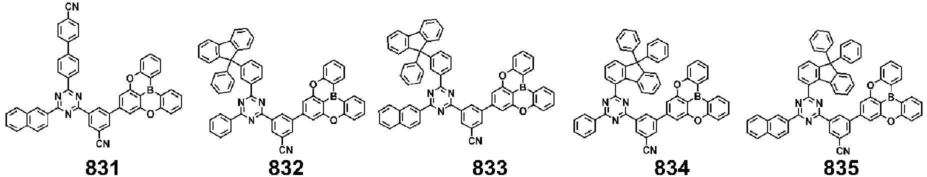

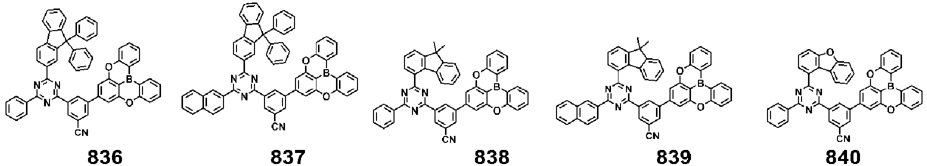

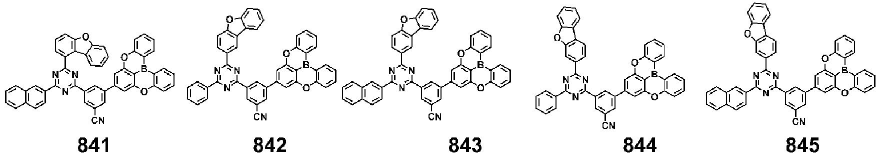

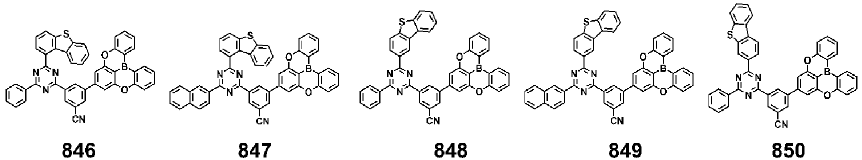

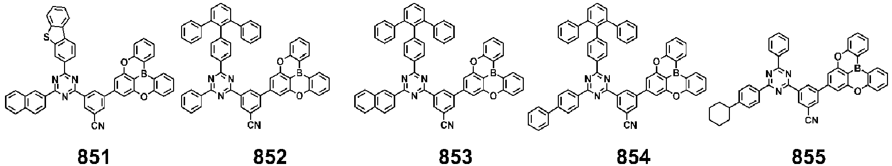

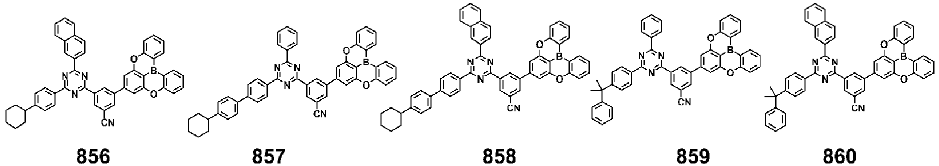

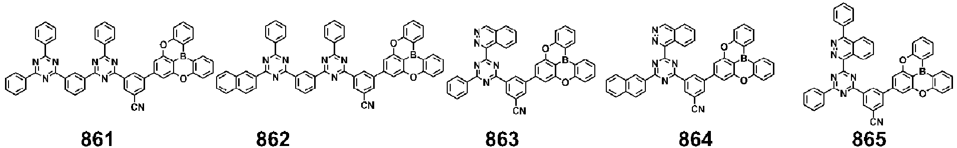

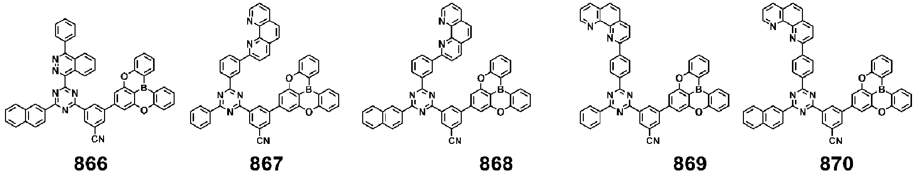

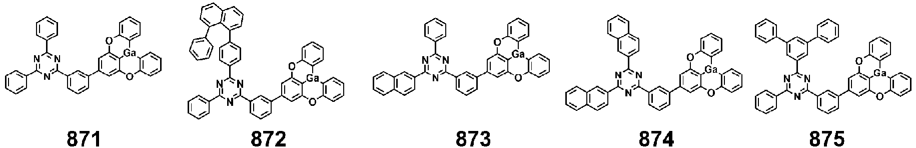

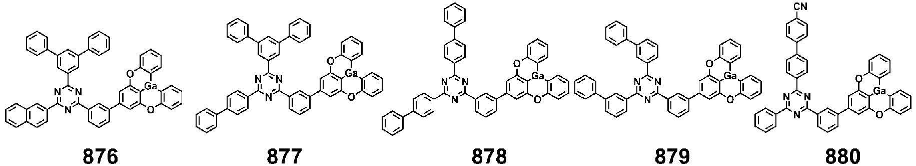

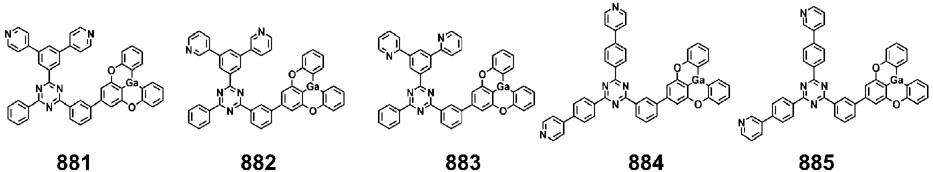

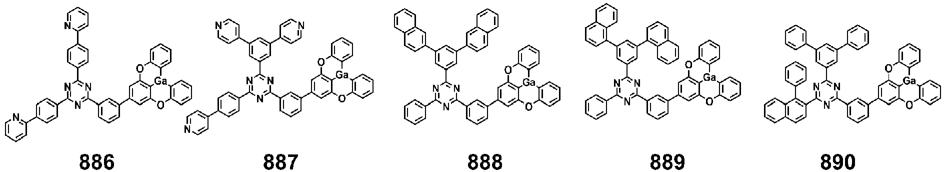

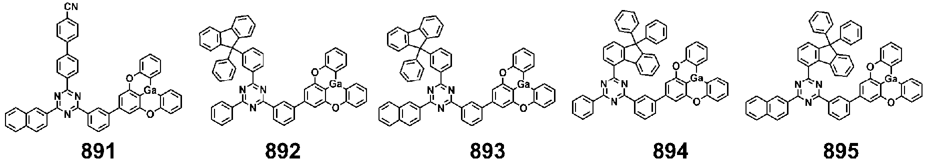

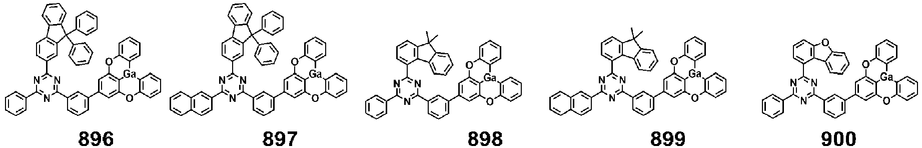

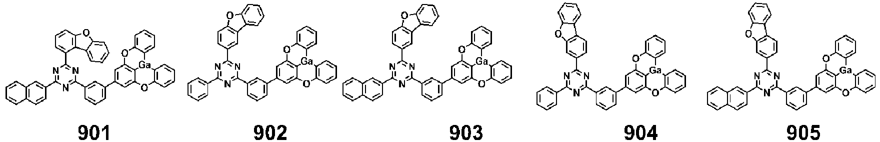

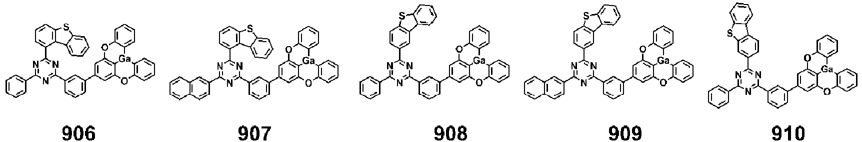

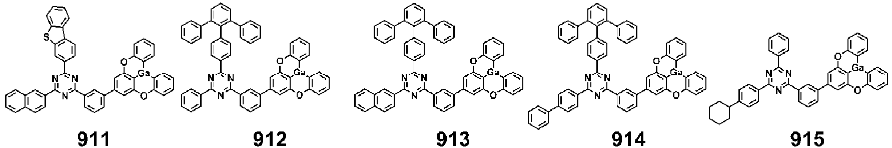

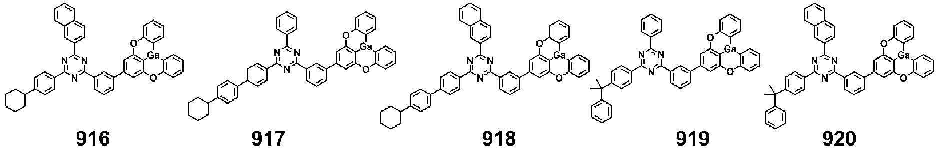

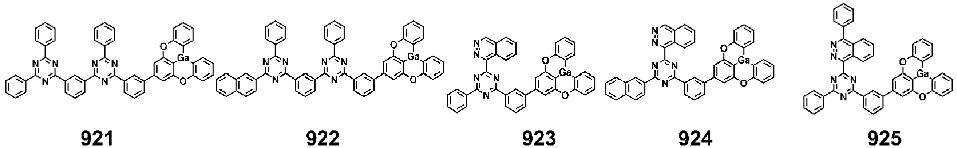

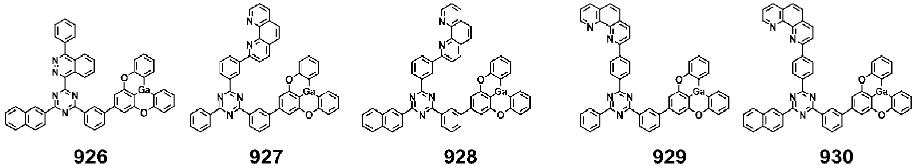

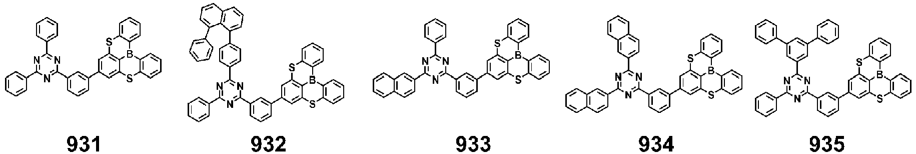

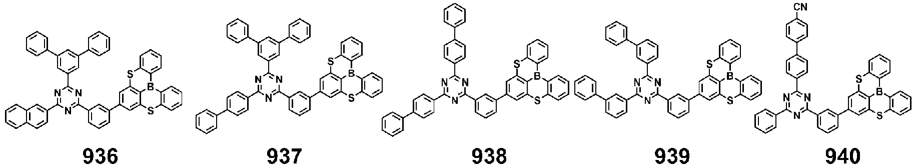

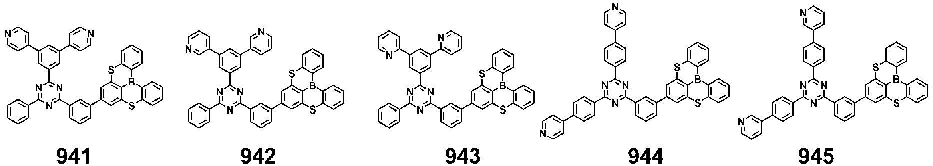

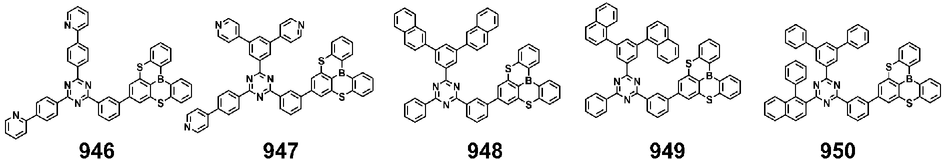

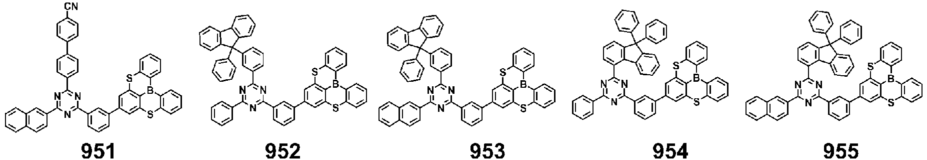

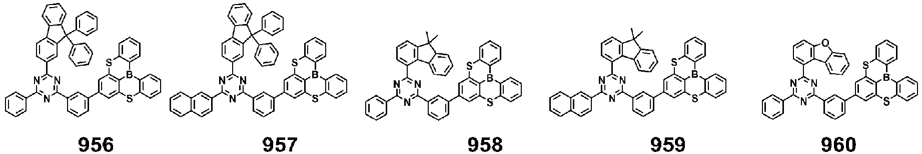

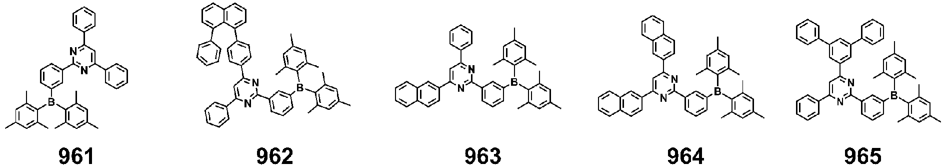

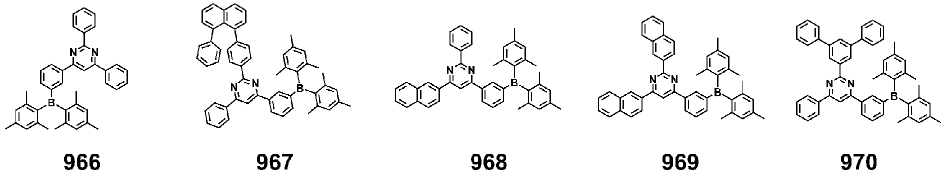

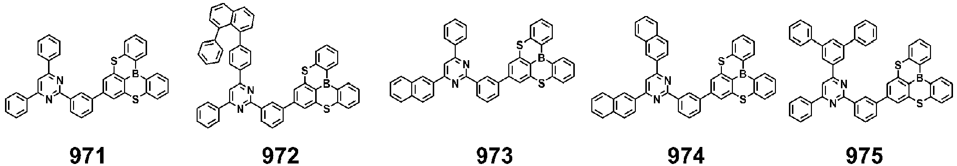

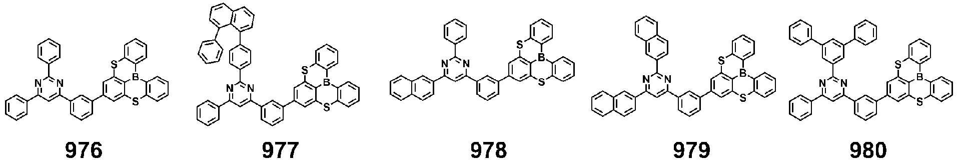

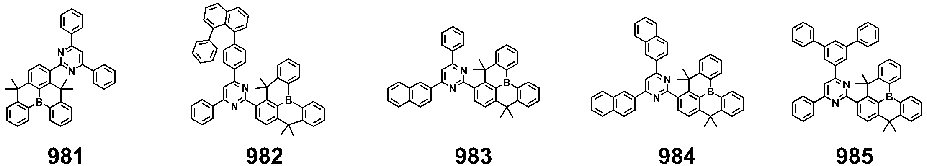

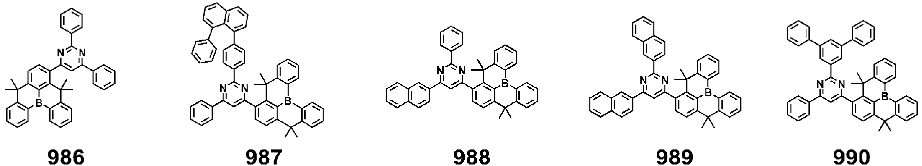

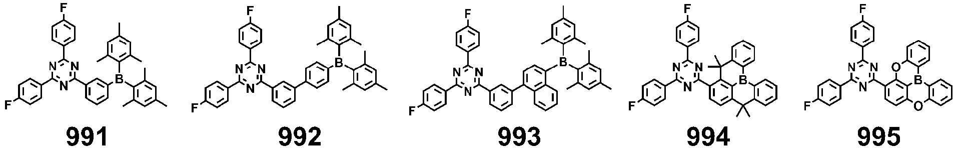

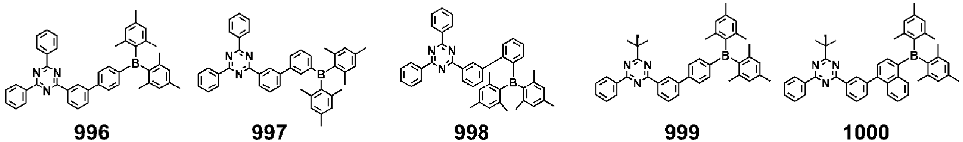

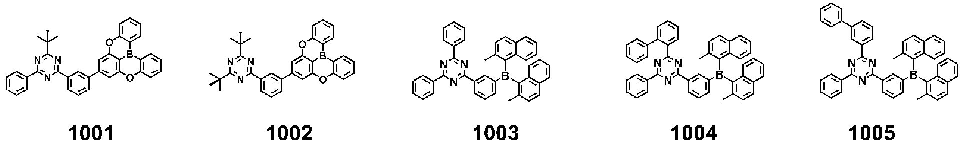

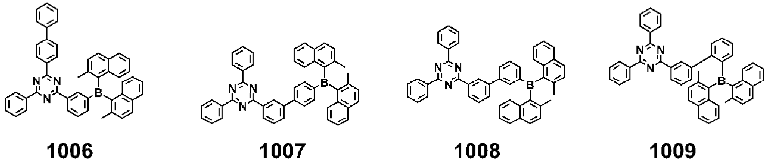

In the heterocyclic compound represented by Formula 1, a π electron-deficient nitrogen-containing C₁-C₆₀ heterocyclic group is linked via a phenyl linker to a *-M(R₂)(R₃) substituent including M, which is a Group 13 element. In this regard, the phenyl linker links the π electron-deficient nitrogen-containing C₁-C₆₀ heterocyclic group to the *-M(R₂)(R₃) substituent in a meta structure. For example, electron-transporting ability may be improved by the π electron-deficient nitrogen-containing C₁-C₆₀ heterocyclic group and the *-M(R₂)(R₃) substituent, and as electron-withdrawing groups are substituted in a meta structure in the phenyl linker, electron-transporting ability may be strengthened, and overall material stability may also be improved. Accordingly, when the heterocyclic compound represented by Formula 1 is applied to an organic light-emitting device (for example, applied to an electron transport region of an organic light-emitting device), high efficiency and long lifespan may be achieved.

Synthesis methods of the heterocyclic compound represented by Formula 1 may be recognizable by one of ordinary skill in the art by referring to Synthesis Examples and/or Examples provided herein.

According to one or more embodiments of the present disclosure, at least one heterocyclic compound represented by Formula 1 may be utilized in a light-emitting device (e.g., an organic light-emitting device). Accordingly, provided is a light-emitting device including: a first electrode; a second electrode facing the first electrode; an interlayer between the first electrode and the second electrode and including an emission layer; and the heterocyclic compound represented by Formula 1.

In one or more embodiments,
the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron-blocking layer, or any combination thereof, and
the electron transport region may include a buffer layer, a hole-blocking layer, an electron control layer, an electron transport layer, an electron injection layer, or any combination thereof.
In one or more embodiments, the heterocyclic compound may be included between the first electrode and the second electrode of the light-emitting device. Accordingly, the heterocyclic compound may be included in the interlayer of the light-emitting device, for example, in the electron transport region of the interlayer.

In one or more embodiments, the electron transport layer may include the heterocyclic compound.

In one or more embodiments, the emission layer in the interlayer of the light-emitting device may include a dopant and a host. The emission layer may be to emit red light, green light, blue light, and/or white light (e.g., combined white light). For example, in some embodiments, the emission layer may be to emit blue light. The blue light may have a maximum emission wavelength in a range of, for example, about 400 nm to about 490 nm.

In one or more embodiments, the blue light may have a maximum emission wavelength in a range of about 430 nm to about 480 nm, about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, the heterocyclic compound may be included in the host. For example, the heterocyclic compound may act as a host.

In one or more embodiments, the emission layer in the interlayer of the light-emitting device may include a dopant and a host, the dopant may include a transition metal-containing compound, the transition metal-containing compound may include a transition metal and ligand(s) in the number of m, m may be an integer from 1 to 6, the ligand(s) in the number of m may be identical to or different from each other, at least one of the ligand(s) in the number of m and the transition metal may be linked to each other via a carbon-transition metal bond, and the carbon-transition metal bond may be a coordinate bond. For example, in some embodiments, at least one of the ligand(s) in the number of m may be a carbene ligand (e.g., Ir(pmp)₃, etc.). The transition metal may be, for example, iridium, platinum, osmium, palladium, rhodium, gold, or the like. The dopant may be to emit blue light. More details on the emission layer and the dopant may be the same as described herein.

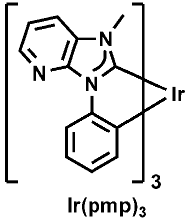

In one or more embodiments, the emission layer in the interlayer of the light-emitting device may include a dopant and a host, the host may include a second compound and a third compound, the second compound including at least one π electron-deficient nitrogen-containing C₁-C₆₀ heterocyclic group, and the third compound including a group represented by Formula 3 described herein, and the dopant may be to emit blue light. The second compound and the third compound in the light-emitting device may be different from each other.

In one or more embodiments, the second compound and the third compound may form an exciplex.

For example, in some embodiments, the second compound may include a pyridine group, a pyrimidine group, a pyrazine group, a pyridazine group, a triazine group, or any combination thereof.

In one or more embodiments, the second compound may include a compound represented by Formula 2: 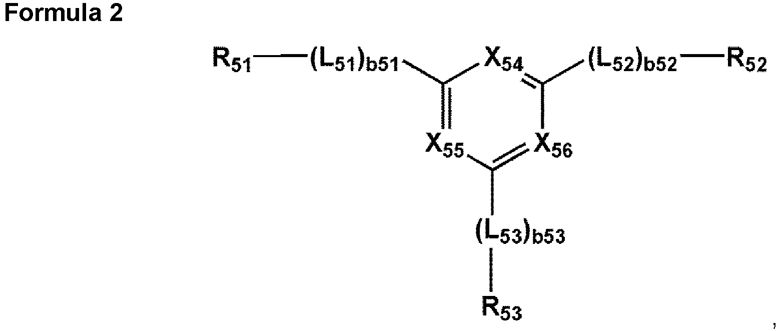 wherein, in Formula 2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one selected from among X₅₄ to X₅₆ may be N, and
R₅₁ to R₅₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂).

R₁₀ₐ and Q₁ to Q₃ may each be the same as described herein.

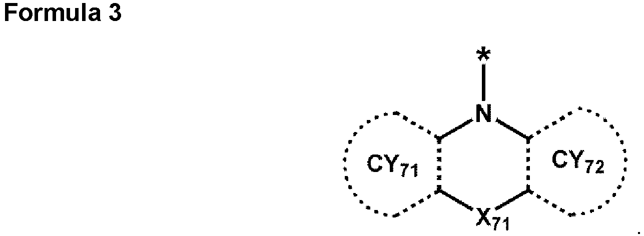

In Formula 3,
ring CY₇₁ and ring CY₇₂ may each independently be a π electron-rich C₃-C₆₀ cyclic group or a pyridine group,
X₇₁ may be a single bond, or a linking group including O, S, N, B, C, Si, or any combination thereof, and
* indicates a binding site to any atom included in a remaining portion of the third compound other than the group represented by Formula 3.

For example, in one or more embodiments, the third compound may not include (e.g., may exclude) any compound represented by Formula 3-1 described herein.

For example, in one or more embodiments, the following compounds may be excluded from the third compound:

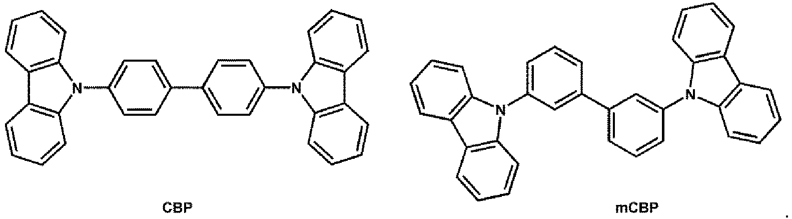

In one or more embodiments, the third compound may include a compound represented by Formula 3-1, a compound represented by Formula 3-2, a compound represented by Formula 3-3, a compound represented by Formula 3-4, a compound represented by Formula 3-5, or any combination thereof: 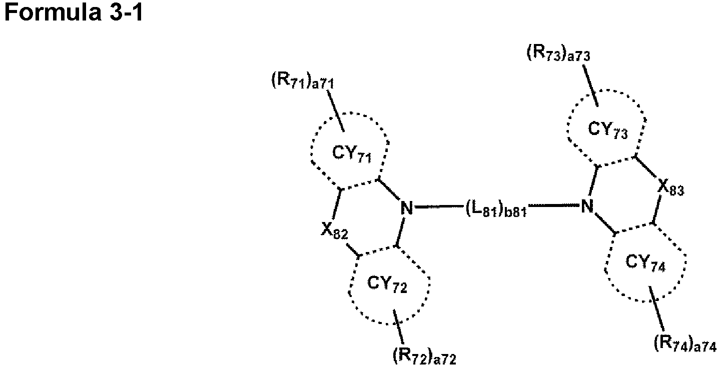 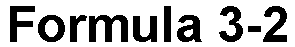 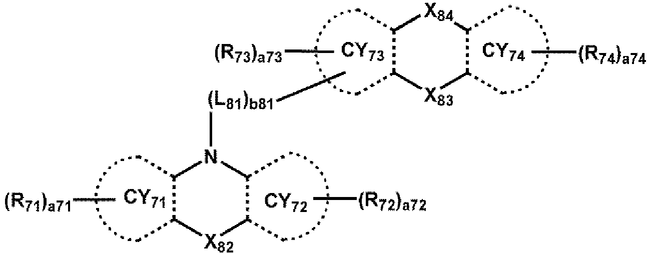 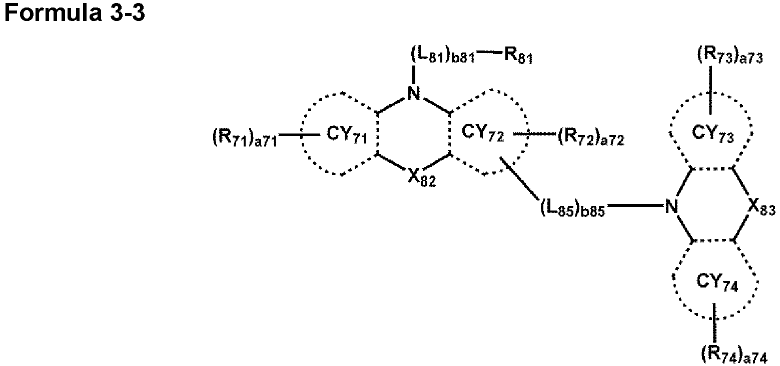 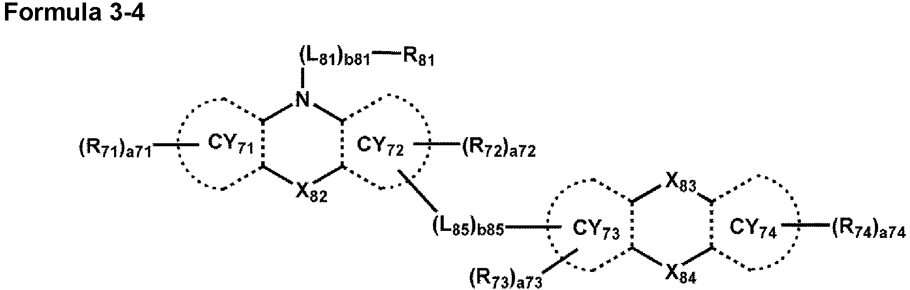 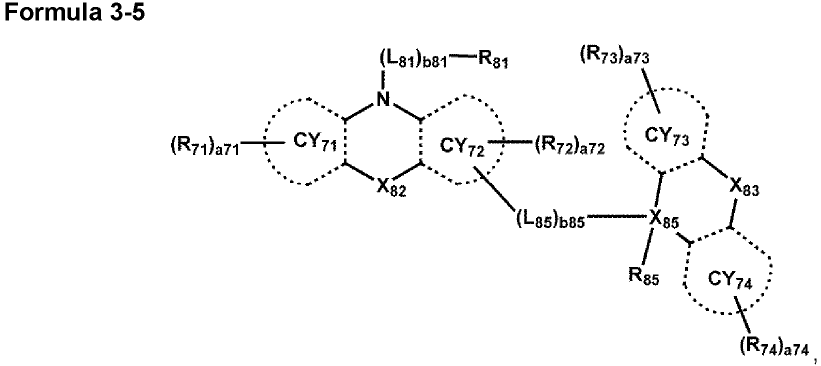
ring CY₇₁ to ring CY₇₄ may each independently be a π electron-rich C₃-C₆₀ cyclic group or a pyridine group,
X₈₂ may be a single bond, O, S, N[(L₈₂)_{b82}-R₈₂], C(R₈₂ₐ)(R_{82b}), or Si(R82a)(R82b),
X₈₃ may be a single bond, O, S, N[(L₈₃)_{b83}-R₈₃], C(R₈₃ₐ)(R_{83b}), or Si(R83a)(R83b),
X₈₄ may be O, S, N[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each be the same as described herein with respect to Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
a71 to a74 may each independently be an integer from 0 to 20, and
R₁₀ₐ and Q₁ to Q₃ may each be the same as described herein.

In one or more embodiments, the emission layer in the interlayer of the light-emitting device may include a dopant and a host, and the dopant may include a transition metal-containing compound, a delayed fluorescence material, or any combination thereof. The delayed fluorescence material may be a compound in which a difference between a triplet energy level (eV) of the compound and a singlet energy level (eV) of the compound is at least 0 eV but not more than 0.5 eV (or at least 0 eV but not more than 0.3 eV).

In one or more embodiments, the delayed fluorescence material may be a compound including at least one cyclic group including boron (B) and nitrogen (N) as ring-forming atoms.

In one or more embodiments, the delayed fluorescence material may be a C₈-C₆₀ polycyclic group-containing compound including two or more cyclic groups (e.g., one being a first ring and another being a second ring) condensed to each other while sharing boron (B).

In one or more embodiments, the delayed fluorescence material may include a condensed ring in which at least one third ring is condensed with at least one fourth ring, for example, to form the condensed ring including four or more rings,

the third ring of the delayed fluorescence compound may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and

the fourth ring of the delayed fluorescence compound may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the delayed fluorescence material may include a compound represented by Formula 502, a compound represented by Formula 503, or any combination thereof: 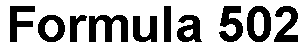 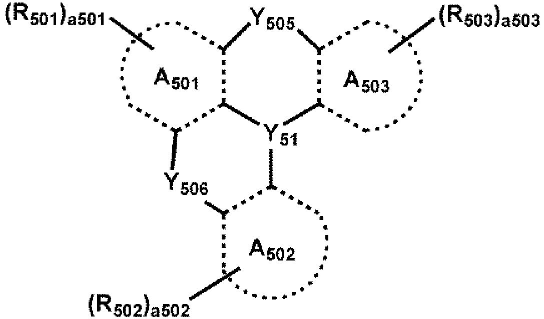 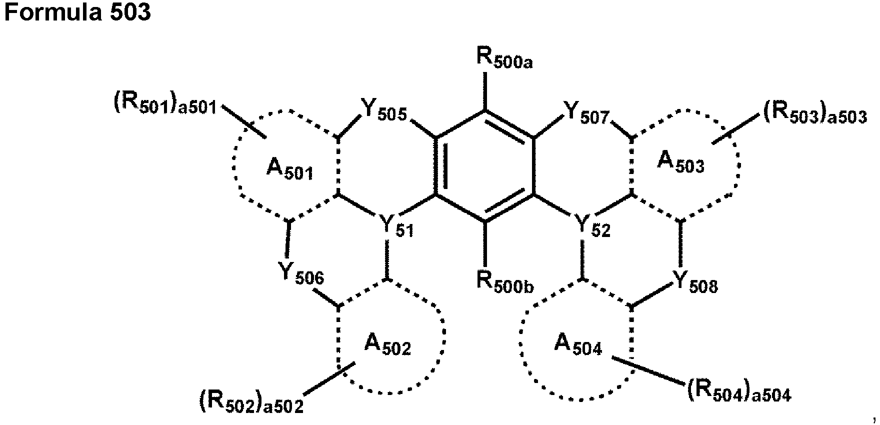 wherein, in Formulae 502 and 503,
ring A₅₀₁ to ring A₅₀₄ may each independently be a C₃-C₆₀ carbocyclic group or a C₁-C₆₀ heterocyclic group,
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
a501 to a504 may each independently be an integer from 0 to 20.
R₁₀ₐ and Q₁ to Q₃ may each be the same as described herein.

In one or more embodiments, the light-emitting device may satisfy at least one condition selected from among Conditions 1 to 4:

### Condition 1

lowest unoccupied molecular orbital (LUMO) energy level (eV) of third compound > LUMO energy level (eV) of transition metal-containing compound

### Condition 2

LUMO energy level (eV) of transition metal-containing compound > LUMO energy level (eV) of second compound

### Condition 3

highest occupied molecular orbital (HOMO) energy level (eV) of transition metal-containing compound > HOMO energy level (eV) of third compound

### Condition 4

HOMO energy level (eV) of third compound > HOMO energy level (eV) of second compound.

Each of the HOMO energy level and LUMO energy level of each of the transition metal-containing compound, the second compound, and the third compound may be a negative value, and may be measured according to a suitable method.

In one or more embodiments, an absolute value of a difference between the LUMO energy level of the transition metal-containing compound and the LUMO energy level of the second compound may be at least about 0.1 eV but not more than about 1.0 eV or an absolute value of a difference between the LUMO energy level of the transition metal-containing compound and the LUMO energy level of the third compound may be at least about 0.1 eV but not more than about 1.0 eV, and an absolute value of a difference between the HOMO energy level of the transition metal-containing compound and the HOMO energy level of the second compound may be about 1.25 eV or less (e.g., at least about 0.2 eV but not more than about 1.25 eV) or an absolute value of a difference between the HOMO energy level of the transition metal-containing compound and the HOMO energy level of the third compound may be about 1.25 eV or less (e.g., at least about 0.2 eV but not more than about 1.25 eV).

When the relationships between LUMO energy level and HOMO energy level satisfy the conditions as described above, a balance between holes and electrons injected into the emission layer may be achieved.

In one or more embodiments, the electron transport region of the light-emitting device may include a hole-blocking layer, and the hole-blocking layer may include a phosphine oxide-containing compound, a silicon-containing compound, or any combination thereof. For example, the hole-blocking layer may directly contact the emission layer.

In one or more embodiments, the light-emitting device may include a capping layer arranged outside (e.g., on) the first electrode and/or outside (e.g., on) the second electrode.

For example, in one or more embodiments, the light-emitting device may further include at least one of a first capping layer arranged on a surface of the first electrode or a second capping layer arranged on a surface of the second electrode, and at least one of the first capping layer or the second capping layer may include the heterocyclic compound represented by Formula 1. More details on the first capping layer and/or the second capping layer may be the same as described herein.

In one or more embodiments, the light-emitting device may further include a first capping layer arranged on a surface of the first electrode. For example, the first capping layer may include the heterocyclic compound represented by Formula 1.

In one or more embodiments, the light-emitting device may further include a second capping layer arranged on a surface of the second electrode. For example, the second capping layer may include the heterocyclic compound represented by Formula 1.

In one or more embodiments, the light-emitting device may further include a first capping layer arranged on a surface of the first electrode and a second capping layer arranged on a surface of the second electrode. For example, at least one of the first capping layer or the second capping layer may include the heterocyclic compound represented by Formula 1.

The expression "(an interlayer and/or a capping layer) includes at least one heterocyclic compound" as utilized herein may include a case (e.g., an embodiment) in which "(an interlayer and/or a capping layer) includes identical heterocyclic compounds represented by Formula 1" and a case (e.g., an embodiment) in which "(an interlayer and/or a capping layer) includes two or more different heterocyclic compounds represented by Formula 1."

For example, in some embodiments, the interlayer and/or the capping layer may include, as the heterocyclic compound, only Compound 1. In this regard, Compound 1 may be present in the electron transport region of the light-emitting device. In one or more embodiments, the interlayer may include, as the heterocyclic compound, Compound 1 and Compound 2. In this regard, Compound 1 and Compound 2 may be present in an identical layer (e.g., both (e.g., simultaneously) Compound 1 and Compound 2 may be present in the electron transport region) or in different layers (e.g., Compound 1 may be present in the electron transport region, and Compound 2 may be present in the hole transport region).

The term "interlayer" as utilized herein refers to a single layer and/or all of multiple layers arranged between the first electrode and the second electrode of the light-emitting device.

According to one or more embodiments, an electronic apparatus may include the light-emitting device. In some embodiments, the electronic apparatus may further include a thin-film transistor. For example, the electronic apparatus may further include a thin-film transistor including a source electrode and a drain electrode, and the first electrode of the light-emitting device may be electrically connected to the source electrode or the drain electrode of the thin-film transistor. In some embodiments, the electronic apparatus may further include a color filter, a color conversion layer, a touch screen layer, a polarizing layer, or any combination thereof. More details on the electronic apparatus may be the same as described herein.

According to one or more embodiments, an electronic equipment may include the light-emitting device. For example, the electronic equipment may be at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, or a signboard. More details on the electronic equipment may be the same as described herein.

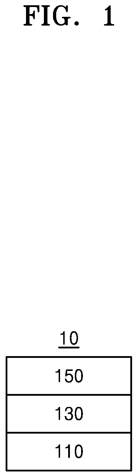

### Description of FIG. 1

FIG. 1 is a schematic cross-sectional view of a light-emitting device 10 according to one or more embodiments of the present disclosure. The light-emitting device 10 may include a first electrode 110, an interlayer 130, and a second electrode 150.

Hereinafter, the structure of the light-emitting device 10 according to one or more embodiments and a method of manufacturing the light-emitting device 10 will be described in more detail with reference to FIG. 1.

### First electrode 110

In FIG. 1, in one or more embodiments, a substrate may be additionally provided and arranged under the first electrode 110 and/or on the second electrode 150. In one or more embodiments, as the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In one or more embodiments, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure including (e.g., consisting of) a single layer or a multi-layer structure including multiple layers. For example, in some embodiments, the first electrode 110 may have a three-layer structure of ITO/Ag/ITO.

### Interlayer 130

The interlayer 130 is arranged on the first electrode 110. The interlayer 130 may include an emission layer.

In one or more embodiments, the interlayer 130 may further include a hole transport region between the first electrode 110 and the emission layer, and an electron transport region between the emission layer and the second electrode 150.

In one or more embodiments, the interlayer 130 may further include, in addition to one or more suitable organic materials, a metal-containing compound such as an organometallic compound, an inorganic material such as a quantum dot, and/or the like.

In one or more embodiments, the interlayer 130 may include i) two or more emitting units sequentially stacked between the first electrode 110 and the second electrode 150, and ii) a charge generation layer between the two or more emitting units. When the interlayer 130 includes the two or more emitting units and the charge generation layer, the light-emitting device 10 may be a tandem light-emitting device.

### Hole transport region in interlayer 130

The hole transport region may have i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The hole transport region may include a hole injection layer, a hole transport layer, an emission auxiliary layer, an electron-blocking layer, or any combination thereof.

For example, in one or more embodiments, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers of each structure are stacked sequentially from the first electrode 110 in the stated order.

In one or more embodiments, the hole transport region may include a compound represented by Formula 201, a compound represented by Formula 202, or any combination thereof: 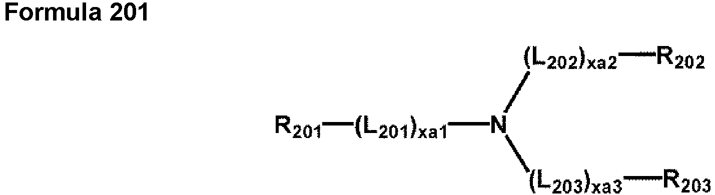 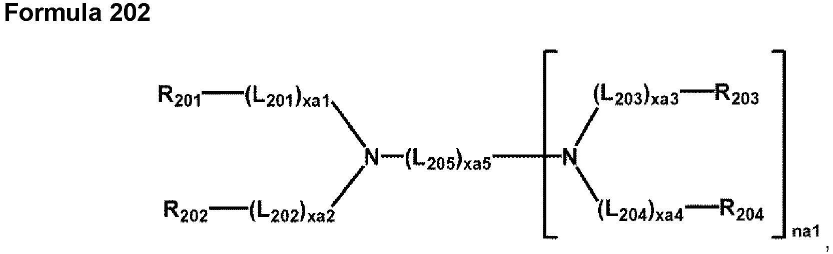 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₆ alkenylene group unsubstituted or substituted with at least one R₁₀ₐ, to form a C₈-C₆₀ polycyclic group (e.g., a carbazole group, etc.) unsubstituted or substituted with at least one R₁₀ₐ (e.g., see Compound HT16, etc.),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, in some embodiments, each of Formulae 201 and 202 may include at least one selected from among groups represented by Formulae CY201 to CY217:

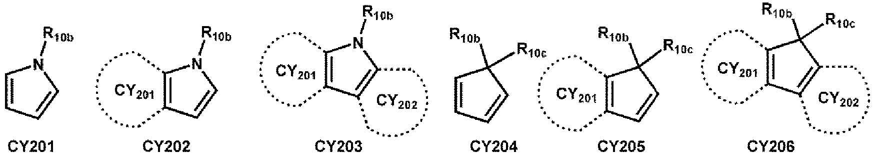

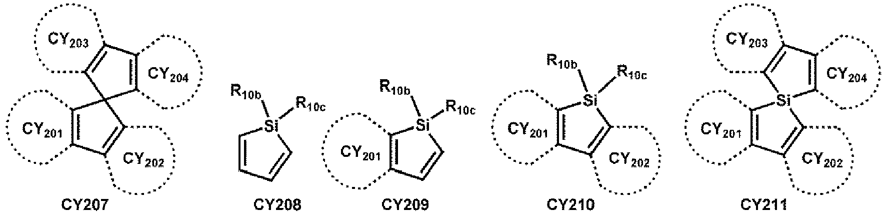

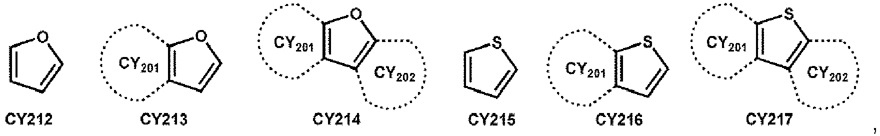

Wherein, in Formulae CY201 to CY217, R_{10b} and R_{10c} may each be the same as described herein with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, in Formulae CY201 to CY217, ring CY₂₀₁ to ring CY₂₀₄ may each independently be a benzene group, a naphthalene group, a phenanthrene group, or an anthracene group.

In one or more embodiments, each of Formulae 201 and 202 may include at least one selected from the groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not include(e.g., may exclude) any one of the groups represented by Formulae CY201 to CY203.

In one or more embodiments, each of Formulae 201 and 202 may not include(e.g., may exclude) any one of the groups represented by Formulae CY201 to CY203, and may include at least one selected from the groups represented by Formulae CY204 to CY217.

In one or more embodiments, each of Formulae 201 and 202 may not include (e.g., may exclude) and one of the groups represented by Formulae CY201 to CY217. In present disclosure, "not include a or any 'component'" "exclude a or any 'component'", "'component'-free", and/or the like refers to that the "component" not being added, selected or utilized as a component in the composition/formula/element, but, in some embodiments, the "component" of less than a suitable amount may still be included due to other impurities and/or external factors.

For example, in one or more embodiments, the hole transport region may include: at least one selected from among Compounds HT1 to HT46; 4,4',4"-[tris(3-methylphenyl)phenylamino] triphenylamine (m-MTDATA); 4,4',4"-tris(N,N-diphenylamino)triphenylamine (TDATA); 4,4',4"-tris[N-(2-naphthyl)-N-phenylamino]-triphenylamine (2-TNATA); N,N'-di(naphthalen-1-yl)-N,N'-diphenyl-benzidine (NPB(NPD)); β-NPB; N,N'-bis(3-methylphenyl)-N,N'-diphenyl-[1,1'-biphenyl]-4,4'-diamine (TPD); spiro-TPD; spiro-NPB; methylated NPB; 4,4'-cyclohexylidene bis[N,N-bis(4-methylphenyl)benzenamine] (TAPC); 4,4'-bis[N,N'-(3-tolyl)amino]-3,3'-dimethylbiphenyl (HMTPD); 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); or any combination thereof:

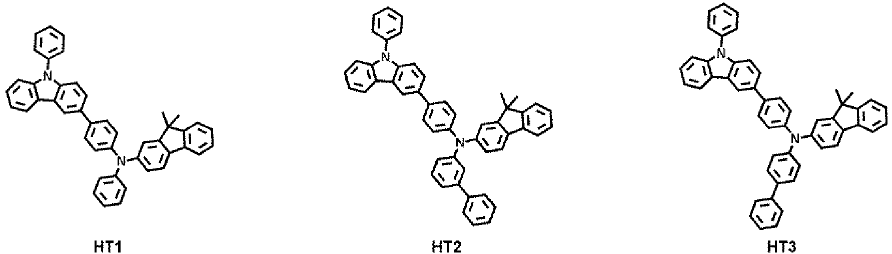

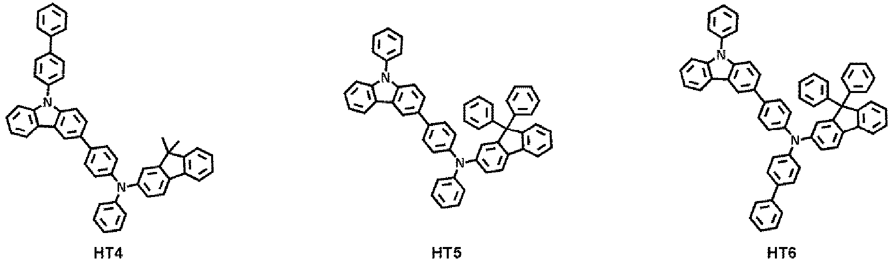

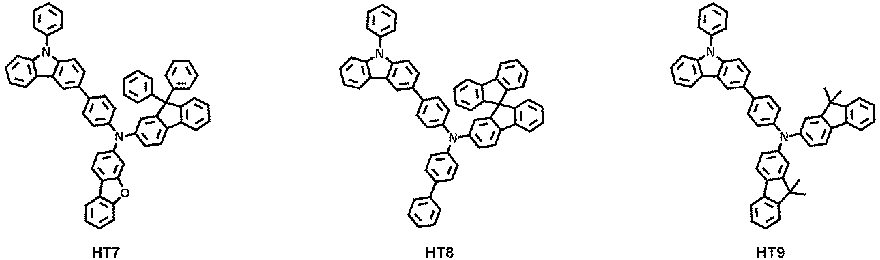

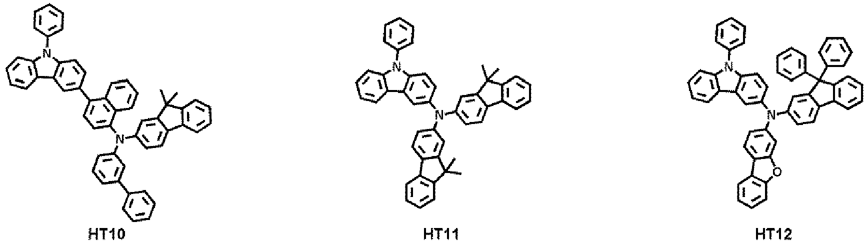

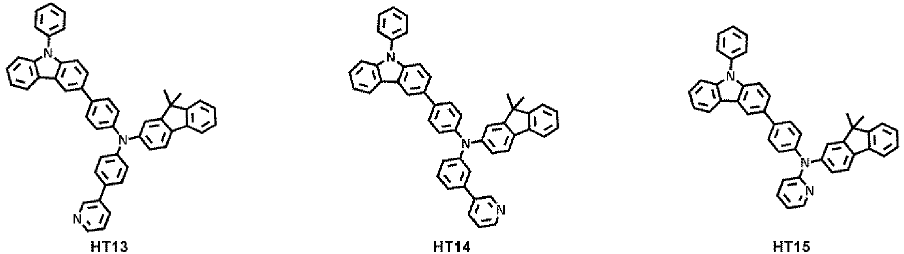

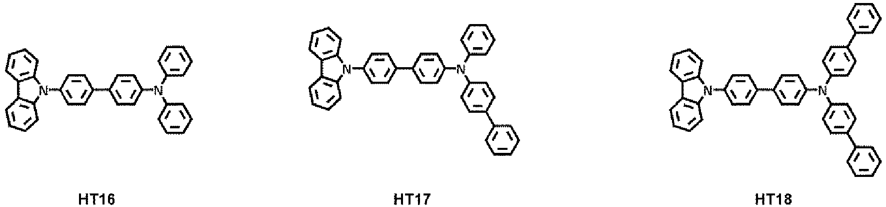

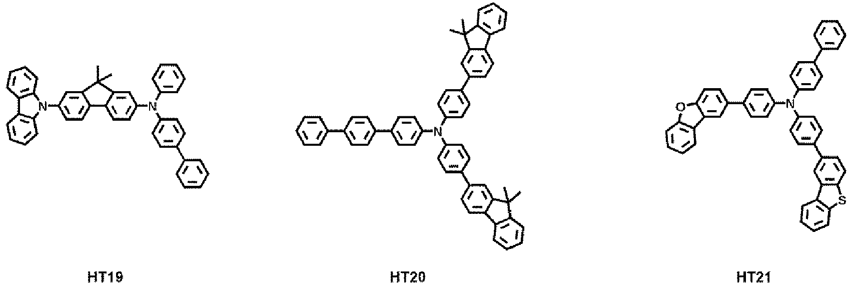

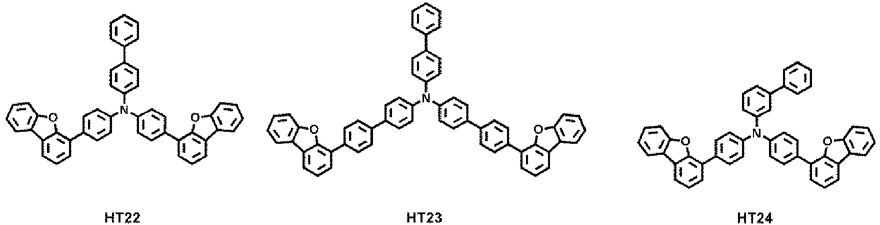

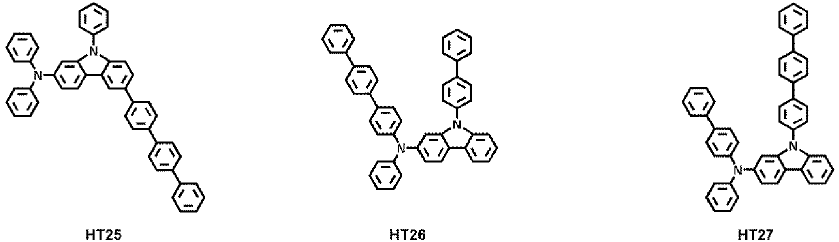

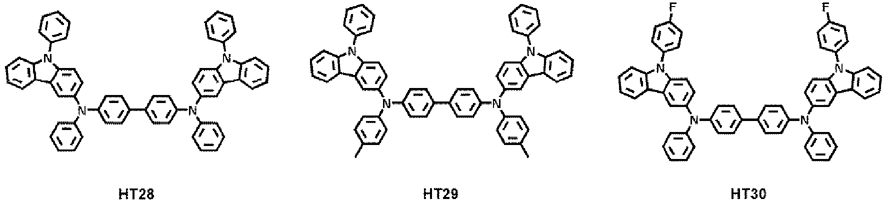

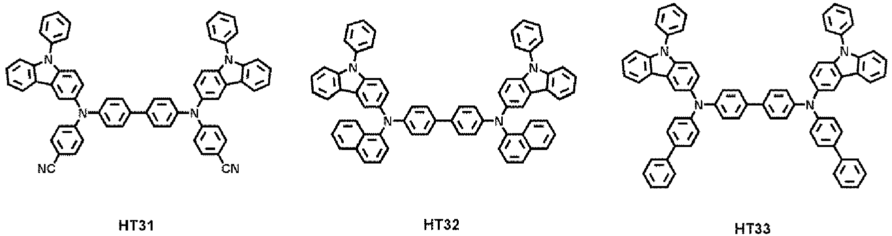

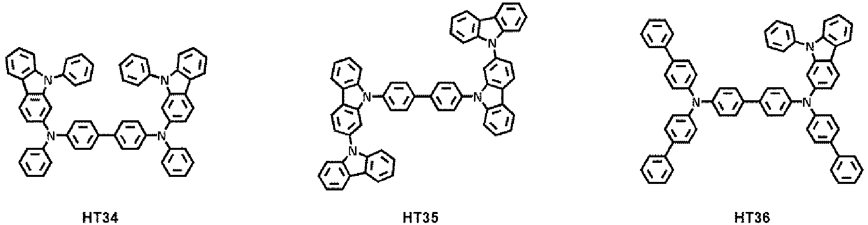

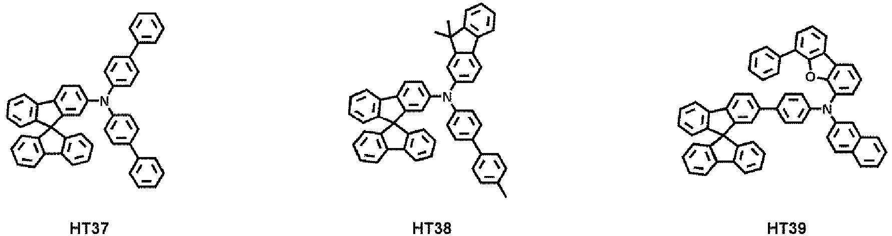

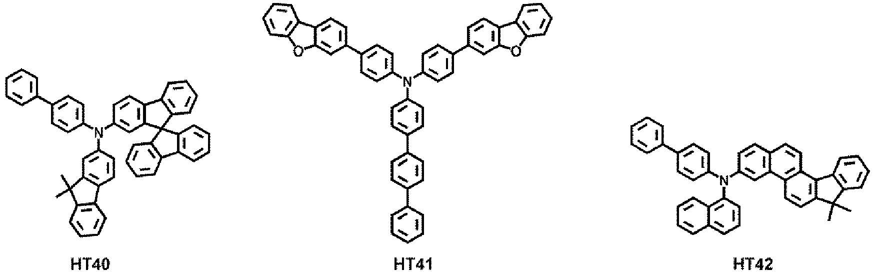

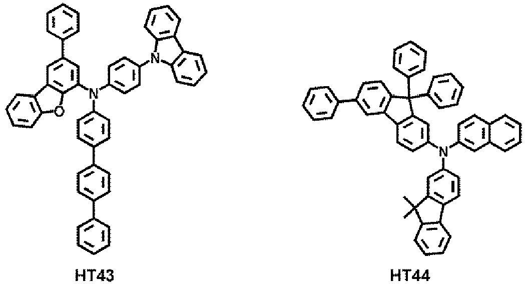

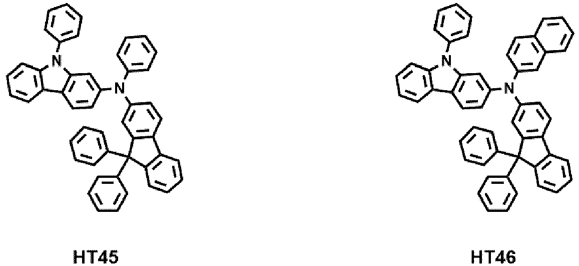

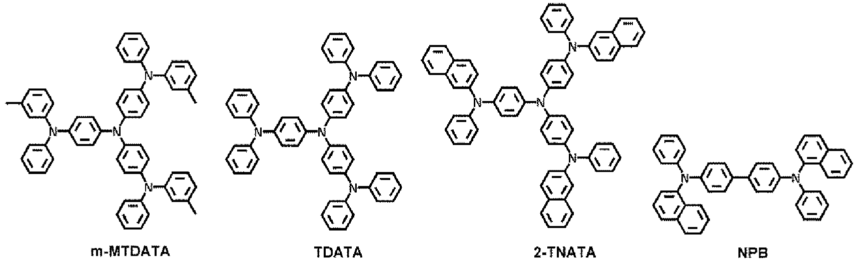

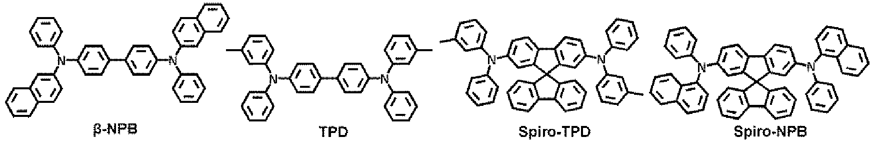

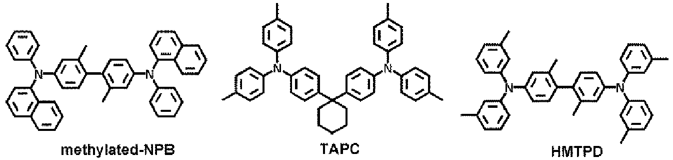

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described above, satisfactory hole-transporting characteristics may be obtained without a substantial increase in driving voltage.

The emission auxiliary layer may increase light-emission efficiency by compensating for an optical resonance distance according to the wavelength of light emitted by the emission layer, and the electron-blocking layer may block or reduce the leakage of electrons from the emission layer to the hole transport region. Materials that may be included in the hole transport region may be included in the emission auxiliary layer and the electron-blocking layer.

### p-dopant

In one or more embodiments, the hole transport region may further include, in addition to the materials described above, a charge-generation material for the improvement of conductive properties. The charge-generation material may be substantially uniformly or non-uniformly dispersed in the hole transport region (e.g., in the form of a single layer including (e.g., consisting of) a charge-generation material).

The charge-generation material may be, for example, a p-dopant.

For example, in one or more embodiments, the p-dopant may have a LUMO energy level of -3.5 eV or less.

In one or more embodiments, the p-dopant may include a quinone derivative, a cyano group-containing compound, a compound including element EL1 and element EL2, or any combination thereof.

Non-limiting examples of the quinone derivative may be tetracyanoquinodimethane (TCNQ), 2,3,5,6-tetrafluoro-7,7,8,8-tetracyanoquinodimethane (F4-TCNQ), and/or the like.

Non-limiting examples of the cyano group-containing compound may be dipyrazino[2,3-f: 2',3'-h] quinoxaline-2,3,6,7,10,11-hexacarbonitrile (HAT-CN), a compound represented by Formula 221, and/or the like: 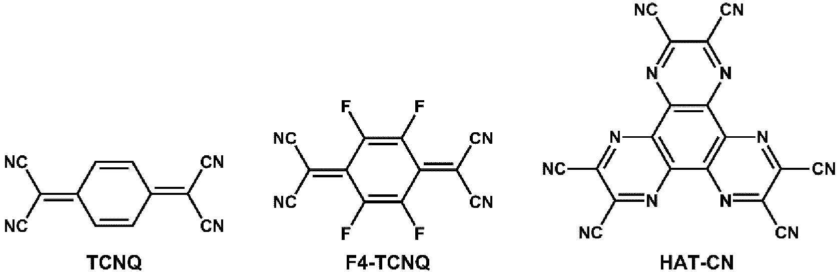 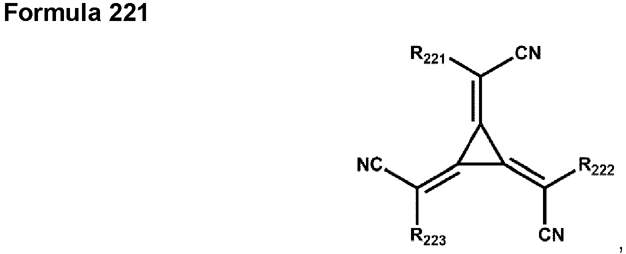 wherein, in Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound including element EL1 and element EL2, element EL1 may be a metal, a metalloid, or any combination thereof, and element EL2 may be a non-metal, a metalloid, or any combination thereof.

Non-limiting examples of the metal may be: an alkali metal (e.g., lithium (Li), sodium (Na), potassium (K), rubidium (Rb), cesium (Cs), etc.); an alkaline earth metal (e.g., beryllium (Be), magnesium (Mg), calcium (Ca), strontium (Sr), barium (Ba), etc.); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (e.g., zinc (Zn), indium (In), tin (Sn), etc.); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Non-limiting examples of the metalloid may be silicon (Si), antimony (Sb), tellurium (Te), and/or the like.

Non-limiting examples of the non-metal may be oxygen (O), a halogen (e.g., F, Cl, Br, I, etc.), and/or the like.

For example, the compound including element EL1 and element EL2 may include a metal oxide, a metal halide (e.g., metal fluoride, metal chloride, metal bromide, metal iodide, etc.), a metalloid halide (e.g., metalloid fluoride, metalloid chloride, metalloid bromide, metalloid iodide, etc.), a metal telluride, or any combination thereof.

Non-limiting examples of the metal oxide may be tungsten oxides (e.g., WO, W₂O₃, WO₂, WO₃, W₂O₅, etc.), vanadium oxides (e.g., VO, V₂O₃, VO₂, V₂O₅, etc.), molybdenum oxides (e.g., MoO, Mo₂O₃, MoO₂, MoOs, Mo₂O₅, etc.), rhenium oxides (e.g., ReOs, etc.), and/or the like.

Non-limiting examples of the metal halide may be alkali metal halides, alkaline earth metal halides, transition metal halides, post-transition metal halides, lanthanide metal halides, and/or the like.

Non-limiting examples of the alkali metal halide may be LiF, NaF, KF, RbF, CsF, LiCl, NaCl, KCl, RbCl, CsCl, LiBr, NaBr, KBr, RbBr, CsBr, Lil, Nal, KI, Rbl, Csl, and/or the like.

Non-limiting examples of the alkaline earth metal halide may be BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Non-limiting examples of the transition metal halide may be titanium halides (e.g., TiF₄, TiCl₄, TiBr₄, TiI₄, etc.), zirconium halides (e.g., ZrF₄, ZrCl₄, ZrBr₄, ZrI₄, etc.), hafnium halides (e.g., HfF₄, HfCl₄, HfBr₄, HfI₄, etc.), vanadium halides (e.g., VF₃, VCl₃, VBr₃, VI₃, etc.), niobium halides (e.g., NbF₃, NbCl₃, NbBr₃, NbI₃, etc.), tantalum halides (e.g., TaF₃, TaCl₃, TaBr₃, TaI₃, etc.), chromium halides (e.g., CrF₃, CrCl₃, CrBr₃, CrI₃, etc.), molybdenum halides (e.g., MoF₃, MoCl₃, MoBrs, MoI₃, etc.), tungsten halides (e.g., WF₃, WCl₃, WBrs, WI₃, etc.), manganese halides (e.g., MnF₂, MnCl₂, MnBr₂, MnI₂, etc.), technetium halides (e.g., TcF₂, TcCl₂, TcBr₂, TcI₂, etc.), rhenium halides (e.g., ReF₂, ReCl₂, ReBr₂, ReI₂, etc.), ferrous halides (e.g., FeF₂, FeCl₂, FeBr₂, FeI₂, etc.), ruthenium halides (e.g., RuF₂, RuCl₂, RuBr₂, RuI₂, etc.), osmium halides (e.g., OsF₂, OsCl₂, OsBr₂, OsI₂, etc.), cobalt halides (e.g., CoF₂, CoCl₂, CoBr₂, CoI₂, etc.), rhodium halides (e.g., RhF₂, RhCl₂, RhBr₂, RhI₂, etc.), iridium halides (e.g., IrF₂, IrCl₂, IrBr₂, IrI₂, etc.), nickel halides (e.g., NiF₂, NiCl₂, NiBr₂, NiI₂, etc.), palladium halides (e.g., PdF₂, PdCl₂, PdBr₂, PdI₂, etc.), platinum halides (e.g., PtF₂, PtCl₂, PtBr₂, PtI₂, etc.), cuprous halides (e.g., CuF, CuCl, CuBr, Cul, etc.), silver halides (e.g., AgF, AgCl, AgBr, Agl, etc.), gold halides (e.g., AuF, AuCl, AuBr, Aul, etc.), and/or the like.

Non-limiting examples of the post-transition metal halide may be zinc halides (e.g., ZnF₂, ZnCl₂, ZnBr₂, ZnI₂, etc.), indium halides (e.g., InI₃, etc.), tin halides (e.g., SnI₂, etc.), and/or the like.

Non-limiting examples of the lanthanide metal halide may be YbF, YbF₂, YbF₃, SmF₃, YbCl, YbCl₂, YbCls, SmCls, YbBr, YbBr₂, YbBr₃, SmBr₃, YbI, YbI₂, YbI₃, SmI₃, and/or the like.

Non-limiting examples of the metalloid halide may be antimony halides (e.g., SbCl₅, etc.) and/or the like.

Non-limiting examples of the metal telluride may be alkali metal tellurides (e.g., Li₂Te, Na₂Te, K₂Te, Rb₂Te, Cs₂Te, etc.), alkaline earth metal tellurides (e.g., BeTe, MgTe, CaTe, SrTe, BaTe, etc.), transition metal tellurides (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal tellurides (e.g., ZnTe, etc.), lanthanide metal tellurides (e.g., LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from among a red emission layer, a green emission layer, and a blue emission layer, in which the two or more layers contact each other or are separated from each other, to emit white light (e.g., combined white light). In one or more embodiments, the emission layer may include two or more materials selected from among a red light-emitting material, a green light-emitting material, and a blue light-emitting material, in which the two or more materials are mixed with each other in a single layer, to emit white light (e.g., combined white light).

In one or more embodiments, the emission layer may include a host and a dopant. The dopant may include a phosphorescent dopant, a fluorescent dopant, or any combination thereof.

An amount of the dopant in the emission layer may be in a range of about 0.01 parts by weight to about 15 parts by weight based on 100 parts by weight of the host.

In one or more embodiments, the emission layer may include a quantum dot.

In one or more embodiments, the emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within the ranges described above, excellent or suitable luminescence characteristics may be obtained without a substantial increase in driving voltage.

### Host

In one or more embodiments, the host may include a compound represented by Formula 301:

**Formula 301** **[Ar₃₀₁]_{xb11}-[(L₃₀₁)_{xb1}-R₃₀₁]_{xb21},**

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂),-B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be the same as described herein with respect to Q₁.

For example, in some embodiments, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or any combination thereof: 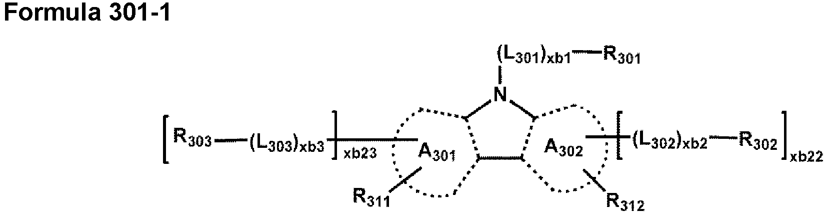 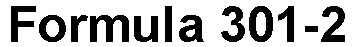 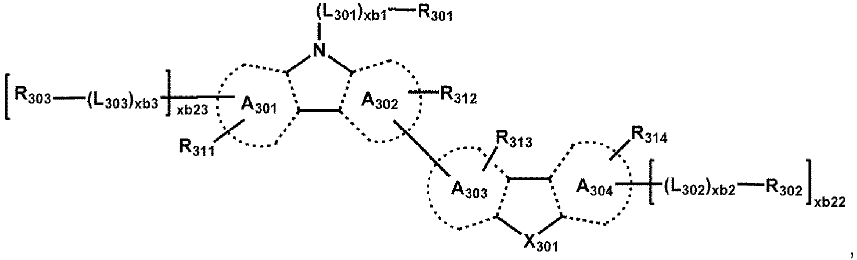 wherein, in Formula 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described herein with respect to L₃₀₁,
xb2 to xb4 may each independently be the same as described herein with respect to xb1, and
R₃₀₂ to R₃₀₅ and R₃₁₁ to R₃₁₄ may each be the same as described herein with respect to R₃₀₁.

In one or more embodiments, the host may include an alkaline earth metal complex, a post-transition metal complex, or any combination thereof. For example, the host may include a Be complex (e.g., Compound H55), a Mg complex, a Zn complex, or any combination thereof.

In one or more embodiments, the host may include: at least one selected from among Compounds H1 to H128; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP); 1,3-di(carbazol-9-yl)benzene (mCP); 1,3,5-tri(carbazol-9-yl)benzene (TCP); or any combination thereof:

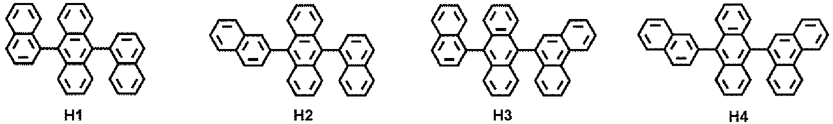

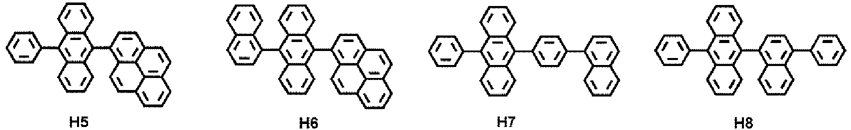

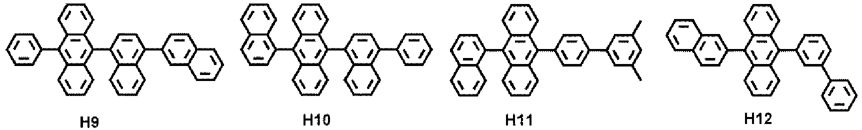

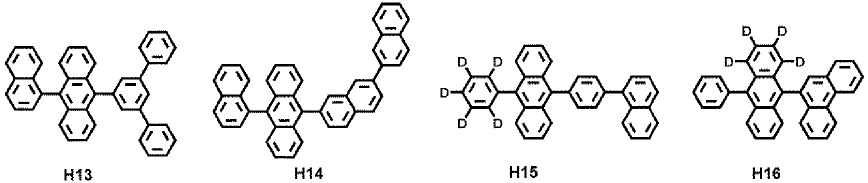

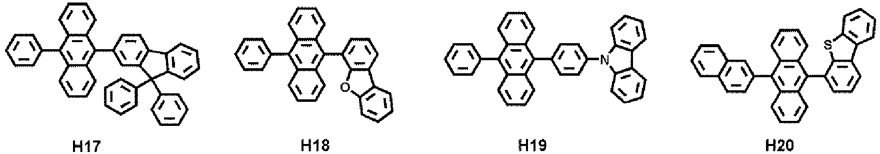

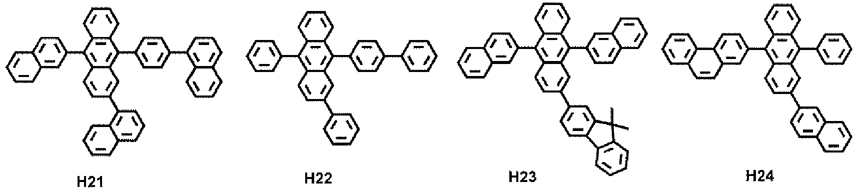

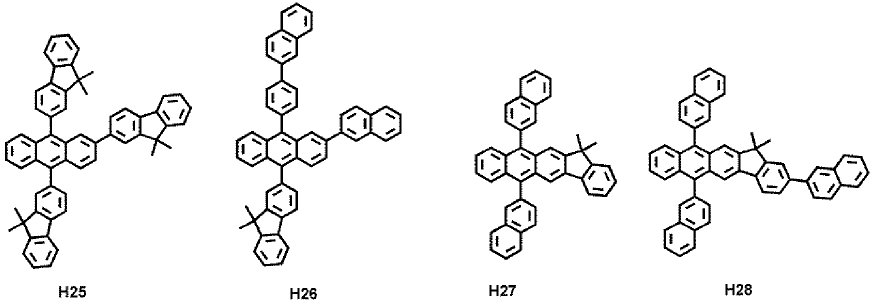

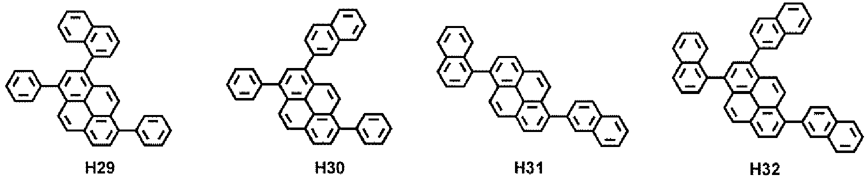

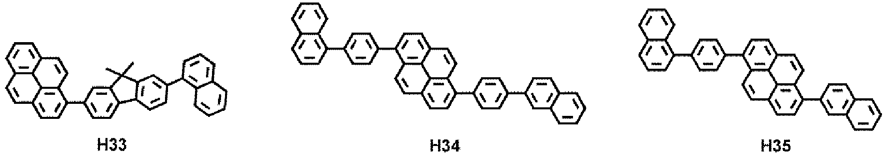

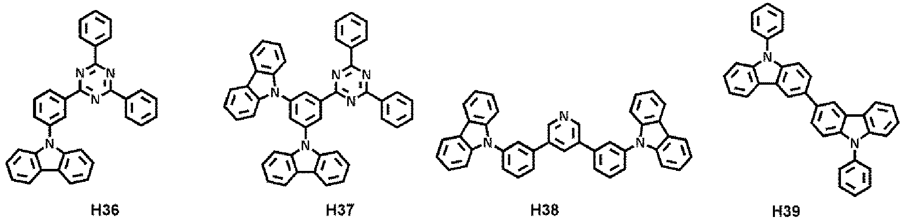

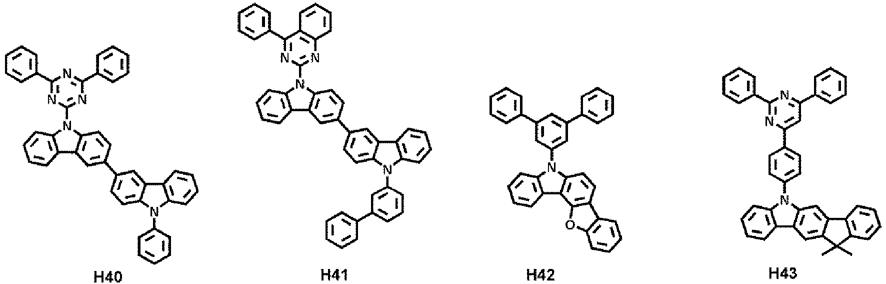

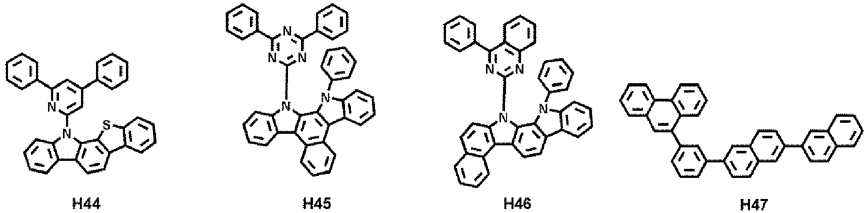

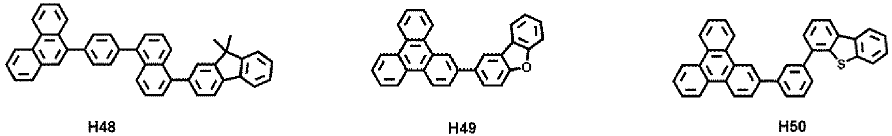

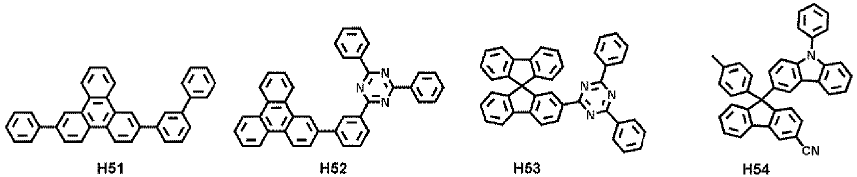

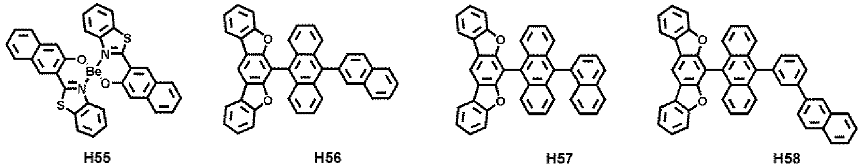

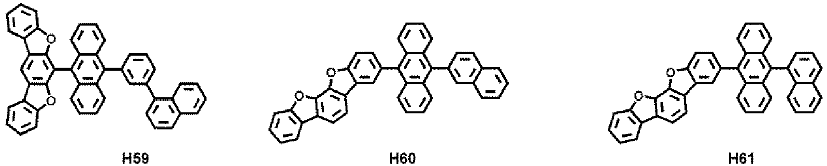

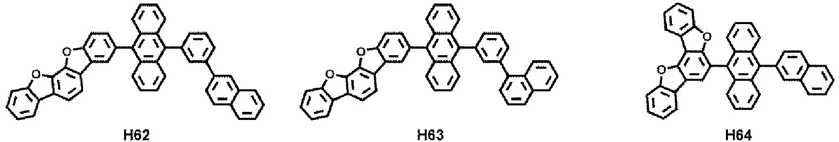

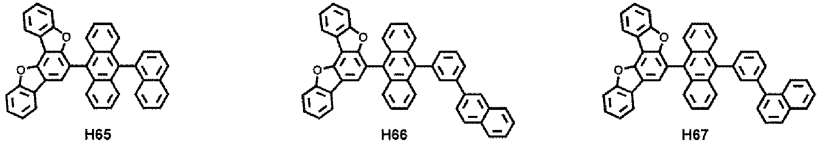

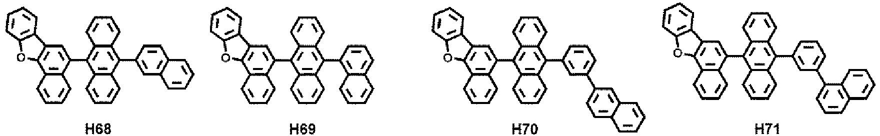

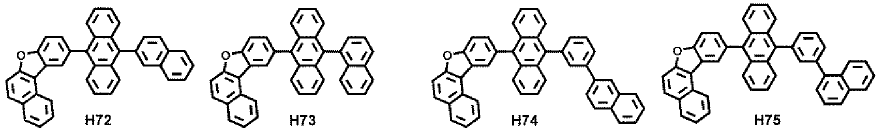

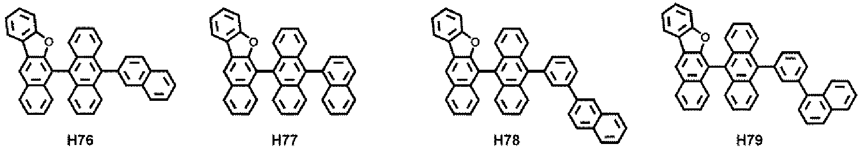

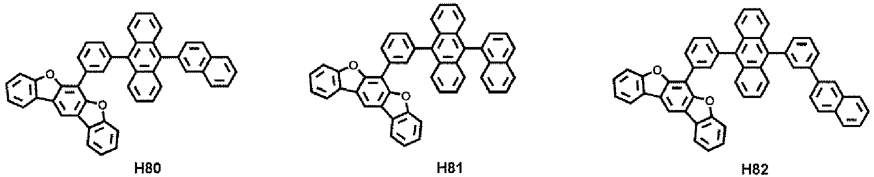

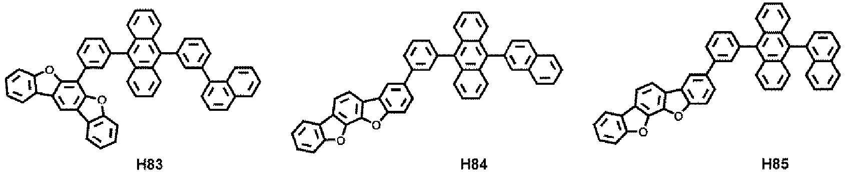

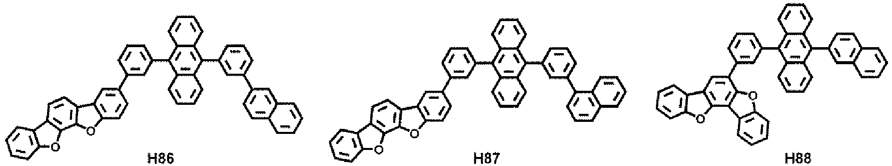

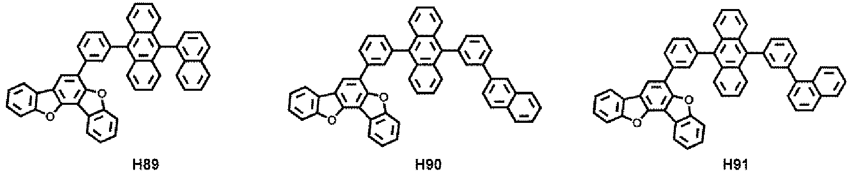

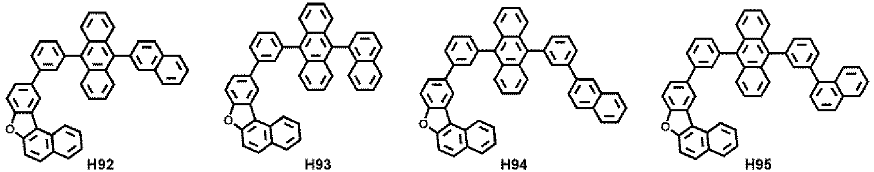

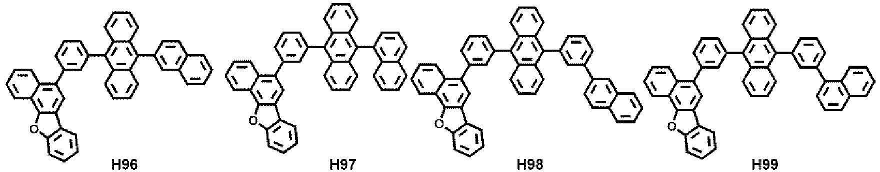

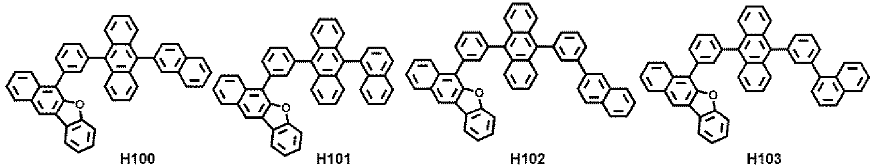

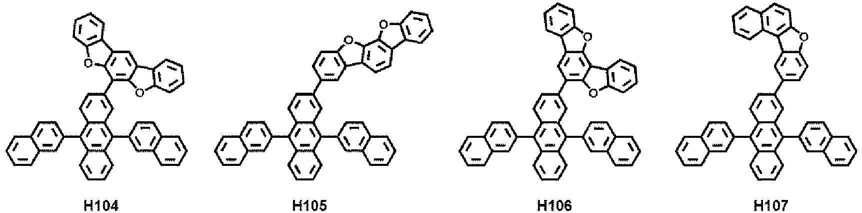

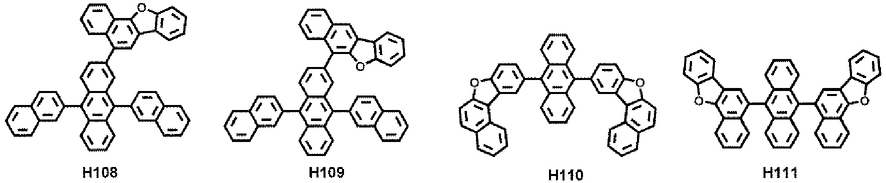

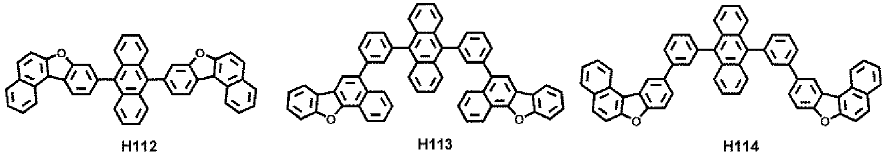

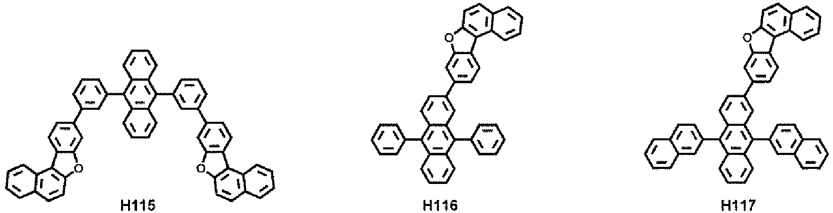

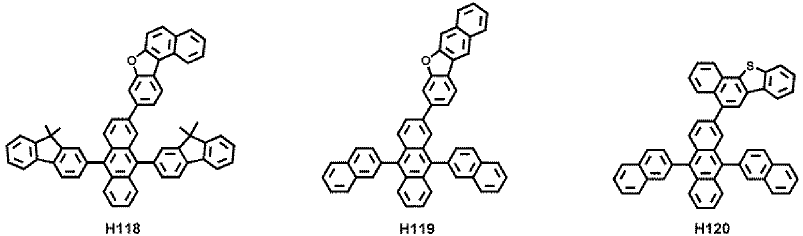

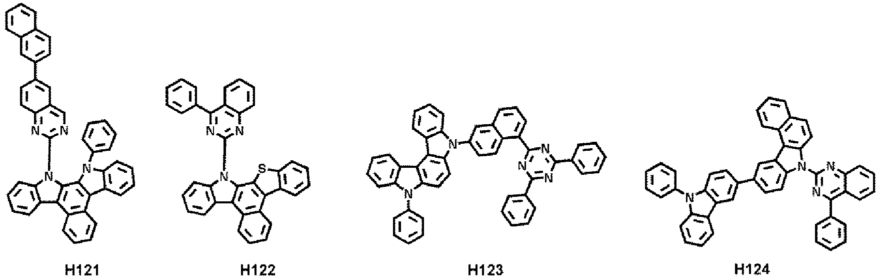

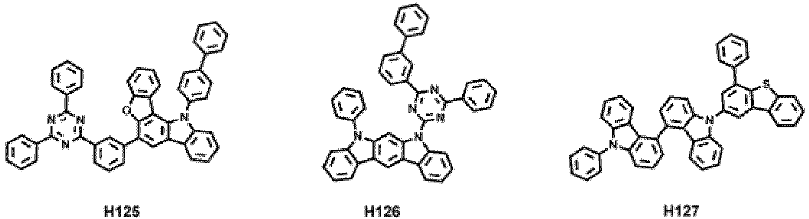

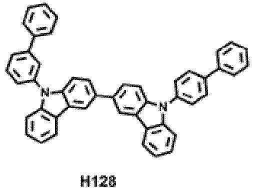

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

For example, in one or more embodiments, the phosphorescent dopant may include an organometallic compound represented by Formula 401:

**Formula 401** **M(L₄₀₁)_{xc1}(L₄₀₂)_{xc2}**

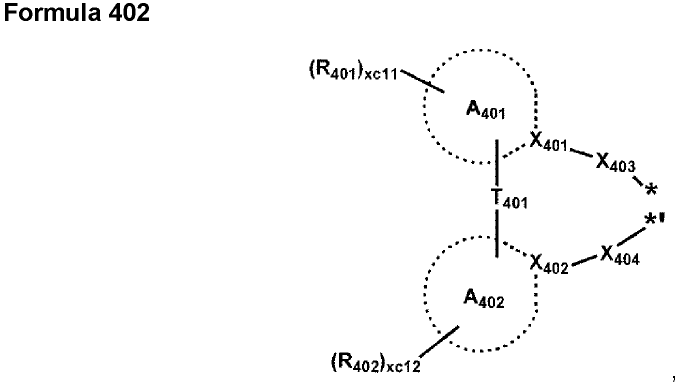

wherein, in Formulae 401 and 402,
M may be a transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁(s) may be identical to or different from each other,
L₄₀₂ may be an organic ligand, and xc2 may be 0, 1, 2, 3, or 4, wherein, when xc2 is 2 or more, two or more of L₄₀₂(s) may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (e.g., a covalent bond or a coordinate bond), O, S, N(Q413), B(Q413), P(Q413), C(Q413)(Q414), or Si(Q413)(Q414),
Q₄₁₁ to Q₄₁₄ may each be the same as described herein with respect to Q₁,
R₄₀₁ and R₄₀₂ may each independently be hydrogen, deuterium, -F, -Cl, -Br,-I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in some embodiments, in Formula 402, i) X₄₀₁ may be nitrogen and X₄₀₂ may be carbon, or ii) each of X₄₀₁ and X₄₀₂ may be nitrogen.

In one or more embodiments, when xc1 in Formula 401 is 2 or more, two of ring A₄₀₁(s) among two or more of L₄₀₁(s) may optionally be linked to each other via T₄₀₂, which is a linking group, and/or two of ring A₄₀₂(s) among two or more of L₄₀₁(s) may optionally be linked to each other via T₄₀₃, which is a linking group (see Compounds PD1 to PD4 and PD7). T₄₀₂ and T₄₀₃ may each be the same as described herein with respect to T₄₀₁.

In Formula 401, L₄₀₂ may be an organic ligand. For example, L₄₀₂ may include a halogen, a diketone group (e.g., an acetylacetonate group), a carboxylic acid group (e.g., a picolinate group), -C(=O), an isonitrile group, -CN group, a phosphorus-containing group (e.g., a phosphine group, a phosphite group, etc.), or any combination thereof.

In one or more embodiments, the phosphorescent dopant may include, for example, one selected from among Compounds PD1 to PD39, or any combination thereof:

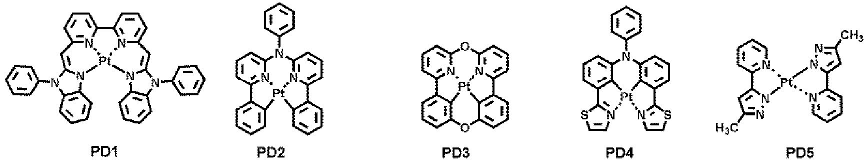

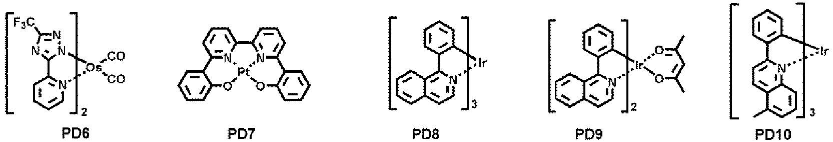

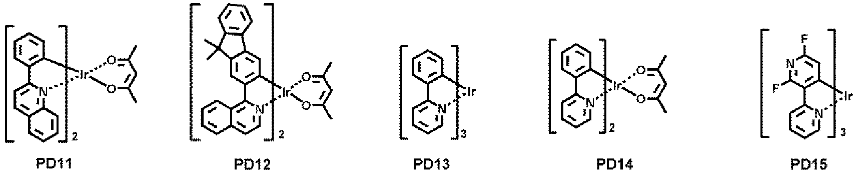

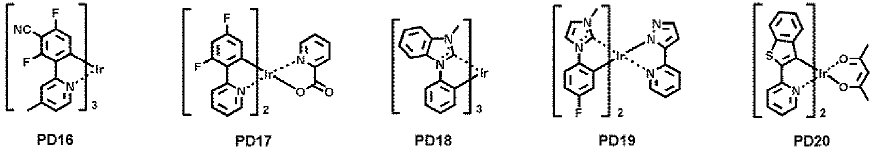

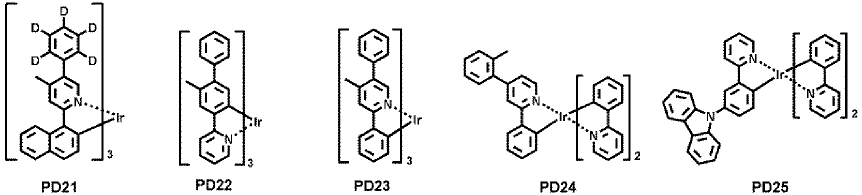

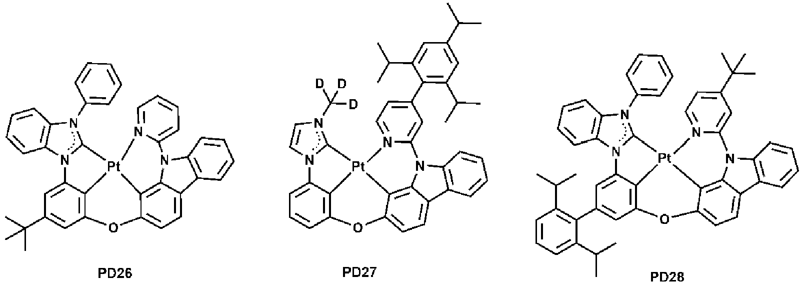

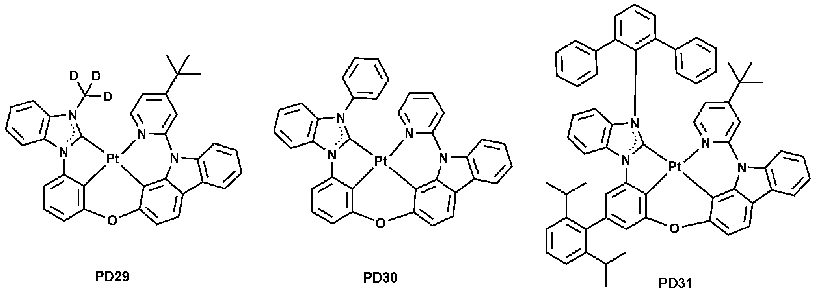

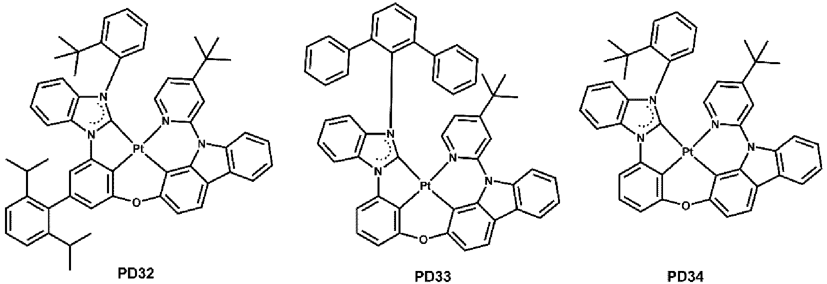

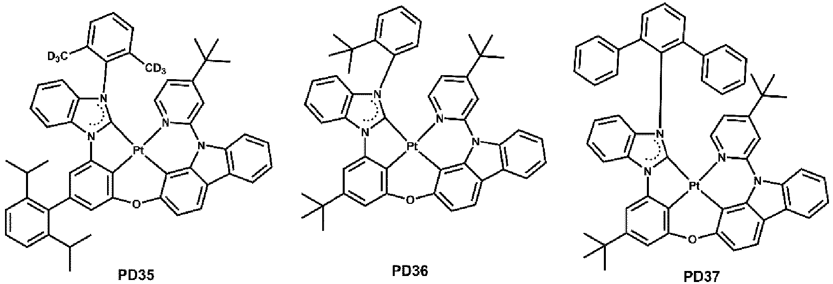

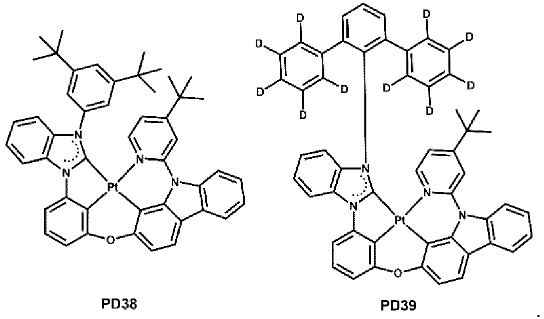

### Fluorescent dopant

The fluorescent dopant may include an amine group-containing compound, a styryl group-containing compound, or any combination thereof.

For example, in some embodiments, the fluorescent dopant may include a compound represented by Formula 501: 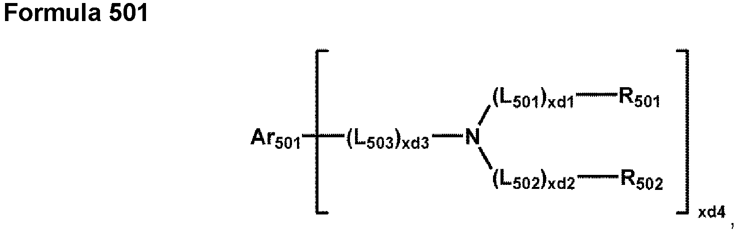 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, in some embodiments, Ar₅₀₁ in Formula 501 may be a condensed cyclic group (e.g., an anthracene group, a chrysene group, a pyrene group, etc.) in which three or more monocyclic groups are condensed with each other.

In one or more embodiments, xd4 in Formula 501 may be 2.

For example, in one or more embodiments, the fluorescent dopant may include: at least one selected from among Compounds FD1 to FD37; 4,4'-bis(2,2-diphenylvinyl)-1,1'-biphenyl (DPVBi); 4,4'-bis[4-(N,N-diphenylamino)styryl]biphenyl (DPAVBi); or any combination thereof:

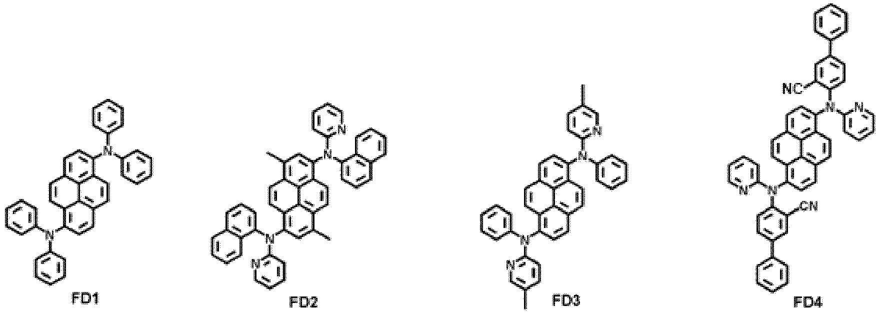

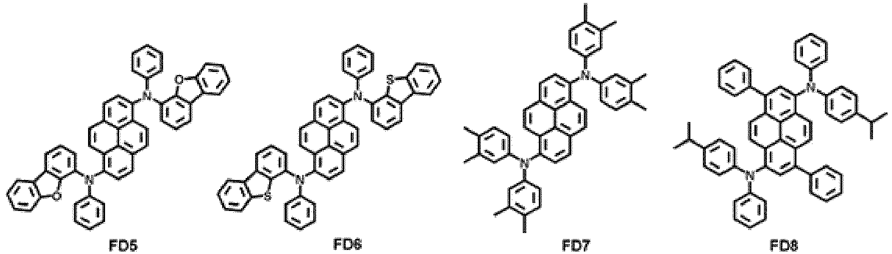

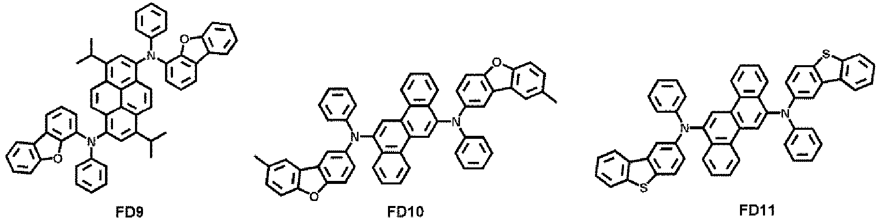

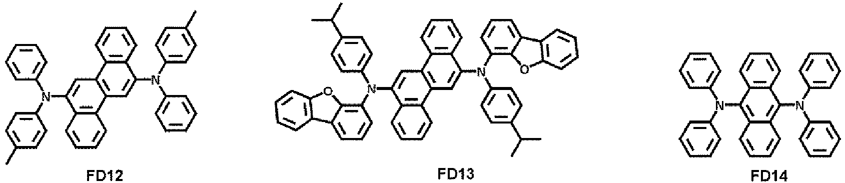

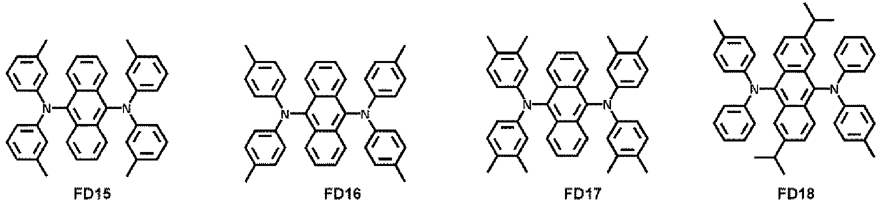

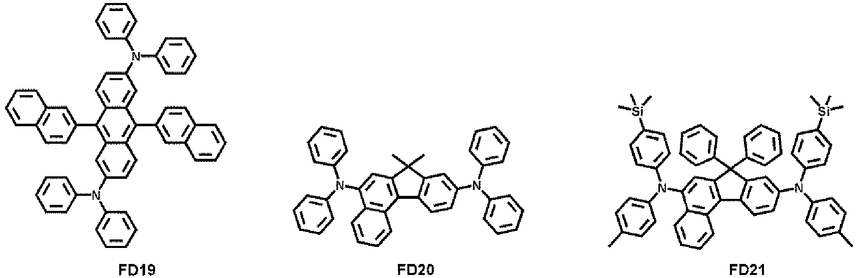

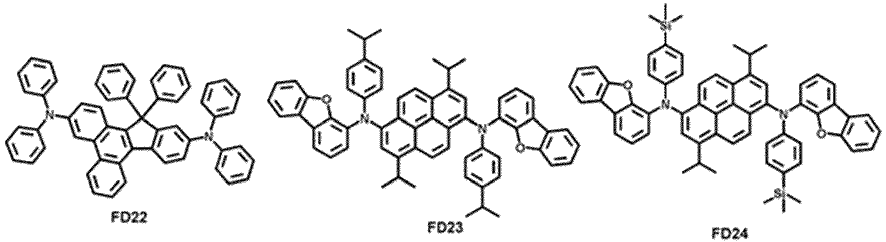

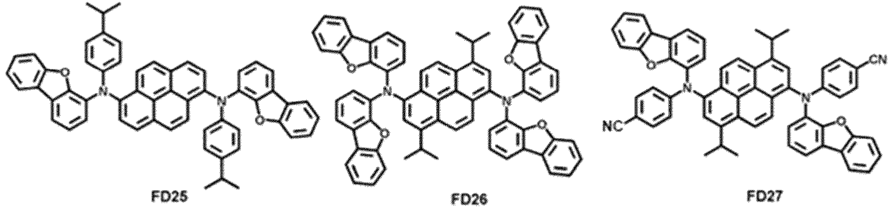

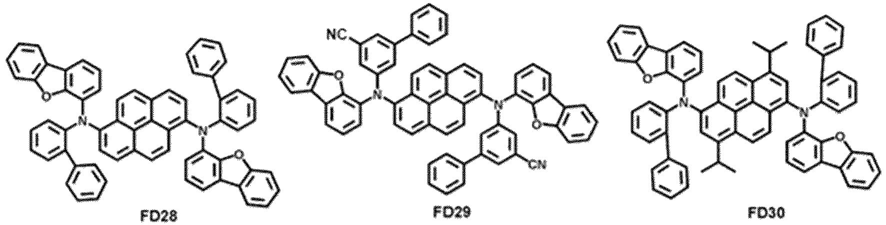

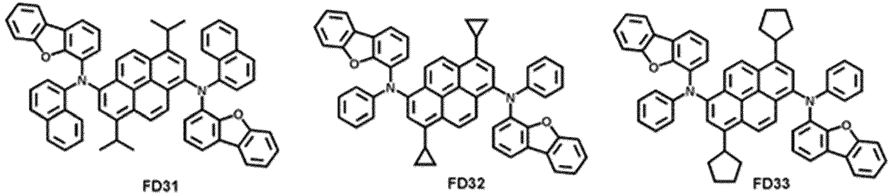

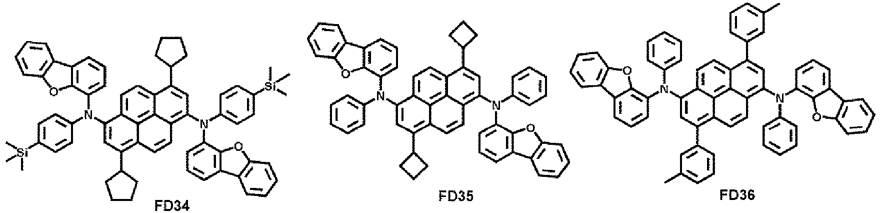

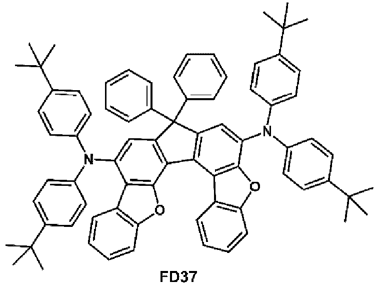

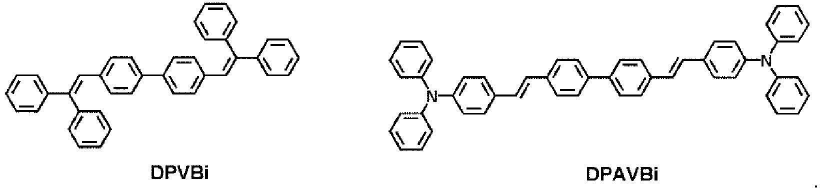

### Delayed fluorescence material

In one or more embodiments, the emission layer may include a delayed fluorescence material.

The delayed fluorescence material described herein may be selected from compounds capable of emitting delayed fluorescence based on a delayed fluorescence emission mechanism.

The delayed fluorescence material included in the emission layer may act as a host or a dopant depending on the type or kind of other materials included in the emission layer.

In one or more embodiments, a difference between a triplet energy level (eV) of the delayed fluorescence material and a singlet energy level (eV) of the delayed fluorescence material may be at least 0 eV but not more than 0.5 eV. When the difference between the triplet energy level (eV) of the delayed fluorescence material and the singlet energy level (eV) of the delayed fluorescence material is within the range described above, up-conversion from the triplet state to the singlet state of the delayed fluorescence material may effectively occur, and thus, the light-emitting device 10 may have improved luminescence efficiency.

For example, in one or more embodiments, the delayed fluorescence material may include i) a material including at least one electron donor (e.g., a π electron-rich C₃-C₆₀ cyclic group, such as a carbazole group, etc.) and at least one electron acceptor (e.g., a sulfoxide group, a cyano group, a π electron-deficient nitrogen-containing C₁-C₆₀ cyclic group, etc.), ii) a material including a C₈-C₆₀ polycyclic group including two or more cyclic groups condensed to each other while sharing boron (B), and/or iii) the like.

Non-limiting examples of the delayed fluorescence material may include at least one selected from among Compounds DF1 to DF14:

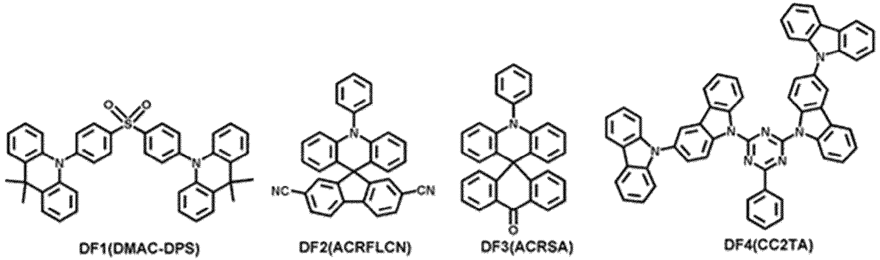

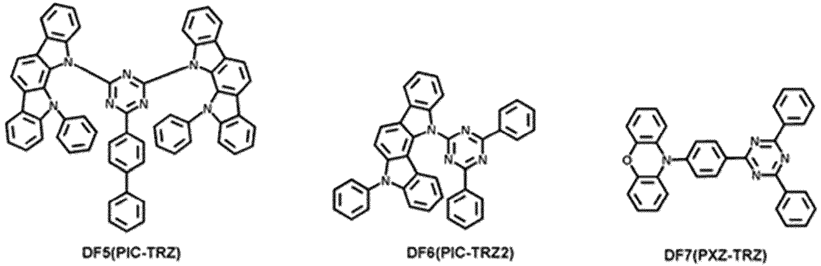

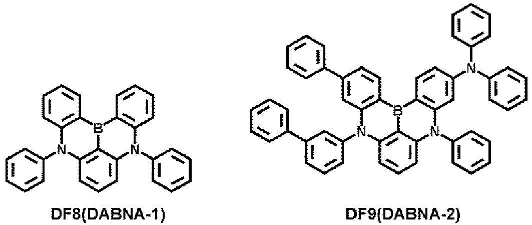

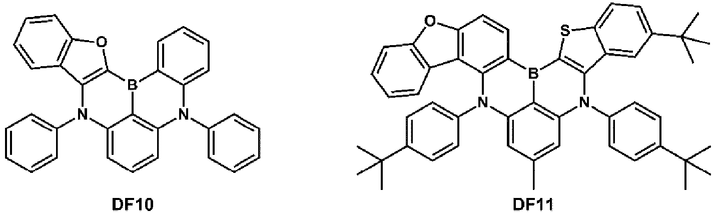

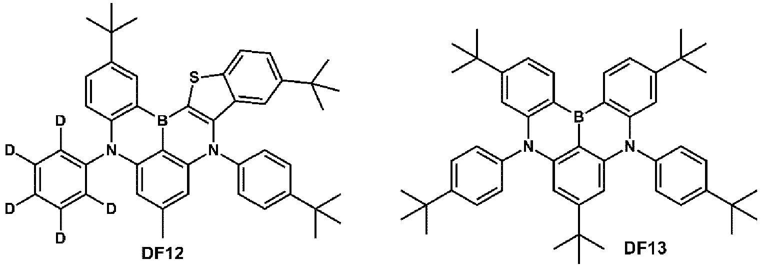

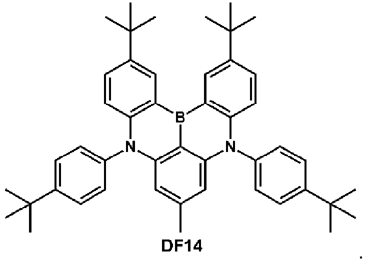

### Quantum dot

In one or more embodiments, the emission layer may include a quantum dot.

The term "quantum dot" as utilized herein refers to a crystal of a semiconductor compound, and may include any material capable of emitting light of one or more suitable emission wavelengths according to the size of the crystal.

The diameter of the quantum dot may be, for example, in a range of about 1 nm to about 10 nm. In the present disclosure, when dot, dots, or dot particles are spherical, "diameter" indicates a particle diameter or an average particle diameter, and when the particles are non-spherical, the "diameter" indicates a major axis length or an average major axis length. The diameter of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter is referred to as D50. D50 refers to the average diameter of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The quantum dot may be synthesized by a wet chemical process, a metal organic chemical vapor deposition process, a molecular beam epitaxy process, or any process similar thereto.

The wet chemical process is a method including mixing a precursor material of a quantum dot with an organic solvent and then growing quantum dot particle crystals. When the crystal grows, the organic solvent naturally acts as a dispersant coordinated on the surface of the quantum dot crystal and controls the growth of the crystal so that the growth of quantum dot particles may be controlled or selected through a process which costs lower, and is easier than vapor deposition methods, such as metal organic chemical vapor deposition (MOCVD) or molecular beam epitaxy (MBE).

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Non-limiting examples of the Group II-VI semiconductor compound may be: a binary compound, such as CdS, CdSe, CdTe, ZnS, ZnSe, ZnTe, ZnO, HgS, HgSe, HgTe, MgSe, MgS, and/or the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or one or more combinations thereof.

Non-limiting examples of the Group III-V semiconductor compound may be: a binary compound, such as GaN, GaP, GaAs, GaSb, AlN, AlP, AlAs, AlSb, InN, InP, InAs, InSb, and/or the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and/or the like; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and/or the like; or one or more combinations thereof. In some embodiments, the Group III-V semiconductor compound may further include a Group II element. Non-limiting examples of the Group III-V semiconductor compound further including the Group II element may be InZnP, InGaZnP, InAlZnP, and/or the like.

Non-limiting examples of the Group III-VI semiconductor compound may be: a binary compound, such as GaS, GaSe, Ga₂Se₃, GaTe, InS, InSe, In₂S₃, In₂Se₃, InTe, and/or the like; a ternary compound, such as InGaS₃, InGaSe₃, and/or the like; or one or more combinations thereof.

Non-limiting examples of the Group I-III-VI semiconductor compound may be: a ternary compound, such as AgInS, AgInS₂, CuInS, CuInS₂, CuGaO₂, AgGaO₂, AgAlO₂, and/or the like; or one or more combinations thereof.

Non-limiting examples of the Group IV-VI semiconductor compound may be: a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or one or more combinations thereof.

Non-limiting examples of the Group IV element or compound may be: a single element compound, such as Si, Ge, and/or the like; a binary compound, such as SiC, SiGe, and/or the like; or one or more combinations thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or may have a core-shell dual structure. For example, a material included in the core and a material included in the shell may be different from each other.

The shell of the quantum dot may act as a protective layer which prevents chemical denaturation of the core to maintain semiconductor characteristics, and/or as a charging layer which imparts electrophoretic characteristics to the quantum dot. The shell may be single-layered or multi-layered. The interface between the core and the shell may have a concentration gradient in which the concentration of an element existing in the shell decreases toward the center of the core.

Examples of the shell of the quantum dot may be an oxide of metal, metalloid, or non-metal, a semiconductor compound, or any combination thereof. Non-limiting examples of the oxide of metal, metalloid, or non-metal may be: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; a ternary compound, such as MgAl₂O₄, CoFe₂O₄, NiFe₂O₄, CoMn₂O₄, and/or the like; or one or more combinations thereof. Examples of the semiconductor compound may be: as described herein, a Group II-VI semiconductor compound; a Group III-V semiconductor compound; a Group III-VI semiconductor compound; a Group I-III-VI semiconductor compound; a Group IV-VI semiconductor compound; or one or more combinations thereof. Non-limiting examples of the semiconductor compound suitable as a shell may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or one or more combinations thereof.

The quantum dot may have a full width at half maximum (FWHM) of an emission spectrum of about 45 nm or less, about 40 nm or less, or for example, about 30 nm or less. When the FWHM of the quantum dot is within these ranges, the quantum dot may have improved color purity or improved color reproducibility. In some embodiments, because light emitted through the quantum dot is emitted in all directions, the wide viewing angle may be improved.

In one or more embodiments, the quantum dot may be in the form of a spherical particle, a pyramidal particle, a multi-arm particle, a cubic nanoparticle, a nanotube particle, a nanowire particle, a nanofiber particle, a nanoplate particle, and/or the like.

Because the energy band gap of the quantum dot may be adjusted by controlling the size of the quantum dot, light having one or more suitable wavelength bands may be obtained from a quantum dot emission layer. Accordingly, by utilizing quantum dots of different sizes, a light-emitting device that emits light of one or more suitable wavelengths may be implemented. In one or more embodiments, the size of the quantum dot may be selected to enable the quantum dot to emit red light, green light, and/or blue light. In some embodiments, quantum dots with suitable sizes may be configured to emit white light by combination of light of one or more suitable colors.

### Electron transport region in interlayer 130

The electron transport region may have i) a single-layer structure including (e.g., consisting of) a single layer including (e.g., consisting of) a single material, ii) a single-layer structure including (e.g., consisting of) a single layer including (e.g., consisting of) multiple materials that are different from each other, or iii) a multi-layer structure including multiple layers including multiple materials that are different from each other.

The electron transport region may include a buffer layer, a hole-blocking layer, an electron control layer, an electron transport layer, an electron injection layer, or any combination thereof.

For example, in one or more embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in the stated order.

In one or more embodiments, the electron transport region (e.g., the buffer layer, the hole-blocking layer, the electron control layer, or the electron transport layer in the electron transport region) may include a metal-free compound including at least one π electron-deficient nitrogen-containing C₁-C₆₀ cyclic group.

For example, in some embodiments, the electron transport region may include a compound represented by Formula 601:

**Formula 601** **[Ar₆₀₁]ₓₑ₁₁-[(L₆₀₁)ₓₑ₁-R₆₀₁]ₓₑ₂₁,**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In one or more embodiments, Ar₆₀₁ in Formula 601 may be an anthracene group unsubstituted or substituted with at least one R₁₀ₐ.

In one or more embodiments, the electron transport region may include a compound represented by Formula 601-1: 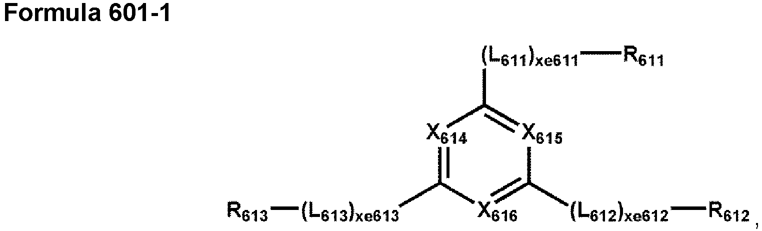 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be the same as described herein with respect to L₆₀₁,
xe611 to xe613 may each be the same as described herein with respect to xe1,
R₆₁₁ to R₆₁₃ may each be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, in some embodiments, xe1 and xe611 to xe613 in Formulae 601 and 601-1 may each independently be 0, 1, or 2.

In one or more embodiments, the electron transport region may include: at least one selected from among Compounds ET1 to ET45; 2,9-dimethyl-4,7-diphenyl-1,10-phenanthroline (BCP); 4,7-diphenyl-1,10-phenanthroline (Bphen); tris(8-hydroxyquinolinato)aluminum (Alq₃); bis(2-methyl-8-quinolinolato-N1,O8)-(1,1'-biphenyl-4-olato)aluminum (BAlq); 3-(4-biphenyl)-4-phenyl-5-tert-butylphenyl-1,2,4-triazole (TAZ); 4-(naphthalen-1-yl)-3,5-diphenyl-4H-1,2,4-triazole (NTAZ; or any combination thereof:

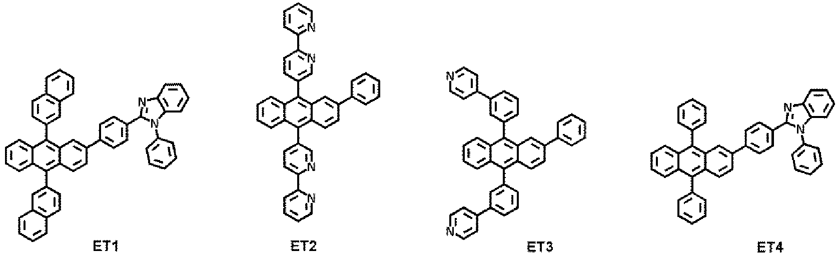

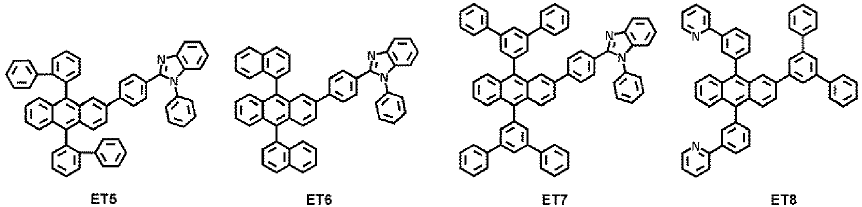

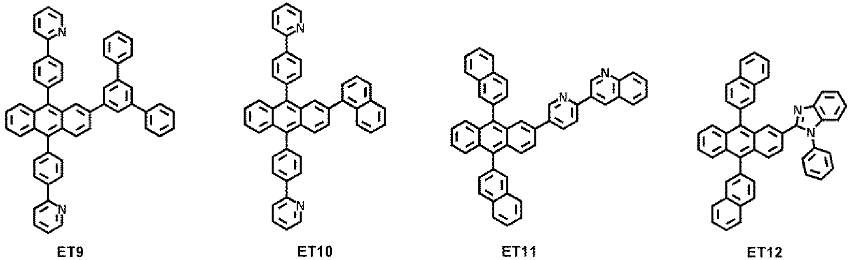

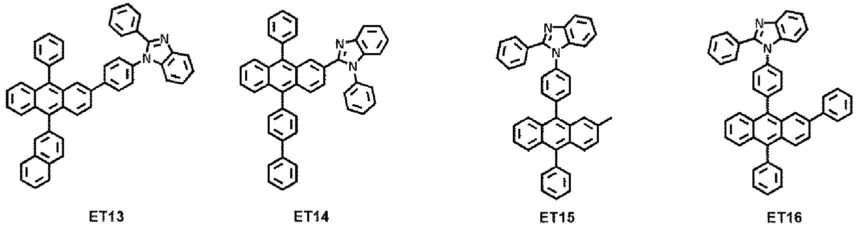

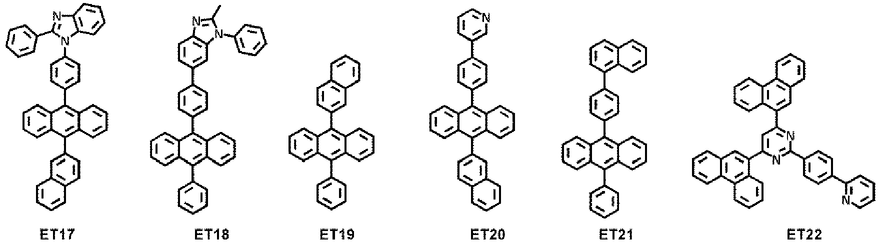

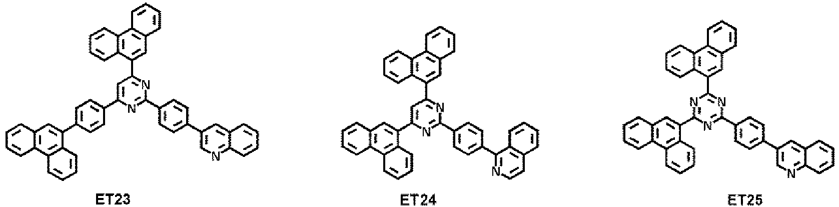

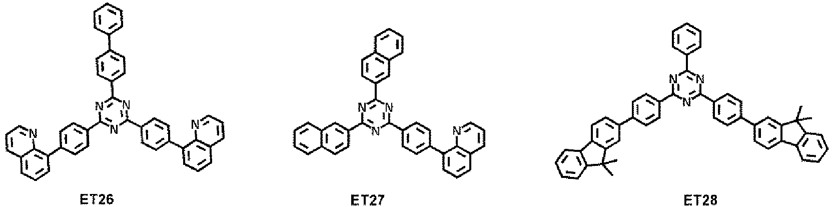

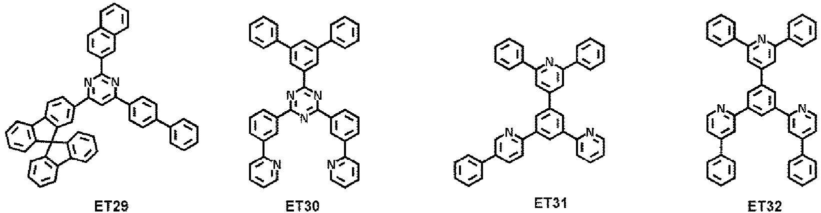

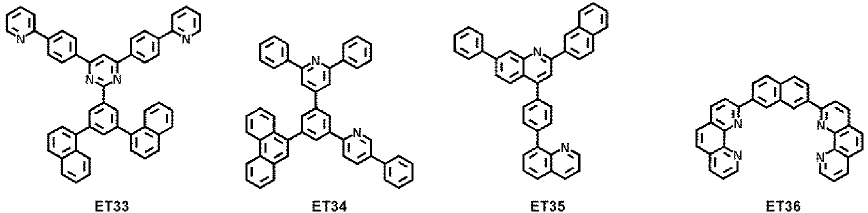

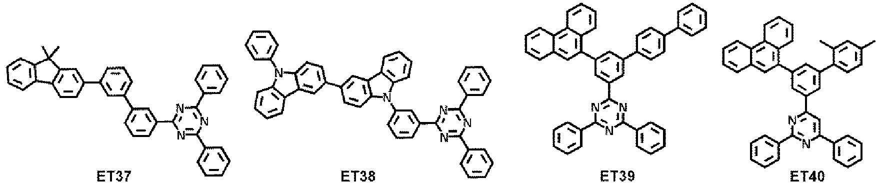

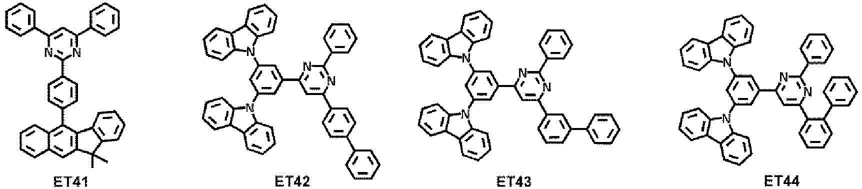

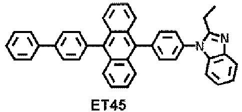

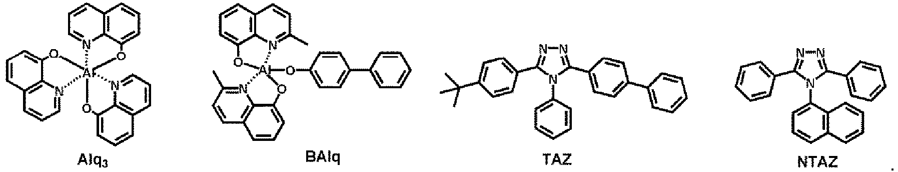

A thickness of the electron transport region may be in a range of about 100 Å to about 5,000 Å, for example, about 160 Å to about 4,000 Å. When the electron transport region includes a buffer layer, a hole-blocking layer, an electron control layer, an electron transport layer, or any combination thereof, a thickness of the buffer layer, the hole-blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport region are within the ranges described above, satisfactory electron-transporting characteristics may be obtained without a substantial increase in driving voltage.

In one or more embodiments, the electron transport region (e.g., the electron transport layer in the electron transport region) may further include, in addition to one or more of the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the metal ion of the alkaline earth-metal complex may include hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, in some embodiments, the metal-containing material may include a Li complex. The Li complex may include, for example, Compound ET-D1 (LiQ) or ET-D2:

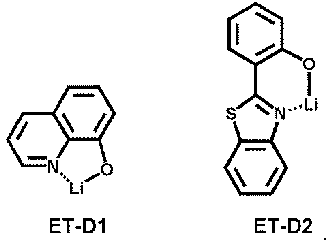

In one or more embodiments, the electron transport region may include an electron injection layer that facilitates the injection of electrons from the second electrode 150. The electron injection layer may directly contact the second electrode 150.

The electron injection layer may have i) a single-layered structure including (e.g., consisting of) a single layer including (e.g., consisting of) a single material, ii) a single-layered structure including (e.g., consisting of) a single layer including (e.g., consisting of) multiple layers that are different from each other, or iii) a multi-layered structure including multiple layers including multiple materials that are different from each other.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (e.g., fluorides, chlorides, bromides, iodides, etc.), or tellurides of the alkali metal, the alkaline earth metal, and the rare earth metal, respectively, or any combination thereof.

The alkali metal-containing compound may include: an alkali metal oxide, such as Li₂O, Cs₂O, K₂O, and/or the like; an alkali metal halide, such as LiF, NaF, CsF, KF, Lil, Nal, Csl, KI, and/or the like; or any combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include a lanthanide metal telluride. Non-limiting examples of the lanthanide metal telluride may be LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one of metal ions of the alkali metal, one or metal ions of the alkaline earth metal, and one of metal ions of the rare earth metal, respectively, and ii) a ligand bonded to the metal ion (e.g., the respective metal ion), for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

In one or more embodiments, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (e.g., a compound represented by Formula 601).

In one or more embodiments, the electron injection layer may include (e.g., consist of) i) an alkali metal-containing compound (e.g., alkali metal halide), or ii) a) an alkali metal-containing compound (e.g., alkali metal halide); and b) an alkali metal, an alkaline earth metal, a rare earth metal, or any combination thereof. For example, in some embodiments, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be substantially uniformly or non-uniformly dispersed in a matrix including the organic material.

A thickness of the electron injection layer may be in a range of about 1 Å to about 100 Å, for example, about 3 Å to about 90 Å. When the thickness of the electron injection layer is within the ranges described above, satisfactory electron injection characteristics may be obtained without a substantial increase in driving voltage.

### Second electrode 150

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or any combination thereof, each having a low-work function, may be utilized.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layer structure or a multi-layer structure including multiple layers.

### Capping layer

A first capping layer may be arranged outside (e.g., on) the first electrode 110, and/or a second capping layer may be arranged outside (e.g., on) the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, light generated in the emission layer of the interlayer 130 of the light-emitting device 10 may be extracted toward the outside through the first electrode 110, which is a semi-transmissive electrode or a transmissive electrode, and the first capping layer. In some embodiments, light generated in the emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of 1.6 or more (e.g., at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may (e.g., the first capping layer and the second capping layer may each independently) include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may each optionally be substituted with a substituent including O, N, S, Se, Si, F, Cl, Br, I, or any combination thereof. In one or more embodiments, at least one of the first capping layer or the second capping layer may (e.g., the first capping layer and the second capping layer may each independently) include an amine group-containing compound.

For example, in one or more embodiments, at least one of the first capping layer or the second capping layer may (e.g., the first capping layer and the second capping layer may each independently) include a compound represented by Formula 201, a compound represented by Formula 202, or any combination thereof.

In one or more embodiments, at least one of the first capping layer or the second capping layer may (e.g., the first capping layer and the second capping layer may each independently) include at least one selected from among Compounds HT28 to HT33, at least one selected from among Compounds CP1 to CP6, β-NPB, or any combination thereof:

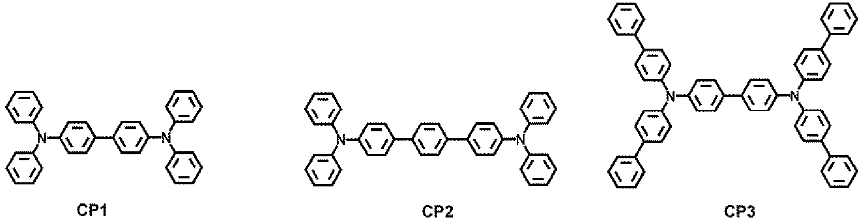

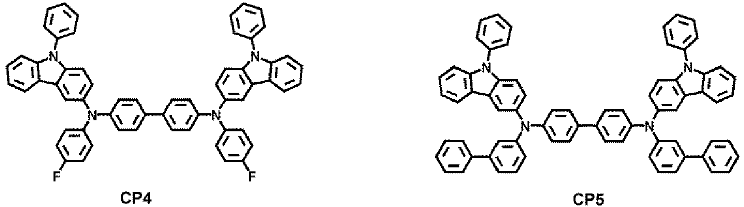

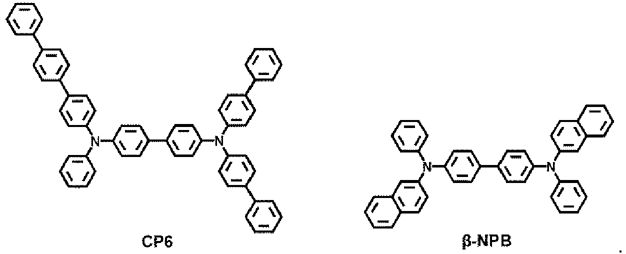

### Film

The heterocyclic compound represented by Formula 1 may be included in one or more suitable films. Accordingly, one or more aspects of embodiments of the present disclosure are directed toward a film including the heterocyclic compound represented by Formula 1. The film may be, for example, an optical member (or a light control element) (e.g., a color filter, a color conversion member, a capping layer, a light extraction efficiency enhancement layer, a selective light-absorbing layer, a polarizing layer, a quantum dot-containing layer, etc.), a light-blocking member (e.g., a light reflective layer, a light-absorbing layer, etc.), a protective member (e.g., an insulating layer, a dielectric layer, etc.), and/or the like.

### Electronic apparatus

The light-emitting device may be included in one or more suitable electronic apparatuses. For example, the electronic apparatus including the light-emitting device may be a light-emitting apparatus, an authentication apparatus, and/or the like.

In one or more embodiments, the electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be arranged in at least one travel direction of light emitted from the light-emitting device. For example, the in some embodiments, light emitted from the light-emitting device may be blue light or white light (e.g., combined white light). Details on the light-emitting device may be the same as described herein. In one or more embodiments, the color conversion layer may include a quantum dot. The quantum dot may be, for example, the quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area configured to emit first color light, a second area configured to emit second color light, and/or a third area configured to emit third color light, wherein the first color light, the second color light, and/or the third color light may have different maximum emission wavelengths from one another. For example, in one or more embodiments, the first color light may be red light, the second color light may be green light, and the third color light may be blue light. For example, in one or more embodiments, the plurality of color filter areas (or the plurality of color conversion areas) may include quantum dots. In some embodiments, the first area may include a red quantum dot to emit red light, the second area may include a green quantum dot to emit green light, and the third area may not include(e.g., may exclude) any quantum dot. Details on the quantum dot may be the same as described herein. The first area, the second area, and/or the third area may each further include a scatter.

For example, in one or more embodiments, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic apparatus may further include a thin-film transistor, in addition to the light-emitting device as described above. The thin-film transistor may include a source electrode, a drain electrode, and an activation layer, wherein one selected from the source electrode and the drain electrode may be electrically connected to the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

In one or more embodiments, the electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin-film encapsulation layer, the electronic apparatus may be flexible.

Various functional layers may be additionally arranged on the sealing portion, in addition to the color filter and/or the color conversion layer, according to the utilization of the electronic apparatus. Non-limiting examples of the functional layers may be a touch screen layer, a polarizing layer, and/or the like. The touch screen layer may be a pressure-sensitive touch screen layer, a capacitive touch screen layer, or an infrared touch screen layer.

The authentication apparatus may be, for example, a biometric authentication apparatus that authenticates an individual by utilizing biometric information of a living body (e.g., fingertips, pupils, etc.). The authentication apparatus may further include, in addition to the light-emitting device as described above, a biometric information collector.

The electronic apparatus may be applied to one or more of displays, light sources, lighting, personal computers (e.g., a mobile personal computer), mobile phones, digital cameras, electronic organizers, electronic dictionaries, electronic game machines, medical instruments (e.g., electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (e.g., meters for a vehicle, an aircraft, and a vessel), projectors, and/or the like.

### Electronic equipment

The light-emitting device may be included in one or more suitable electronic equipment.

For example, the electronic equipment including the light-emitting device may be at least one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a mobile phone, a tablet, a phablet, a PDA, a wearable device, a laptop computer, a digital camera, a camcorder, a viewfinder, a micro display, a 3D display, a virtual reality or augmented reality display, a vehicle, a video wall with multiple displays tiled together, a theater or stadium screen, a phototherapy device, or a signboard.

The light-emitting device may have excellent or suitable luminescence efficiency and long lifespan, and thus, the electronic equipment including the light-emitting device may have desirable characteristics such as high luminance, high resolution, and low power consumption.

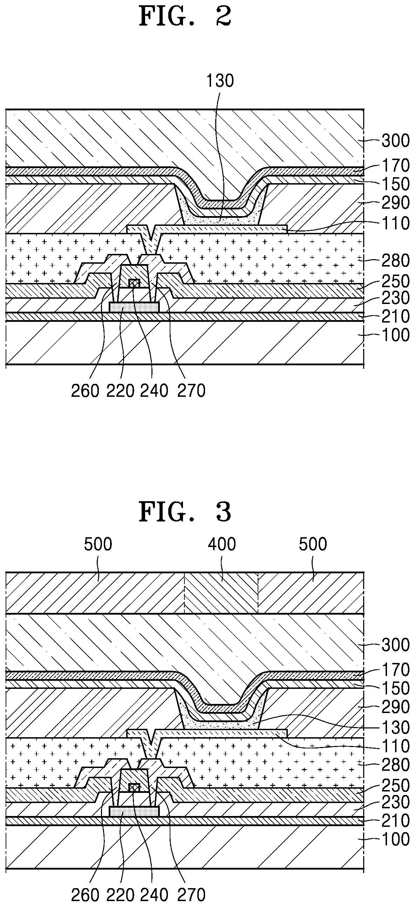

### Description of FIG. 2 and FIG. 3

FIG. 2 is a cross-sectional view of a light-emitting apparatus according to one or more embodiments of the present disclosure.

The light-emitting apparatus of FIG. 2 may include a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220, respectively.

The TFT may be electrically connected to the light-emitting device to drive the light-emitting device, and may be covered and protected by a passivation layer 280. The passivation layer 280 may include an inorganic insulating film, an organic insulating film, or any combination thereof. The light-emitting device may be provided on the passivation layer 280. The light-emitting device may include a first electrode 110, an interlayer 130, and a second electrode 150.

The first electrode 110 may be on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be on the first electrode 110. The pixel defining layer 290 may expose a certain region of the first electrode 110, and the interlayer 130 may be formed in the exposed region of the first electrode 110. The pixel defining layer 290 may be a polyimide-based organic film or a polyacrylic-based organic film. In some embodiments, at least some layers of the interlayer 130 may extend beyond the upper portion of the pixel defining layer 290 to be arranged in the form of a common layer.

The second electrode 150 may be on the interlayer 130, and a capping layer 170 may be additionally formed on the second electrode 150. The capping layer 170 may be formed to cover the second electrode 150.

The encapsulation portion 300 may be on the capping layer 170. The encapsulation portion 300 may be arranged on the light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (e.g., polymethyl methacrylate, polyacrylic acid, etc.), an epoxy-based resin (e.g., aliphatic glycidyl ether (AGE), etc.), or any combination thereof; or any combination of the inorganic films and the organic films.

FIG. 3 is a cross-sectional view of a light-emitting apparatus according to one or more embodiments of the present disclosure.

The light-emitting apparatus of FIG. 3 is substantially the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

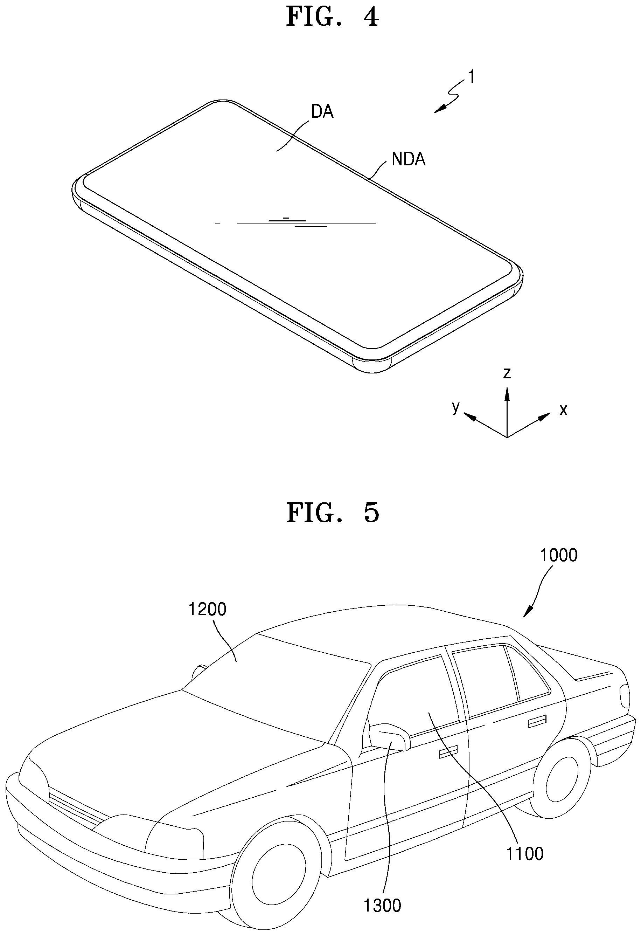

### Description of FIG. 4

FIG. 4 is a schematic perspective view of electronic equipment 1 including a light-emitting device according to one or more embodiments of the present disclosure. The electronic equipment 1 may be, as a device that displays a moving image or still image, a portable electronic equipment, such as a mobile phone, a smart phone, a tablet personal computer (PC), a mobile communication terminal, an electronic notebook, an electronic book, a portable multimedia player (PMP), a navigation, or a ultra-mobile PC (UMPC), as well as one or more suitable products, such as a television, a laptop, a monitor, a billboard, or an Internet of things (IOT). The electronic equipment 1 may be such a product above or a part thereof. In some embodiments, the electronic equipment 1 may be a wearable device, such as a smart watch, a watch phone, a glasses-type or kind display, or a head mounted display (HMD), or a part of the wearable device. However, embodiments of the present disclosure are not limited thereto. For example, the electronic equipment 1 may include a dashboard of a vehicle, a center fascia of a vehicle, a center information display (CID) arranged on a dashboard of a vehicle, a room mirror display replacing a side mirror of a vehicle, an entertainment display for a rear seat of a vehicle or a display arranged on the back of a front seat thereof, a head up display (HUD) installed in the front of a vehicle or projected on a front window glass, and/or a computer generated hologram augmented reality head up display (CGH AR HUD). FIG. 4 illustrates an embodiment in which the electronic equipment 1 is a smart phone for convenience of explanation.

The electronic equipment 1 may include a display area DA and a non-display area NDA outside the display area DA. A display device of the electronic equipment 1 may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board, may be electrically connected may be arranged.

In the electronic equipment 1, a length in the x-axis direction and a length (e.g., a width) in the y-axis direction may be different from each other. In some embodiments, as shown in FIG. 4, the length in the x-axis direction may be shorter than the length (e.g., the width) in the y-axis direction. In one or more embodiments, the length in the x-axis direction may be substantially the same as the length (e.g., the width) in the y-axis direction. In one or more embodiments, the length in the x-axis direction may be longer than the length (e.g., the width) in the y-axis direction.

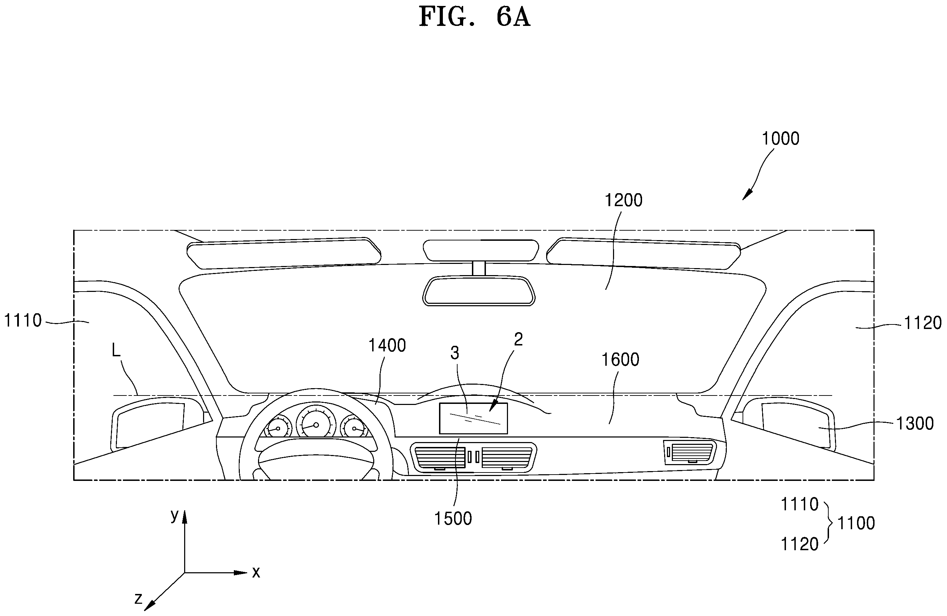

### Descriptions of FIGs. 5 and 6A to 6C

FIG. 5 is a schematic view of an exterior of a vehicle 1000 as electronic equipment including a light-emitting device according to one or more embodiments. FIGs. 6A to 6C are each a schematic view of an interior of the vehicle 1000 according to one or more embodiments.

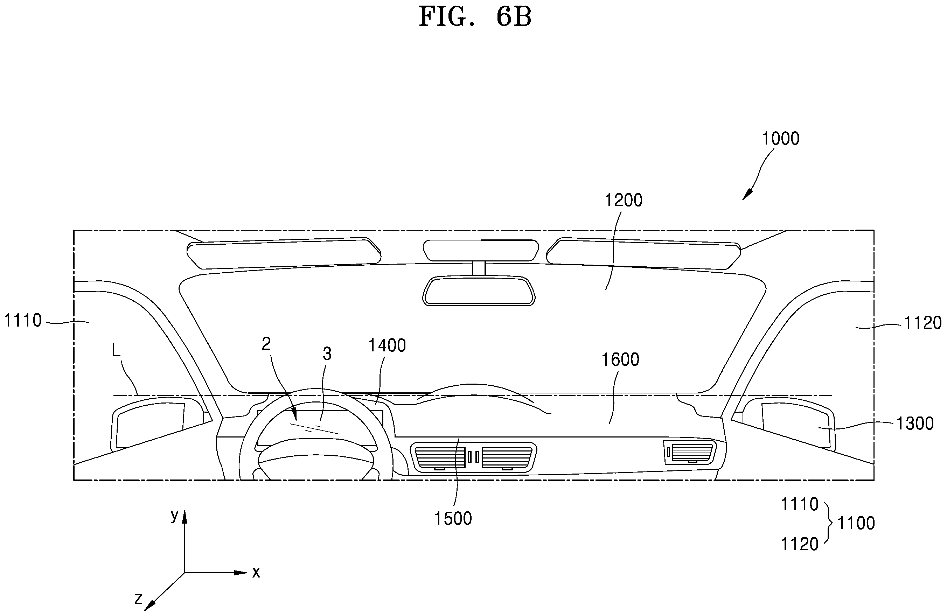

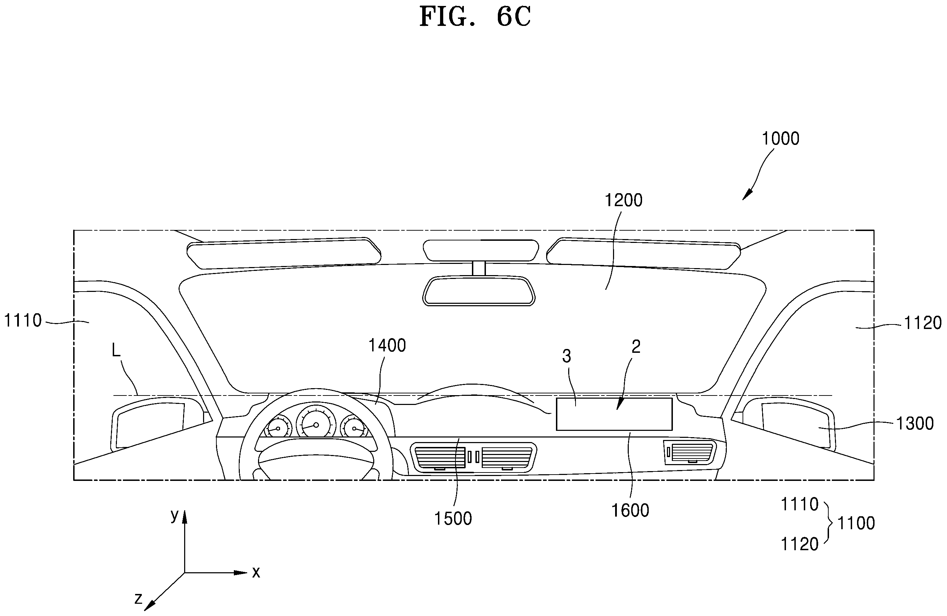

Referring to FIGs. 5, 6A, 6B, and 6C, the vehicle 1000 may refer to one or more suitable apparatuses for moving an object to be transported, such as a human, an object, or an animal, from a departure point to a destination point. The vehicle 1000 may include a vehicle traveling on a road or a track, a vessel moving over the sea or a river, an airplane flying in the sky utilizing the action of air, and/or the like.

In one or more embodiments, the vehicle 1000 may travel on a road or a track. The vehicle 1000 may move in a set or predetermined direction according to rotation of at least one wheel thereof. For example, the vehicle 1000 may include a three-wheeled or four-wheeled vehicle, a construction machine, a two-wheeled vehicle, a prime mover device, a bicycle, or a train running on a track.

The vehicle 1000 may include a body having an interior and an exterior, and a chassis in which mechanical apparatuses necessary for driving are installed as other parts except for the body. The exterior of the body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear, left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on a side of the vehicle 1000. In some embodiments, the side window glass 1100 may be installed on a door of the vehicle 1000. A plurality of side window glasses 1100 may be provided and may face each other. In some embodiments, the side window glass 1100 may include a first side window glass 1110 and a second side window glass 1120. In some embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in the x-direction or the -x-direction (the direction opposite the x-direction). For example, in some embodiments, the first side window glass 1110 and the second side window glass 1120 may be spaced apart from each other in the x-direction or the -x-direction. In other words, an imaginary straight line L connecting the side window glasses 1100 may extend in the x-direction or the -x-direction. For example, the imaginary straight line L connecting the first side window glass 1110 and the second side window glass 1120 to each other may extend in the x-direction or the -x-direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In some embodiments, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning light, a seat belt warning light, an odometer, a hodometer, an automatic shift selector indicator, a door open warning light, an engine oil warning light, and/or a low fuel warning light.

The center fascia 1500 may include a control panel on which a plurality of buttons for adjusting an audio device, an air conditioning device, and/or a heater of a seat are arranged. The center fascia 1500 may be arranged on one side of the cluster 1400.

The passenger seat dashboard 1600 may be spaced apart from the cluster 1400 with the center fascia 1500 arranged therebetween. In some embodiments, the cluster 1400 may be arranged to correspond to a driver seat, and the passenger seat dashboard 1600 may be arranged to correspond to a passenger seat. In some embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In some embodiments, the display device 2 may be arranged between the side window glasses 1100 facing each other. The display device 2 may be arranged on at least one of the cluster 1400, the center fascia 1500, or the passenger seat dashboard 1600.

The display device 2 may include an organic light-emitting display device, an inorganic light-emitting display device, a quantum dot display device, and/or the like. Hereinafter, as the display device 2 according to one or more embodiments of the disclosure, an organic light-emitting display device including the light-emitting device according to the disclosure will be described as an example, but one or more suitable types (kinds) of display devices as described above may be utilized in embodiments of the disclosure.

Referring to FIG. 6A, in one or more embodiments, the display device 2 may be arranged on the center fascia 1500. In some embodiments, the display device 2 may display navigation information. In some embodiments, the display device 2 may display audio, video, or information regarding vehicle settings.

Referring to FIG. 6B, in one or more embodiments, the display device 2 may be arranged on the cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

Referring to FIG. 6C, in one or more embodiments, the display device 2 may be arranged on the passenger seat dashboard 1600. The display device 2 may be embedded in the passenger seat dashboard 1600 or arranged on the passenger seat dashboard 1600. In some embodiments, the display device 2 arranged on the passenger seat dashboard 1600 seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may each be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are each formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed and the structure of a layer to be formed.

### Definition of Terms

The term "C₃-C₆₀ carbocyclic group" as utilized herein refers to a cyclic group including (e.g., consisting of) carbon only as a ring-forming atom and having 3 to 60 carbon atoms, and the term "C₁-C₆₀ heterocyclic group" as utilized herein refers to a cyclic group that has 1 to 60 carbon atoms and further has, in addition to carbon, a heteroatom as a ring-forming atom. The C₃-C₆₀ carbocyclic group and the C₁-C₆₀ heterocyclic group may each be a monocyclic group including (e.g., consisting of) one (e.g., only one) ring or a polycyclic group in which two or more rings are condensed with each other. For example, the number of ring-forming atoms of the C₁-C₆₀ heterocyclic group may be from 3 to 61.

The term "cyclic group" as utilized herein may include both (e.g., simultaneously) the C₃-C₆₀ carbocyclic group and the C₁-C₆₀ heterocyclic group.

The term "π electron-rich C₃-C₆₀ cyclic group" as utilized herein refers to a cyclic group that has 3 to 60 carbon atoms and does not include *-N=*' as a ring-forming moiety, and the term "π electron-deficient nitrogen-containing C₁-C₆₀ cyclic group" as utilized herein refers to a heterocyclic group that has 1 to 60 carbon atoms and includes *-N=*' as a ring-forming moiety.

For example,
the C₃-C₆₀ carbocyclic group may be i) Group T1 or ii) a condensed cyclic group in which two or more of Group T1 are condensed with each other (e.g., a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group," "C₃-C₆₀ carbocyclic group," "C₁-C₆₀ heterocyclic group," "π electron-rich C₃-C₆₀ cyclic group," or "π electron-deficient nitrogen-containing C₁-C₆₀ cyclic group" as utilized herein refer to a group condensed to any cyclic group, a monovalent group, or a polyvalent group (e.g., a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Depending on context, in the present disclosure, a divalent group may refer or be a polyvalent group (e.g., trivalent, tetravalent, etc., and not just divalent) per, e.g., the structure of a formula in connection with which of the terms are utilized.

Non-limiting examples of the monovalent C₃-C₆₀ carbocyclic group and monovalent C₁-C₆₀ heterocyclic group may be a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and non-limiting examples of the divalent C₃-C₆₀ carbocyclic group and the divalent C₁-C₆₀ heterocyclic group may be a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has 1 to 60 carbon atoms, and non-limiting examples thereof may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "C₁-C₆₀ alkylene group" as utilized herein refers to a divalent group having substantially the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of a C₂-C₆₀ alkyl group, and non-limiting examples thereof may be an ethenyl group, a propenyl group, a butenyl group, and/or the like. The term "C₂-C₆₀ alkenylene group" as utilized herein refers to a divalent group having substantially the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of a C₂-C₆₀ alkyl group, and non-limiting examples thereof may be an ethynyl group, a propynyl group, and/or the like. The term "C₂-C₆₀ alkynylene group" as utilized herein refers to a divalent group having substantially the same structure as the C₂-C₆₀ alkynyl group.

The term "C₁-C₆₀ alkoxy group" as utilized herein refers to a monovalent group represented by -OA₁₀₁ (wherein A₁₀₁ is a C₁-C₆₀ alkyl group), and substantially examples thereof are a methoxy group, an ethoxy group, an isopropyloxy group, and/or the like.

The term "C₃-C₁₀ cycloalkyl group" as utilized herein refers to a monovalent saturated hydrocarbon cyclic group having 3 to 10 carbon atoms, and non-limiting examples thereof may be a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as utilized herein refers to a divalent group having substantially the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and non-limiting examples thereof may be a 1,2,3,4-oxatriazolidinyl group, a tetrahydrofuranyl group, a tetrahydrothiophenyl group, and/or the like. The term "C₁-C₁₀ heterocycloalkylene group" as utilized herein refers to a divalent group having substantially the same structure as the C₁-C₁₀ heterocycloalkyl group.

The term "C₃-C₁₀ cycloalkenyl group" as utilized herein refers to a monovalent cyclic group that has 3 to 10 carbon atoms and at least one carbon-carbon double bond in the ring thereof and no aromaticity, and non-limiting examples thereof may be a cyclopentenyl group, a cyclohexenyl group, a cycloheptenyl group, and/or the like. The term "C₃-C₁₀ cycloalkenylene group" as utilized herein refers to a divalent group having substantially the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one double bond in the cyclic structure thereof. Non-limiting examples of the C₁-C₁₀ heterocycloalkenyl group may be a 4,5-dihydro-1,2,3,4-oxatriazolyl group, a 2,3-dihydrofuranyl group, a 2,3-dihydrothiophenyl group, and/or the like. The term "C₁-C₁₀ heterocycloalkenylene group" as utilized herein refers to a divalent group having substantially the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Non-limiting examples of the C₆-C₆₀ aryl group may be a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Non-limiting examples of the C₁-C₆₀ heteroaryl group may be a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, and/or the like. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (e.g., having 8 to 60 carbon atoms) having two or more rings condensed to each other, only carbon atoms as ring-forming atoms, and no aromaticity in its entire molecular structure as a whole. Non-limiting examples of the monovalent non-aromatic condensed polycyclic group may be an indenyl group, a fluorenyl group, a spiro-bifluorenyl group, a benzofluorenyl group, an indenophenanthrenyl group, an indeno anthracenyl group, and/or the like. The term "divalent non-aromatic condensed polycyclic group" as utilized herein refers to a divalent group having substantially the same structure as the monovalent non-aromatic condensed polycyclic group.

The term "monovalent non-aromatic condensed heteropolycyclic group" as utilized herein refers to a monovalent group (e.g., having 1 to 60 carbon atoms) having two or more rings condensed to each other, further including, in addition to carbon atoms, at least one heteroatom, as ring-forming atoms, and having non-aromaticity in its entire molecular structure as a whole. Non-limiting examples of the monovalent non-aromatic condensed heteropolycyclic group may be a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, and/or the like. The term "divalent non-aromatic condensed heteropolycyclic group" as utilized herein refers to a divalent group having substantially the same structure as the monovalent non-aromatic condensed heteropolycyclic group.

The term "C₆-C₆₀ aryloxy group" as utilized herein refers to -OA₁₀₂ (wherein A₁₀₂ is a C₆-C₆₀ aryl group), and the term "C₆-C₆₀ arylthio group" as utilized herein refers to -SA₁₀₃ (wherein A₁₀₃ is a C₆-C₆₀ aryl group).

The term "C₇-C₆₀ arylalkyl group" as utilized herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as utilized herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂),-C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂),-C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂).
Q₁ to Q₃, Q₁₁ to Q₁₃, Q₂₁ to Q₂₃, and Q₃₁ to Q₃₃ as utilized herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as utilized herein refers to any atom other than a carbon atom. Non-limiting examples of the heteroatom may be O, S, N, P, Si, B, Ge, Se, and any combination thereof.

The term "third-row transition metal" as utilized herein includes hafnium (Hf), tantalum (Ta), tungsten (W), rhenium (Re), osmium (Os), iridium (Ir), platinum (Pt), gold (Au), and/or the like.

The term "Ph" as utilized herein refers to a phenyl group, the term "Me" as utilized herein refers to a methyl group, the term "Et" as utilized herein refers to an ethyl group, the term "tert-Bu" or "Bu^{t}" as utilized herein refers to a tert-butyl group, and the term "OMe" as utilized herein refers to a methoxy group.

The term "biphenyl group" as utilized herein refers to "a phenyl group substituted with a phenyl group." In some embodiments, the "biphenyl group" may be a substituted phenyl group having a C₆-C₆₀ aryl group as a substituent.

The term "terphenyl group" as utilized herein refers to "a phenyl group substituted with a biphenyl group." In some embodiments, the "terphenyl group" may be a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

The x-axis, y-axis, and z-axis as utilized herein are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Hereinafter, compounds according to one or more embodiments and light-emitting devices according to one or more embodiments will be described in more detail with reference to Synthesis Examples and Examples. The wording "B was utilized instead of A" utilized in describing Synthesis Examples refers to that an identical molar equivalent of B was utilized in place of A.

### Examples

### Synthesis Example 1: Synthesis of Compound 5

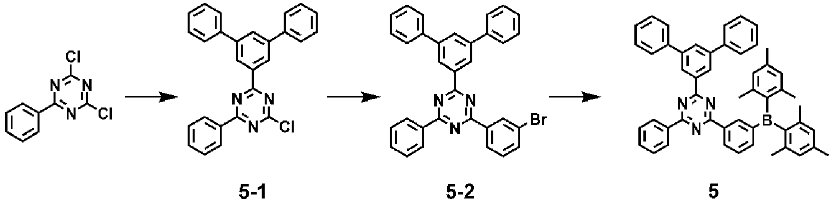

### (1) Synthesis of Intermediate Compound 5-1

2,4-dichloro-6-phenyl-1,3,5-triazine (1.0 eq.), [1,1':3',1"-terphenyl]-5'-ylboronic acid (1.0 eq.), bis(triphenylphosphine)palladium(II)dichloride (0.02 eq.), and potassium carbonate (2.0 eq.) were dissolved in a solution containing toluene, ethanol (EtOH), and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 5-1 was obtained by column chromatography (yield: 80 %).

### (2) Synthesis of Intermediate Compound 5-2

Intermediate Compound 5-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 5-2 was obtained by column chromatography (yield: 75 %).

### (3) Synthesis of Compound 5

Tetrahydrofuran (THF) was added to Intermediate Compound 5-2 (1.0 eq.), and the resultant reaction solution was cooled to -78 °C. N-butyllithium (1.05 eq.) was slowly added dropwise to the reaction solution under a nitrogen atmosphere, followed by stirring at -78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 5 was obtained by column chromatography (yield: 67 %).

By fast atom bombardment mass spectrometry (FAB-MS), mass number m/z = 709.36 was observed as a molecular ion peak. Thus, Compound 5 was identified.

### Synthesis Example 2: Synthesis of Compound 6

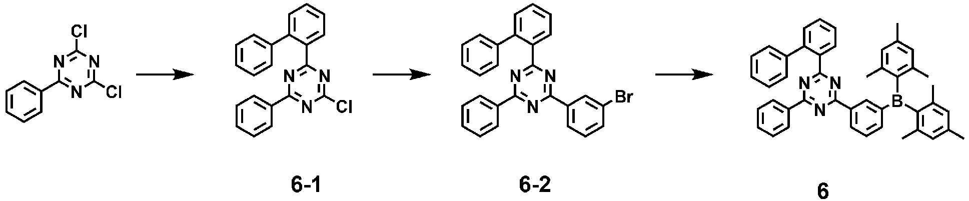

### (1) Synthesis of Intermediate Compound 6-1

2,4-dichloro-6-phenyl-1,3,5-triazine (1.0 eq.), [1,1'-biphenyl]-2-ylboronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 6-1 was obtained by column chromatography (yield: 82 %).

### (2) Synthesis of Intermediate Compound 6-2

Intermediate Compound 6-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 6-2 was obtained by column chromatography (yield: 72 %).

### (3) Synthesis of Compound 6

THF was added to Intermediate Compound 6-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 6 was obtained by column chromatography (yield: 67 %).

By FAB-MS, mass number m/z = 633.33 was observed as a molecular ion peak. Thus, Compound 6 was identified.

### Synthesis Example 3: Synthesis of Compound 8

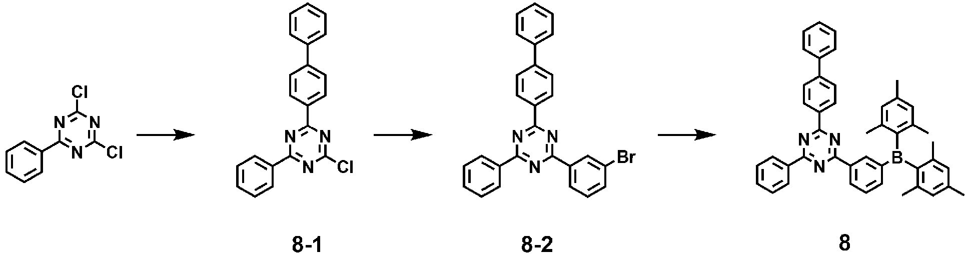

### (1) Synthesis of Intermediate Compound 8-1

2,4-dichloro-6-phenyl-1,3,5-triazine (1.0 eq.), [1,1'-biphenyl]-4-ylboronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 8-1 was obtained by column chromatography (yield: 82 %).

### (2) Synthesis of Intermediate Compound 8-2

Intermediate Compound 8-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 8-2 was obtained by column chromatography (yield: 72 %).

### (3) Synthesis of Compound 8

THF was added to Intermediate Compound 8-2 (1.0 eq.), and the resultant reaction solution was cooled to -78 °C. N-butyllithium (1.05 eq.) was slowly added dropwise to the reaction solution under a nitrogen atmosphere, followed by stirring at-78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 8 was obtained by column chromatography (yield: 67 %).

By FAB-MS, mass number m/z = 633.33 was observed as a molecular ion peak. Thus, Compound 8 was identified.

### Synthesis Example 4: Synthesis of Compound 9

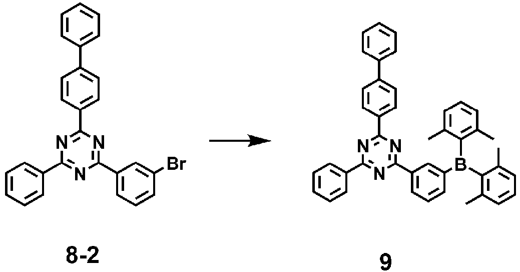

THF was added to Intermediate Compound 8-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Bis(2,6-dimethylphenyl)fluoroborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 9 was obtained by column chromatography (yield: 67 %).

By FAB-MS, mass number m/z = 605.30 was observed as a molecular ion peak. Thus, Compound 9 was identified.

### Synthesis Example 5: Synthesis of Compound 28

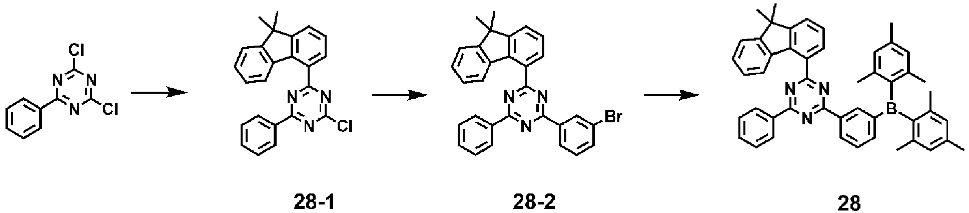

### (1) Synthesis of Intermediate Compound 28-1

2,4-dichloro-6-phenyl-1,3,5-triazine (1.0 eq.), (9,9-dimethyl-9H-fluoren-4-yl)boronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 28-1 was obtained by column chromatography (yield: 82 %).

### (2) Synthesis of Intermediate Compound 28-2

Intermediate Compound 28-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 28-2 was obtained by column chromatography (yield: 72 %).

### (3) Synthesis of Compound 28

THF was added to Intermediate Compound 28-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 28 was obtained by column chromatography (yield: 67 %).

By FAB-MS, mass number m/z = 673.36 was observed as a molecular ion peak. Thus, Compound 28 was identified.

### Synthesis Example 6: Synthesis of Compound 30

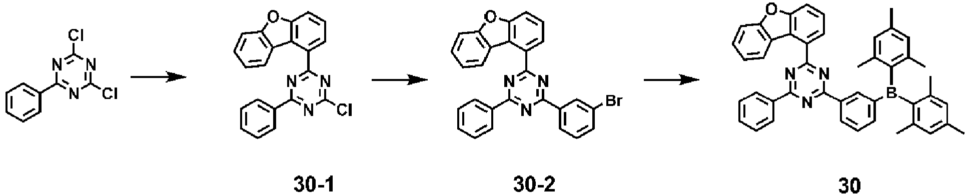

### (1) Synthesis of Intermediate Compound 30-1

2,4-dichloro-6-phenyl-1,3,5-triazine (1.0 eq.), dibenzo[b,d]furan-1-ylboronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 30-1 was obtained by column chromatography (yield: 82 %).

### (2) Synthesis of Intermediate Compound 30-2

Intermediate Compound 30-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 30-2 was obtained by column chromatography (yield: 72 %).

### (3) Synthesis of Compound 30

THF was added to Intermediate Compound 30-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 30 was obtained by column chromatography (yield: 67 %).

By FAB-MS, mass number m/z = 647.31 was observed as a molecular ion peak. Thus, Compound 30 was identified.

### Synthesis Example 7: Synthesis of Compound 55

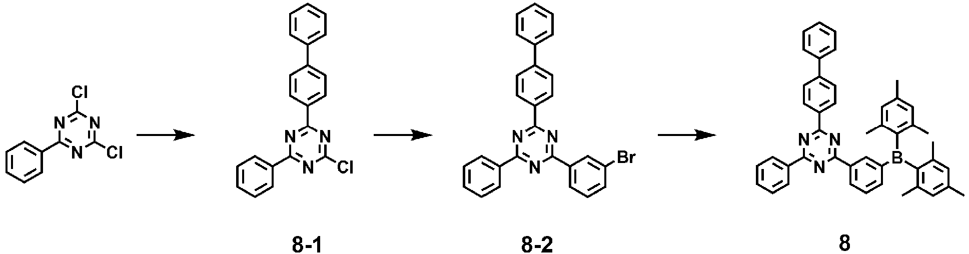

### (1) Synthesis of Intermediate Compound 55-1

2,4-dichloro-6-phenyl-1,3,5-triazine (1.0 eq.), [1,1'-biphenyl]-4-ylboronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 8-1 was obtained by column chromatography (yield: 82 %).

### (2) Synthesis of Intermediate Compound 55-2

Intermediate Compound 55-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 55-2 was obtained by column chromatography (yield: 78 %).

### (3) Synthesis of Compound 55

THF was added to Intermediate Compound 55-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 55 was obtained by column chromatography (yield: 67 %).

By FAB-MS, mass number m/z = 685.34 was observed as a molecular ion peak. Thus, Compound 55 was identified.

### Synthesis Example 8: Synthesis of Compound 58

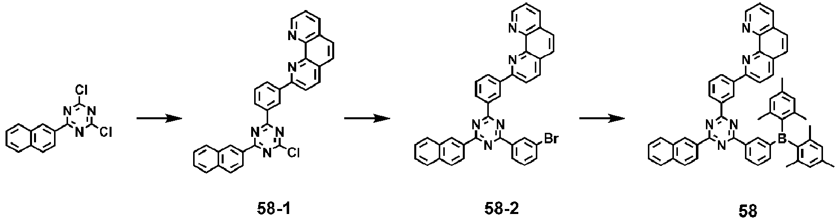

### (1) Synthesis of Intermediate Compound 58-1

2,4-dichloro-6-(naphthalen-2-yl)-1,3,5-triazine (1.0 eq.), (3-(1,10-phenanthrolin-2-yl)phenyl)boronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 58-1 was obtained by column chromatography (yield: 78 %).

### (2) Synthesis of Intermediate Compound 58-2

Intermediate Compound 58-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 58-2 was obtained by column chromatography (yield: 68 %).

### (3) Synthesis of Compound 58

THF was added to Intermediate Compound 58-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 58 was obtained by column chromatography (yield: 67 %).

By FAB-MS, mass number m/z = 785.37 was observed as a molecular ion peak. Thus, Compound 58 was identified.

### Synthesis Example 9: Synthesis of Compound 185

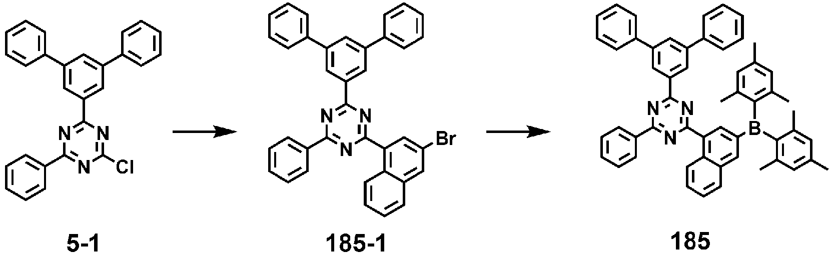

### (1) Synthesis of Intermediate Compound 185-1

Intermediate Compound 5-1 (1.0 eq.), (3-bromonaphthalen-1-yl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 185-1 was obtained by column chromatography (yield: 65 %).

### (2) Synthesis of Compound 185

THF was added to Intermediate Compound 185-1 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 185 was obtained by column chromatography (yield: 67 %).

By FAB-MS, mass number m/z = 759.38 was observed as a molecular ion peak. Thus, Compound 185 was identified.

### Synthesis Example 10: Synthesis of Compound 515

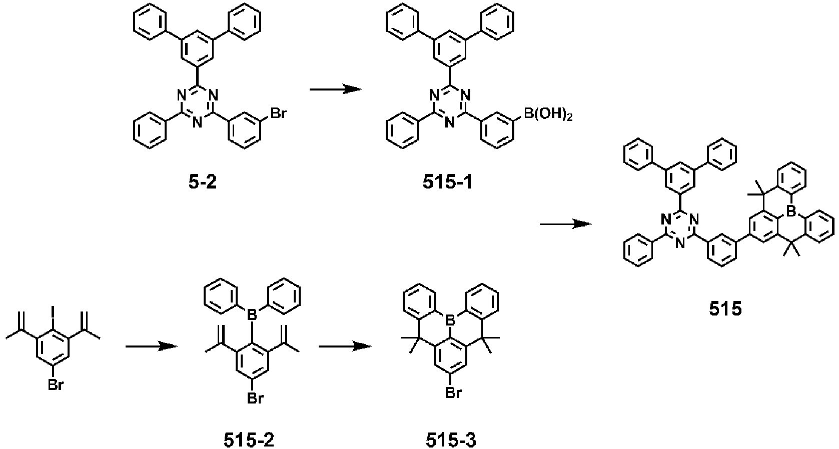

### (1) Synthesis of Intermediate Compound 515-1

THF was added to Intermediate Compound 5-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Trimethyl borate (1.2 eq.) dissolved in THF was slowly added dropwise to the reaction solution, followed by stirring at room temperature for 4 hours. Then, HCl was added dropwise to the reaction solution, followed by stirring at room temperature for 2 hours. The reaction solution was washed three times with ethyl acetate and water, and the resulting organic layer was dried over MgSO₄ first and then dried again under reduced pressure. The resulting solid was washed with water and methanol and filtered to obtain Intermediate Compound 515-1 (yield: 67 %).

### (2) Synthesis of Intermediate Compound 515-2

THF was added to 5-bromo-2-iodo-1,3-di(prop-1-en-2-yl)benzene (1.0 eq.), and the resultant reaction solution was cooled to -78 °C. N-butyllithium (1.0 eq.) was slowly added dropwise to the reaction solution under a nitrogen atmosphere, followed by stirring at -78 °C for 1 hour. Fluorodiphenylborane (1.1 eq.) dissolved in THF was slowly added dropwise to the reaction solution at -78 °C, followed by stirring at room temperature for 4 hours. Then, the reaction solution was filtered under a nitrogen atmosphere. The filtered liquid was dried under reduced pressure to obtain Intermediate Compound 515-2 (yield: 55 %).

### (3) Synthesis of Intermediate Compound 515-3

Intermediate Compound 515-2 (1.0 eq.) and tris(((trifluoromethyl)sulfonyl)oxy)scandium (2.0 eq.) were dissolved in dichloromethane, and the resultant reaction solution was stirred at 50 °C for 54 hours under a nitrogen atmosphere. After cooling, the reaction solution was washed three times with a sodium bicarbonate solution and dichloromethane, and the resulting organic layer was dried over MgSO₄ first and then dried again under reduced pressure. Intermediate Compound 515-3 was obtained by column chromatography (yield: 58 %).

### (4) Synthesis of Compound 515

Intermediate Compound 515-3 (1.0 eq.), Intermediate Compound 515-1 (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Compound 515 was obtained by column chromatography (yield: 70 %).

By FAB-MS, mass number m/z = 781.36 was observed as a molecular ion peak. Thus, Compound 515 was identified.

### Synthesis Example 11: Synthesis of Compound 691

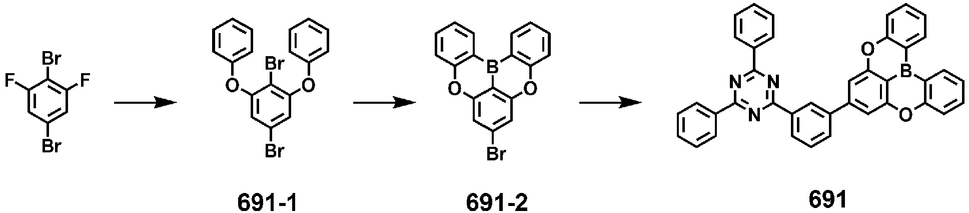

### (1) Synthesis of Intermediate Compound 691-1

2,5-Dibromo-1,3-difluorobenzene (1.0 eq.), phenol (3.0 eq.), and potassium carbonate (3.0 eq.) were dissolved in DMSO, and the resultant reaction solution was stirred at 100 °C for 18 hours. After cooling, water was added and a brown solid was obtained through filter. Intermediate Compound 691-1 was obtained by recrystallizing the brown solid with dichloromethane and ethanol (yield: 58%).

### (2) Synthesis of Intermediate Compound 691-2

THF was added to Intermediate Compound 691-1 (1.0 eq.), and the resultant reaction solution was cooled to -78 °C. N-butyllithium (1.0 eq.) was slowly added dropwise to the reaction solution under a nitrogen atmosphere, followed by stirring at - 78 °C for 1 hour. Tribromoborane (1.1 eq.) was slowly added dropwise to the reaction solution at -78 °C, followed by stirring at room temperature for 4 hours. Diisopropylehtylamine (5.0 eq.) was slowly added dropwise to the reaction solution at - 78 °C, followed by stirring at room temperature for 1 hours. Then, the reaction solution was stirred at 50 °C for 6 hours. Then, the reaction solution was cooled and washed three times with ethyl acetate and water, and the resulting organic layer was dried over MgSO₄ first and then dried again under reduced pressure. Compound 691-2 was obtained by column chromatography (yield: 35 %).

### (3) Synthesis of Compound 691

Intermediate Compound 691-2 (1.0 eq.), (3-(4,6-diphenyl-1,3,5-triazin-2-yl)phenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Compound 691 was obtained by column chromatography (yield: 68 %).

By FAB-MS, mass number m/z = 577.20 was observed as a molecular ion peak. Thus, Compound 691 was identified.

### Synthesis Example 12: Synthesis of Compound 695

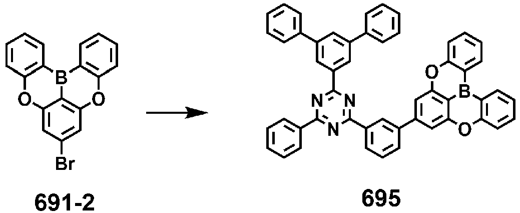

Intermediate Compound 691-2 (1.0 eq.), Intermediate Compound 515-1 (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Compound 695 was obtained by column chromatography (yield: 68 %).

By FAB-MS, mass number m/z = 729.26 was observed as a molecular ion peak. Thus, Compound 695 was identified.

### Synthesis Example 13: Synthesis of Compound 696

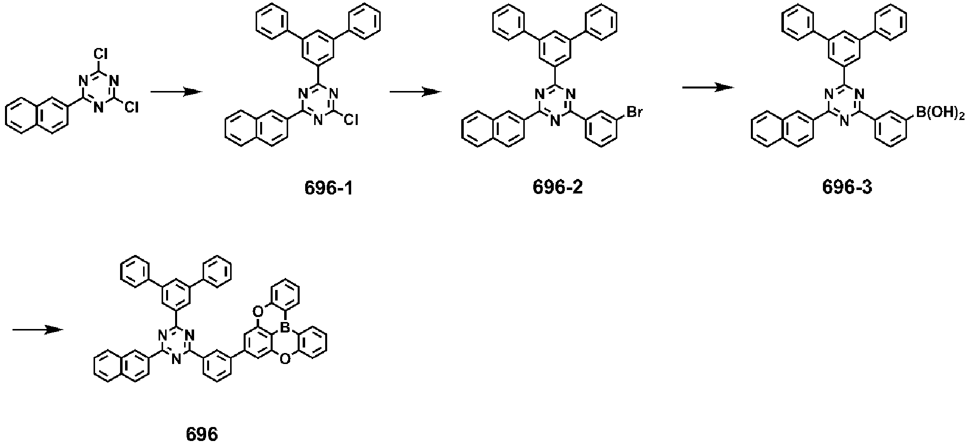

### (1) Synthesis of Intermediate Compound 696-1

2,4-Dichloro-6-(naphthalen-2-yl)-1,3,5-triazine (1.0 eq.), [1,1'-3',1"-terphenyl]-5'-ylboronic acid (1.0 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 696-1 was obtained by column chromatography (yield: 82 %).

### (2) Synthesis of Intermediate Compound 696-2

Intermediate Compound 696-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 696-2 was obtained by column chromatography (yield: 72 %).

### (3) Synthesis of Compound 696-3

THF was added to Intermediate Compound 696-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Trimethyl borate (1.2 eq.) was slowly added dropwise to the reaction solution at -78 °C, followed by stirring at room temperature for 4 hours. HCl was added dropwise to the reaction solution, followed by stirring at room temperature for 2 hours. Then, the reaction solution was washed three times with ethyl acetate and water, and the resulting organic layer was dried over MgSO₄ first and then dried again under reduced pressure. The resulting solid was washed with water and methanol, and Intermediate Compound 696-3 was obtained by and filter (yield: 67 %).

### (4) Synthesis of Intermediate Compound 696

Intermediate Compound 691-2 (1.0 eq.), Intermediate Compound 696-3 (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Compound 696 was obtained by column chromatography (yield: 65 %).

By FAB-MS, mass number m/z = 779.27 was observed as a molecular ion peak. Thus, Compound 696 was identified.

### Synthesis Example 14: Synthesis of Compound 965

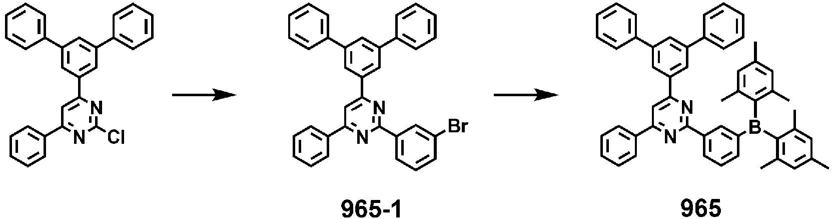

### (1) Synthesis of Intermediate Compound 965-1

4-([1,1':3',1"-terphenyl]-5'-yl)-2-chloro-6-phenylpyrimidine (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 965-1 was obtained by column chromatography (yield: 65 %).

### (2) Synthesis of Compound 965

THF was added to Intermediate Compound 965-1 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 965 was obtained by column chromatography (yield: 57 %).

By FAB-MS, mass number m/z = 708.36 was observed as a molecular ion peak. Thus, Compound 965 was identified.

### Synthesis Example 15: Synthesis of Compound 966

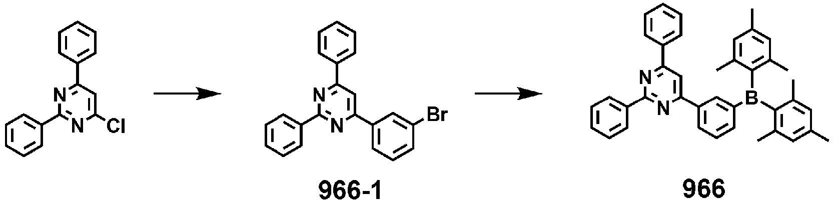

### (1) Synthesis of Intermediate Compound 966-1

4-chloro-2,6-diphenylpyrimidine (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 966-1 was obtained by column chromatography (yield: 65 %).

### (2) Synthesis of Compound 966

THF was added to Intermediate Compound 966-1 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 966 was obtained by column chromatography (yield: 67 %).

By FAB-MS, mass number m/z = 556.30 was observed as a molecular ion peak. Thus, Compound 966 was identified.

### Synthesis Example 16: Synthesis of Compound 996

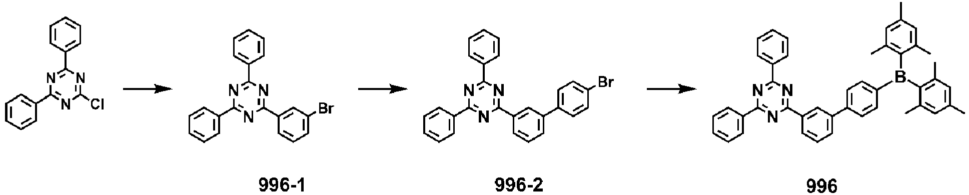

### (1) Synthesis of Intermediate Compound 996-1

2-chloro-4,6-diphenyl-1,3,5-triazine (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 996-1 was obtained by column chromatography (yield: 65 %).

### (2) Synthesis of Intermediate Compound 996-2

Intermediate Compound 996-1 (1.0 eq.), (4-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 996-2 was obtained by column chromatography (yield: 65 %).

### (3) Synthesis of Compound 996

THF was added to Intermediate Compound 996-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorodimesitylborane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 996 was obtained by column chromatography (yield: 67 %).

By FAB-MS, mass number m/z = 633.33 was observed as a molecular ion peak. Thus, Compound 996 was identified.

### Synthesis Example 17: Synthesis of Compound 1002

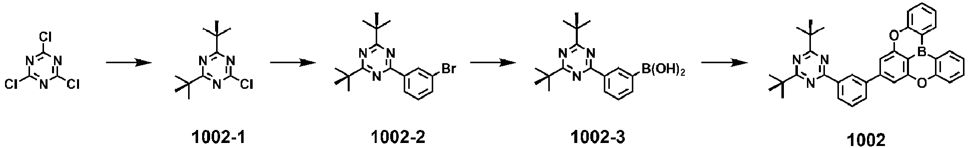

### (1) Synthesis of Intermediate Compound 1002-1

THF was added to 2,4,6-trichloro-1,3,5-triazine (1.0 eq.) and the resultant solution was cooled to 0°C. t-BuMgBr (2.5 eq.) was slowly added dropwise under a nitrogen atmosphere, followed by stirring at room temperature for 6 hours. Ammonium chloride solution was slowly added dropwise, then the reaction solution was washed three times with ethyl acetate and water, and the resulting organic layer was dried over MgSO₄ first and then dried again under reduced pressure. Intermediate compound 1002-1 was obtained by column chromatography (yield: 67%).

### (2) Synthesis of Intermediate Compound 1002-2

Intermediate Compound 1002-1 (1.0 eq.), (3-bromophenyl)boronic acid (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Intermediate Compound 1002-2 was obtained by column chromatography (yield: 65 %).

### (3) Synthesis of Intermediate Compound 1002-3

THF was added to Intermediate Compound 1002-2 (1.0 eq.), and the resultant reaction solution was cooled to -78 °C. N-butyllithium (1.05 eq.) was slowly added dropwise to the reaction solution under a nitrogen atmosphere, followed by stirring at -78 °C for 1 hour. Trimethyl borate (1.2 eq.) was slowly added dropwise to the reaction solution at -78 °C, followed by stirring at room temperature for 4 hours. HCl was added dropwise to the reaction solution, followed by stirring at room temperature for 2 hours. Then, the reaction solution was washed three times with ethyl acetate and water, and the resulting organic layer was dried over MgSO₄ first and then dried again under reduced pressure. The resulting solid was washed with water and methanol, and Intermediate Compound 1002-3 was obtained by and filter (yield: 67 %).

### (4) Synthesis of Compound 1002

Intermediate Compound 691-2 (1.0 eq.), Intermediate Compound 1002-3 (1.1 eq.), bis(triphenylphosphine)palladium(II)dichloride (0.02 eq.), and potassium carbonate (2.0 eq.) were dissolved in a solution containing toluene, EtOH, and H₂O at a volume ratio of 4:1:1, and the resultant reaction solution was stirred at 100 °C for 5 hours under a nitrogen atmosphere. After cooling, the reaction solution was washed three times with ethyl acetate and water, and the resulting organic layer was dried over MgSO₄ first and then dried again under reduced pressure. Compound 1002 was obtained by column chromatography (yield: 65 %).

By FAB-MS, mass number m/z = 537.26 was observed as a molecular ion peak. Thus, Compound 1002 was identified.

### Synthesis Example 18: Synthesis of Compound 1004

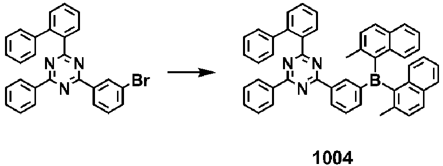

THF was added to Intermediate Compound 6-2 (1.0 eq.), and the resultant reaction solution was cooled to -78 °C. N-butyllithium (1.05 eq.) was slowly added dropwise to the reaction solution under a nitrogen atmosphere, followed by stirring at - 78 °C for 1 hour. Fluorobis(2-methylnaphthalen-1-yl)borane (1.1 eq.) dissolved in THF was slowly added dropwise to the reaction solution at -78 °C, followed by stirring at room temperature for 4 hours. Then, the reaction solution was washed three times with ethyl acetate and water, and the resulting organic layer was dried over MgSO₄ first and then dried again under reduced pressure. Compound 1004 was obtained by column chromatography (yield: 67 %).

By FAB-MS, mass number m/z = 677.30 was observed as a molecular ion peak. Thus, Compound 1004 was identified.

Synthesis methods of compounds other than the compounds synthesized in Synthesis Examples may be easily recognized by those skilled in the art by referring to the synthesis paths and source materials.

### Example 1

As an anode, a glass substrate (product of Corning Inc.) with a 15 Ω/cm² (1,200 Å) ITO electrode formed thereon was cut to a size of 50 mm x 50 mm x 0.7 mm, sonicated with isopropyl alcohol and pure water each for 5 minutes, cleaned by irradiation of ultraviolet rays and exposure of ozone thereto for 30 minutes, and then mounted on a vacuum deposition apparatus.

NPD was deposited on the anode to form a hole injection layer having a thickness of 300 Å, HTL3 was deposited on the hole injection layer to form a hole transport layer having a thickness of 200 Å, and CzSi was deposited on the hole transport layer to form an emission auxiliary layer having a thickness of 100 Å.

HT+ET (host), PS (phosphorescent sensitizer), and a boron dopant were codeposited at a weight ratio of 42:42:15:1 on the emission auxiliary layer to form an emission layer having a thickness of 200 Å, TSPO1 was deposited on the emission layer to form a hole-blocking layer having a thickness of 200 Å, Compound 5 was deposited on the hole-blocking layer to form an electron transport layer having a thickness of 300 Å, LiF was deposited on the electron transport layer to form an electron injection layer having a thickness of 10 Å, and Al was deposited on the electron injection layer to form a cathode having a thickness of 3,000 Å, thereby completing the manufacture of a light-emitting device.

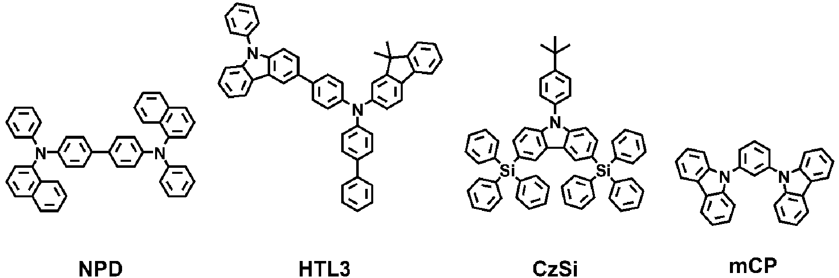

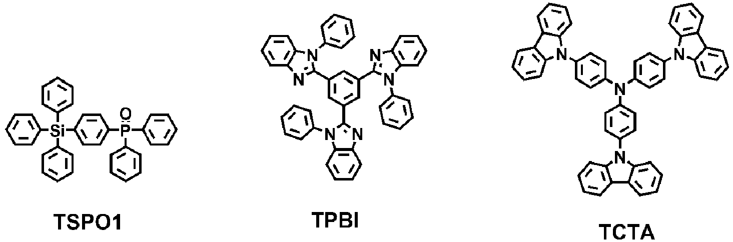

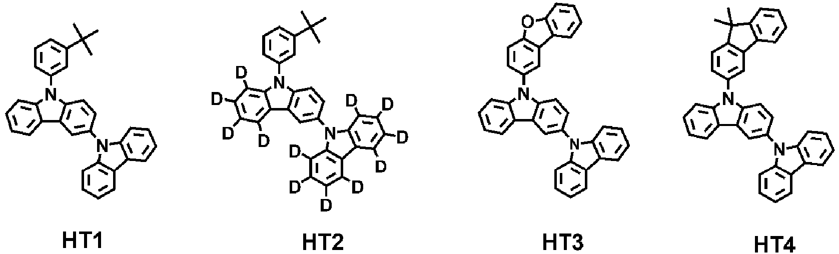

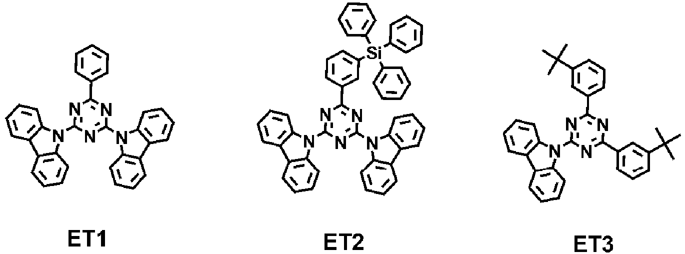

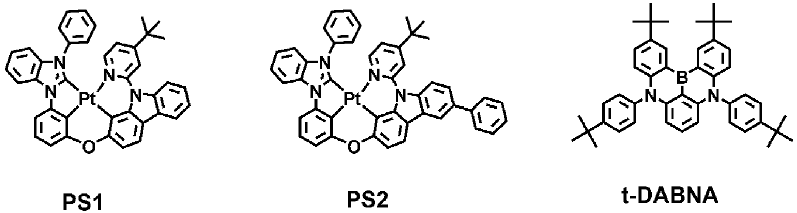

### Examples 2 to 22 and Comparative Examples 1 to 7

Light-emitting devices were each manufactured in substantially the same manner as in Example 1, except that compounds utilized in forming the emission layer and the electron transport layer were respectively changed as shown in Table 1.

### Evaluation Example 1

The driving voltage (V) at the luminance of 1,000 cd/m², efficiency (cd/A), and lifespan ratio (T₉₅) of each of the light-emitting devices manufactured in Examples 1 to 22 and Comparative Examples 1 to 7 were measured by utilizing Keithley SMU 236 and luminance meter PR650, and the results are shown in Table 1. The lifespan ratio (T₉₅) in Table 1 was obtained by measuring the time (device lifespan, hr) taken for the luminance to reach 95 % of the initial luminance in each of Examples and Comparative Examples, and then expressing the measured value as a relative ratio with respect to the device lifespan of Comparative Example 1, which was set to 1.

**Table 1**

| | Exciplex host (HT: ET = 5:5) | Phosphorescent sensitizer (where E is a fluorescent dopant) | Boron dopant | Electron transport layer | Driving voltage (V) | Efficiency (cd/A) | Lifespan ratio (T₉₅) |
|---|---|---|---|---|---|---|---|
| Example 1 | HT3/ET2 | PS2 | t-DABNA | 5 | 4.3 | 26.5 | 4.5 |
| Example 2 | HT3/ET2 | PS2 | t-DABNA | 6 | 4.2 | 28.8 | 4.8 |
| Example 3 | HT3/ET2 | PS2 | t-DABNA | 8 | 4.1 | 28.5 | 5.9 |
| Example 4 | HT3/ET2 | PS2 | t-DABNA | 9 | 4.0 | 28.3 | 6.0 |
| Example 5 | HT3/ET2 | PS2 | t-DABNA | 28 | 4.2 | 27.7 | 4.9 |
| Example 6 | HT3/ET2 | PS2 | t-DABNA | 30 | 4.3 | 29.7 | 4.8 |
| Example 7 | HT3/ET2 | PS2 | t-DABNA | 55 | 4.1 | 26.1 | 4.7 |
| Example 8 | HT3/ET2 | PS2 | t-DABNA | 58 | 4.4 | 29.2 | 4.7 |
| Example 9 | HT3/ET2 | PS2 | t-DABNA | 185 | 4.4 | 26.8 | 4.8 |
| Example 10 | HT3/ET2 | PS2 | t-DABNA | 515 | 4.1 | 27.2 | 5.1 |
| Example 11 | HT3/ET2 | PS2 | t-DABNA | 691 | 4.3 | 27.1 | 5.9 |
| Example 12 | HT3/ET2 | PS2 | t-DABNA | 695 | 4.2 | 27.8 | 6.1 |
| Example 13 | HT3/ET2 | PS2 | t-DABNA | 696 | 4.1 | 26.1 | 6.0 |
| Example 14 | HT3/ET2 | PS2 | t-DABNA | 965 | 4.5 | 28.1 | 5.2 |
| Example 15 | HT3/ET2 | PS2 | t-DABNA | 966 | 4.4 | 28.4 | 5.7 |
| Example 16 | HT3/ET2 | PS2 | t-DABNA | 996 | 4.1 | 26.8 | 5.4 |
| Example 17 | HT3/ET2 | PS2 | t-DABNA | 1002 | 4.0 | 29.1 | 5.9 |
| Example 18 | HT3/ET2 | PS2 | t-DABNA | 1004 | 4.0 | 29.8 | 5.8 |
| Example 19 | HT1/ET2 | PS2 | t-DABNA | 8 | 4.1 | 28.5 | 5.9 |
| Example 20 | HT2/ET2 | PS1 | t-DABNA | 8 | 4.0 | 29.2 | 6.2 |
| Example 21 | HT3/ET3 | PS1 | t-DABNA | 8 | 4.3 | 27.6 | 5.7 |
| Example 22 | HT4/ET1 | PS1 | t-DABNA | 8 | 4.4 | 29.8 | 5.8 |
| Comparative Example 1 | HT3/ET2 | PS2 | t-DABNA | TPBI | 5.6 | 18.8 | 1 |
| Comparative Example 2 | HT3/ET2 | PS2 | t-DABNA | A | 4.9 | 22.3 | 3.1 |
| Comparative Example 3 | HT3/ET2 | PS2 | t-DABNA | B | 5.2 | 21.1 | 3.4 |
| Comparative Example 4 | HT3/ET2 | PS2 | t-DABNA | C | 5.7 | 20.3 | 2.3 |
| Comparative Example 5 | HT3/ET2 | PS2 | t-DABNA | F | 5.9 | 22.2 | 2.8 |
| Comparative Example 6 | HT3/ET2 | PS2 | t-DABNA | G | 5.7 | 25.2 | 3.0 |
| Comparative Example 7 | D | E | - | B | 5.0 | 13.7 | 3.9 |

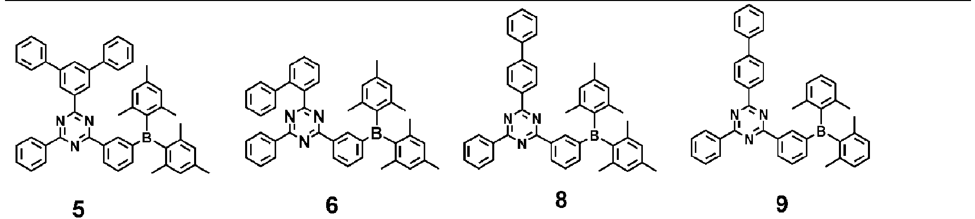

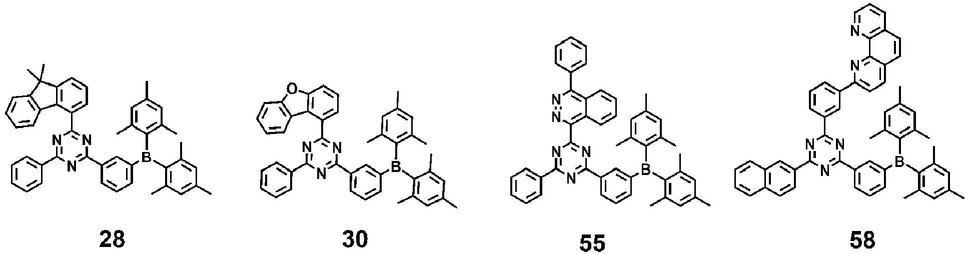

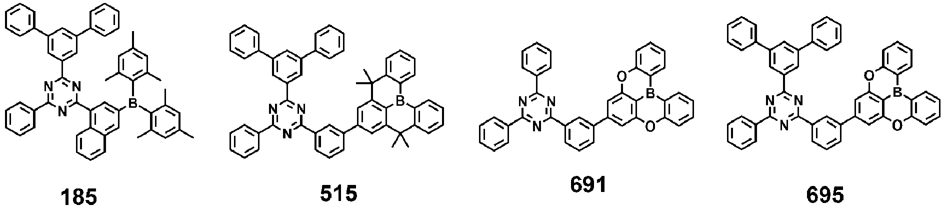

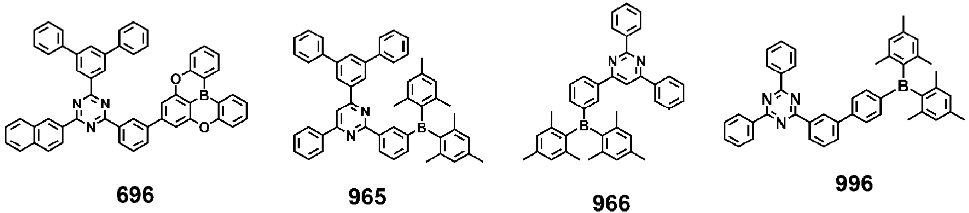

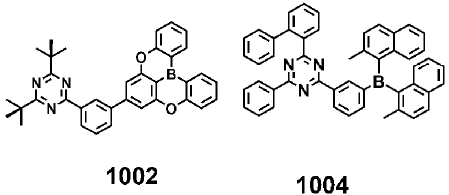

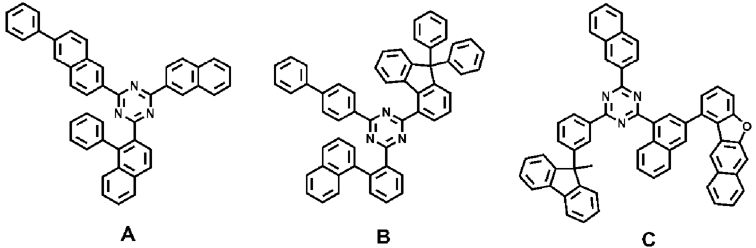

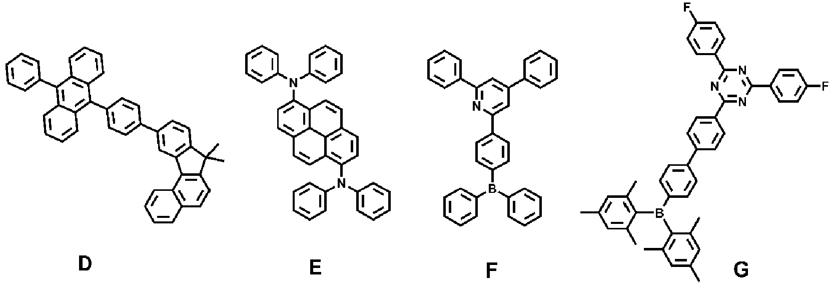

From Table 1, it was confirmed that each of the light-emitting devices according to Examples 1 to 22 had superior driving voltage, efficiency, and device lifespan to those of the light-emitting devices according to Comparative Examples 1 to 7.

According to the one or more embodiments of the present disclosure, by utilizing the heterocyclic compound of the present disclosure, a light-emitting device having reduced driving voltage, improved color purity and efficiency, and increased lifespan, and a high-quality electronic apparatus including the light-emitting device may be manufactured.

In the present disclosure, it will be understood that the term "comprise(s)," "include(s)," or "have/has" specifies the presence of stated features, integers, steps, operations, elements, and/or components, but do not preclude the presence or addition of one or more other features, integers, steps, operations, elements, components, and/or groups thereof.

The term "Group 13 element" as utilized herein may refer to a group of elements in the periodic table numbered 13 classified according to a classification system of The International Union of Pure and Applied Chemistry ("IUPAC").

Throughout the present disclosure, when a component such as a layer, a film, a region, or a plate is mentioned to be placed "on" another component, it will be understood that it may be directly on another component or that another component may be interposed therebetween. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, although the terms "first," "second," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

The light-emitting device, the light-emitting apparatus, the display device, the electronic apparatus, the electronic device, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A light-emitting device (10) comprising:
a first electrode (110);
a second electrode (150) facing the first electrode (110);
an interlayer between (130) the first electrode (110) and the second electrode (150) and comprising an emission layer; and
a heterocyclic compound represented by Formula 1 as defined in claim 6.

2. The light-emitting device (10) of claim 1, wherein the first electrode (110) is an anode,
the second electrode (150) is a cathode,
the interlayer (130) further comprises a hole transport region between the first electrode and the emission layer and an electron transport region between the emission layer and the second electrode,
the hole transport region comprises a hole injection layer, a hole transport layer, an emission auxiliary layer, an electron-blocking layer, or any combination thereof, and
the electron transport region comprises a hole-blocking layer, an electron transport layer, an electron injection layer, or any combination thereof.

3. The light-emitting device (10) of claim 2, wherein the electron transport region comprises the heterocyclic compound represented by Formula 1; and/or
wherein the light-emitting device (10) further comprises at least one of a first capping layer or a second capping layer,
wherein the first capping layer is on a surface of the first electrode (110),
the second capping layer is on a surface of the second electrode (150), and
at least one of the first capping layer or the second capping layer comprises the heterocyclic compound represented by Formula 1.

4. The light-emitting device (10) of any one of the preceding claims, wherein the emission layer is to emit blue light.

5. An electronic apparatus or an electronic equipment comprising the light-emitting device (10) of claim 1.

6. A heterocyclic compound represented by Formula 1: 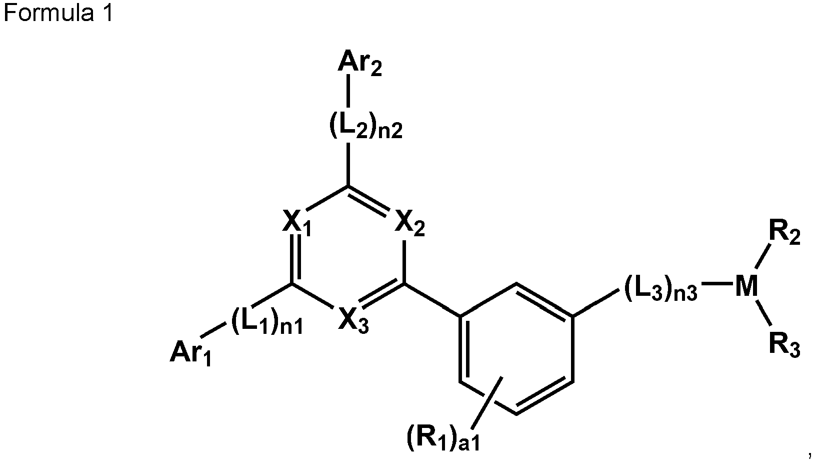 wherein, in Formula 1,
M is a Group 13 element,
X₁ is C(Y₁) or N, X₂ is C(Y₂) or N, and X₃ is C(Y₃) or N,
Ar1 and Ar₂ are each independently a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂),
R₁ to R₃ and Y₁ to Y₃ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
a1 is an integer from 1 to 4,
L₁ to L₃ are each independently a C₃-C₃₀ carbocyclic group unsubstituted or substituted with at least one R₁₀ₐ or a C₁-C₃₀ heterocyclic group unsubstituted or substituted with at least one R₁₀ₐ,
N1 to n3 are each independently an integer from 0 to 4, wherein, when n1 is 0, then *-(L₁)ₙ₁-*' is a single bond, when n2 is 0, then *-(L₂)ₙ₂-*' is a single bond, and when n3 is 0, then *-(L₃)ₙ₃-*' is a single bond,
when a1 is 2 or more, then two or more of R₁(s) are optionally bonded to each other to form a C₃-C₃₀ carbocyclic group unsubstituted or substituted with at least one R₁₀ₐ or a C₁-C₃₀ heterocyclic group unsubstituted or substituted with at least one R₁₀ₐ,
R₂ is optionally bonded to L₃ to form a C₃-C₃₀ carbocyclic group unsubstituted or substituted with at least one R₁₀ₐ or a C₁-C₃₀ heterocyclic group unsubstituted or substituted with at least one R₁₀ₐ,
R₃ is optionally bonded to L₃ to form a C₃-C₃₀ carbocyclic group unsubstituted or substituted with at least one R₁₀ₐ or a C₁-C₃₀ heterocyclic group unsubstituted or substituted with at least one R₁₀ₐ,
R₂ and R₃ are optionally bonded to each other to form a C₃-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is:
hydrogen, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

7. The heterocyclic compound of claim 6, wherein M is boron (B), aluminum (Al), or gallium (Ga); and/or
wherein at least two selected from among X₁ to X₃ are each N.

8. The heterocyclic compound of claims 6 or 7, wherein Ar1 and Ar₂ are each independently:
a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, - CF₂H, -CFH₂, a cyano group, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), or any combination thereof; or -C(Q₁)(Q₂)(Q₃), -Si(Q₁)(Q₂)(Q₃), or -N(Q₁)(Q₂), and
Q₁ to Q₃ and Q₃₁ to Q₃₃ are each independently: hydrogen; deuterium; -F; -Cl; -Br; -I; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

9. The heterocyclic compound of any one of claims 6 to 8, wherein R₁ to R₃ are each independently:
hydrogen, deuterium, -F, -Cl, -Br, -I, a cyano group, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a cyano group, a C₁-C₂₀ alkyl group, a C₁-C₂₀ alkoxy group, a C₁-C₂₀ alkylthio group, a cyclopentyl group, a cyclohexyl group, a cycloheptyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phthalazinyl group, a carbazolyl group, a phenanthrolinyl group, a benzimidazolyl group, a benzofuranyl group, a benzothiophenyl group, a benzothiazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), or any combination thereof; or -C(Q₁)(Q₂)(Q₃), -Si(Q₁)(Q₂)(Q₃), or -N(Q₁)(Q₂), and
Q₁ to Q₃ and Q₃₁ to Q₃₃ are each independently: hydrogen; deuterium; -F; -Cl; -Br; -I; a cyano group; a C₁-C₆₀ alkyl group; a C₂-C₆₀ alkenyl group; a C₂-C₆₀ alkynyl group; a C₁-C₆₀ alkoxy group; a C₁-C₆₀ alkylthio group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₁-C₆₀ alkylthio group, a phenyl group, a biphenyl group, or any combination thereof.

10. The heterocyclic compound of claim 6, wherein R₁ is:
hydrogen, deuterium, -F, or a cyano group; or
a C₁-C₂₀ alkyl group unsubstituted or substituted with deuterium, -F, -Cl, -Br, -I, -CD₃, - CD₂H, -CDH₂, -CF₃, -CF₂H, -CFH₂, a cyano group, a C₁-C₁₀ alkyl group, a cyclopentyl group, a cyclohexyl group, a cycloheptyl group, a cyclopentenyl group, a cyclohexenyl group, a cycloheptenyl group, a phenyl group, a biphenyl group, a naphthyl group, a pyridinyl group, a pyrimidinyl group, or any combination thereof.

11. The heterocyclic compound of any one of claims 6 to 10, wherein L₁ to L₃ are each independently a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phthalazine group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxin group, a dibenzooxathiin group, a dibenzooxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group, each unsubstituted or substituted with at least one R₁₀ₐ.

12. The heterocyclic compound of claim 6, wherein a group represented by 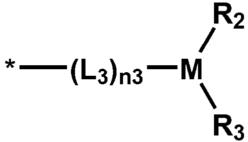 in Formula 1 is a group represented by Formula M(1) or M(2): 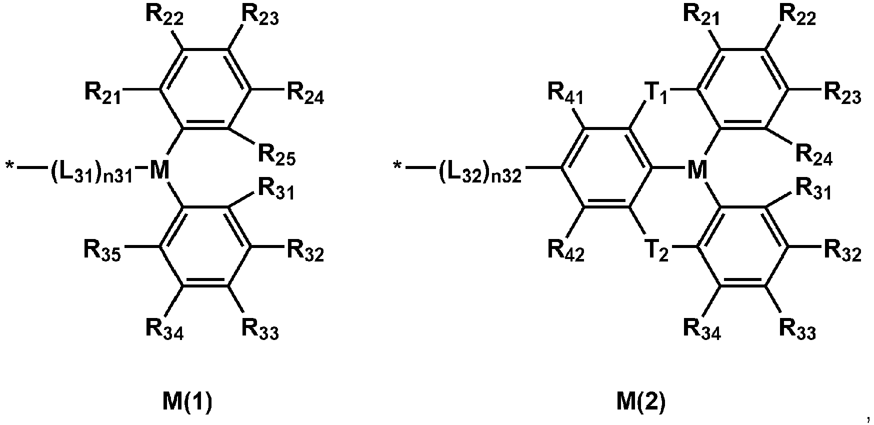 and wherein, in Formulae M(1) and M(2),
L₃₁ and L₃₂ are each the same as defined with respect to L₃ in Formula 1,
n31 is an integer from 0 to 4, and n32 is an integer from 0 to 3,
R₂₁ to R₂₅, R₃₁ to R₃₅, R₄₁, and R₄₂ are each the same as defined with respect to R₁₀ₐ in Formula 1,
T₁ is O, S, or C(Z₁)(Z₂), and T₂ is O, S, or C(Z₁)(Z₂),
Z₁ and Z₂ are each the same as defined with respect to Y₁ in Formula 1, and
* indicates a binding site to a neighboring atom.

13. The heterocyclic compound of claim 12, wherein R₂₁ to R₂₅ and R₃₁ to R₃₅ in Formula M(1) and R₂₁ to R₂₄ and R₃₁ to R₃₄ in Formula M(2) are each independently:
hydrogen; deuterium; or a C₁-C₆₀ alkyl group unsubstituted or substituted with at least one R₁₀ₐ.

14. The heterocyclic compound of claim 13, wherein R₂₁, R₂₃, R₂₅, R₃₁, R₃₃, and R₃₅ in Formula M(1) are each independently a C₁-C₆₀ alkyl group unsubstituted or substituted with at least one R₁₀ₐ.

15. The heterocyclic compound of claim 6, wherein the heterocyclic compound is selected from among compounds 1 to 1009:
